(19) Europäisches Patentamt
European Patent Office
Office européen des brevets

(11) **EP 4 632 947 A1**

(12) **EUROPEAN PATENT APPLICATION**
published in accordance with Art. 153(4) EPC

(43) Date of publication:
**15.10.2025 Bulletin 2025/42**

(21) Application number: **24910873.9**

(22) Date of filing: **18.12.2024**

(51) International Patent Classification (IPC):
*H01Q 1/22* (2006.01)    *H01Q 1/36* (2006.01)
*H01Q 1/44* (2006.01)

(86) International application number:
**PCT/CN2024/140214**

(87) International publication number:
**WO 2025/139942 (03.07.2025 Gazette 2025/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.12.2023  CN 202311871918
18.11.2024  CN 202411651410**

(71) Applicant: **Huawei Technologies Co., Ltd.
Shenzhen, Guangdong 518129 (CN)**

(72) Inventors:
• **SHI, Chuanbo
  Shenzhen, Guangdong 518129 (CN)**
• **SUN, Libin
  Shenzhen, Guangdong 518129 (CN)**
• **XUE, Liang
  Shenzhen, Guangdong 518129 (CN)**
• **FENG, Kun
  Shenzhen, Guangdong 518129 (CN)**
• **TANG, Rundong
  Shenzhen, Guangdong 518129 (CN)**

(74) Representative: **Huawei European IPR
Huawei Technologies Duesseldorf GmbH
Riesstraße 25
80992 München (DE)**

(54) **FOLDABLE ELECTRONIC DEVICE**

(57)    This application provides a foldable electronic device. The foldable electronic device includes an antenna. An operating frequency band of the antenna includes a satellite communication frequency band. The antenna includes a first radiator and a second radiator. A part of a conductive side frame of a first housing is used as the first radiator, and a part of a conductive side frame of a second housing is used as the second radiator. When the foldable electronic device is in an unfolded state, a parasitic resonance generated by the second radiator is close to a first resonance generated by the first radiator, and a radiation characteristic of the antenna in the first resonance is improved by using the parasitic resonance, so that a user performs satellite communication with better communication quality, thereby improving user experience during satellite communication.

FIG. 9

**Description**

This application claims priorities to Chinese Patent Application No. 202311871918.9, filed with the China National Intellectual Property Administration on December 29, 2023 and entitled "FOLDABLE ELECTRONIC DEVICE", and to Chinese Patent Application No. 202411651410.2, filed with the China National Intellectual Property Administration on November 18, 2024 and entitled "FOLDABLE ELECTRONIC DEVICE", both of which are incorporated herein by reference in their entireties.

**TECHNICAL FIELD**

This application relates to the field of wireless communication, and in particular, to a foldable electronic device.

**BACKGROUND**

Currently, a side frame is used as an antenna radiator in an existing terminal electronic device. For example, in a satellite communication system, a side frame radiator is mainly used to form a linearly polarized antenna. When a user performs satellite communication, an electronic device needs to point to the sky in a specific orientation, to complete a communication connection to a satellite.

However, for a foldable electronic device, in an unfolded state, a radiation direction of an antenna may deflect. This increases difficulty in establishing a communication connection to the satellite, and greatly affects communication experience of the user.

**SUMMARY**

This application provides a foldable electronic device. The foldable electronic device includes an antenna, and a conductive part of a side frame of the foldable electronic device is used as a main radiator and a parasitic stub of the antenna, to improve user experience during satellite communication.

According to a first aspect, a foldable electronic device is provided, including a first housing, a second housing, and a ground plane, where the first housing includes a first side frame, the second housing includes a second side frame, at least a part of the first side frame and the ground plane are spaced apart, at least a part of the second side frame and the ground plane are spaced apart, the first side frame includes a first position and a second position, the first position and the second position are located on a first side of the first side frame, the second side frame includes a third position and a fourth position, the third position is located on a second side of the second side frame, and based on the foldable electronic device being in an unfolded state, the first side and the second side are a top side or a bottom side of the foldable electronic device; a first rotating shaft, where the first rotating shaft is located between the first housing and the second housing, and the first rotating shaft is rotatably connected to the first housing and the second housing separately; and an antenna. The antenna includes: a first radiator and a second radiator, where the first radiator is a conductive part of the first side frame between the first position and the second position, and the second radiator is a conductive part of the second side frame between the third position and the fourth position; a feed circuit, where the first radiator includes a feed point, and the feed circuit is coupled to the feed point; and a first tuning circuit, where the second radiator includes a first connection point, and the first tuning circuit is coupled between the first connection point and the ground plane. Based on the foldable electronic device being in the unfolded state, the first radiator is configured to generate a first resonance, a resonance frequency band of the first resonance includes a satellite communication frequency band, and the first radiator, the second radiator, and the first tuning circuit are configured to generate a radiation pattern of the antenna.

According to this embodiment of this application, when the foldable electronic device is in the unfolded state, the feed circuit feeds an electrical signal, the first radiator generates the first resonance, and the second radiator and the first tuning circuit can reduce impact of a current of the ground plane on the radiation pattern generated by the antenna. Because impact of the current of the ground plane on a maximum radiation direction of the radiation pattern generated by the antenna is reduced, an included angle between the maximum radiation direction of the radiation pattern generated by the antenna when the foldable electronic device is in the unfolded state and a length direction of the electronic device is small, and it is convenient to establish a communication connection to a satellite. Therefore, during satellite communication, the foldable electronic device has good communication quality in the unfolded state. This effectively improves user experience. In addition, because impact of the current of the ground plane on the maximum radiation direction of the radiation pattern generated by the antenna is reduced, a radiation direction of the antenna does not greatly deflect, so that a user performs satellite communication with better communication quality, thereby effectively improving user experience.

With reference to the first aspect, in some implementations of the first aspect, the first side frame is provided with a first slot and a second slot at the first position and the second position.

According to this embodiment of this application, a current corresponding to the first resonance is mainly generated by the first radiator, the current is mainly concentrated on the first radiator, and a plurality of current modes are not generated on the ground plane. Therefore, the maximum radiation direction of the radiation pattern generated by the antenna is easily determined. In an embodiment, the resonance may be understood as being generated in a wire DM mode.

With reference to the first aspect, in some implementations of the first aspect, the first side frame is provided with a first slot at the first position, and the first side frame is coupled to the ground plane at the second position.

With reference to the first aspect, in some implementations of the first aspect, based on the foldable electronic device being in the unfolded state, the maximum radiation direction of the radiation pattern of the antenna is related to the second radiator and the first tuning circuit.

According to this embodiment of this application, that the first tuning circuit may be configured to switch the maximum radiation direction of the radiation pattern generated by the antenna may be understood as: the first tuning circuit may switch an equivalent electrical parameter (for example, equivalent capacitance, equivalent inductance, or equivalent resistance) between the first connection point and the ground plane, so that a parasitic resonance generated by the second radiator is close to the first resonance, to reduce impact of the current of the ground plane on the maximum radiation direction of the radiation pattern generated by the antenna. In an embodiment, because impact of the current of the ground plane on the maximum radiation direction of the radiation pattern generated by the antenna is reduced, the maximum radiation direction of the radiation pattern generated by the antenna when the foldable electronic device is in the unfolded state greatly deflects. In an embodiment, because impact of the current of the ground plane on the maximum radiation direction of the radiation pattern generated by the antenna is reduced, the included angle between the maximum radiation direction of the radiation pattern generated by the antenna when the foldable electronic device is in the unfolded state and the length direction of the electronic device is small, and it is convenient to establish a communication connection to a satellite. Therefore, during satellite communication, the foldable electronic device has good communication quality in the unfolded state. This effectively improves user experience.

With reference to the first aspect, in some implementations of the first aspect, based on the antenna operating in the satellite communication frequency band, when the foldable electronic device is in the unfolded state, the maximum radiation direction of the radiation pattern generated by the antenna is a first direction; and when the foldable electronic device is in a folded state, a maximum radiation direction of the radiation pattern generated by the antenna is a second direction. An angle between the first direction and the second direction is less than or equal to 30°.

According to this embodiment of this application, the first direction is approximately the same as the second direction. When the foldable electronic device performs satellite communication, a state (the folded state or the unfolded state) of the foldable electronic device is changed, and the foldable electronic device has good communication quality. This effectively improves user experience.

With reference to the first aspect, in some implementations of the first aspect, the first tuning circuit and the second radiator are configured to generate a parasitic resonance, and a frequency difference between a resonance point frequency of the first resonance and a resonance point frequency of the parasitic resonance is less than or equal to 200 MHz.

According to this embodiment of this application, when the foldable electronic device is in the unfolded state, the feed circuit feeds an electrical signal, the first radiator is configured to generate the first resonance (the resonance frequency band of the first resonance includes the satellite communication frequency band), and the second radiator is configured to generate the parasitic resonance. The parasitic resonance is close to the first resonance (the difference between the resonance point frequency of the first resonance and the resonance point frequency of the parasitic resonance is less than or equal to 200 MHz). The antenna can improve a radiation characteristic of the first resonance by using the parasitic resonance, so that the user performs satellite communication with better communication quality, thereby effectively improving user experience.

With reference to the first aspect, in some implementations of the first aspect, the antenna generates an efficiency pit at a first frequency, and a frequency difference between the resonance point frequency of the first resonance and a frequency of the first frequency is less than or equal to 200 MHz.

According to this embodiment of this application, coupling between the second radiator and the first radiator is weak, and the parasitic resonance cannot be better excited. Therefore, a pit corresponding to the parasitic resonance cannot appear obviously in an S-parameter diagram. Because the parasitic resonance is partially excited by a current, an obvious pit appears on an efficiency curve (for example, radiation efficiency or system efficiency). For example, if the efficiency pit appears at the first frequency, the first frequency may be considered as a resonance point corresponding to the parasitic resonance. In an embodiment, the pit results in a reduction of efficiency (for example, radiation efficiency or system efficiency) by no more than 1.5 dB. In an embodiment, the pit results in a reduction of efficiency (for example, radiation efficiency or system efficiency) by no more than 1 dB.

With reference to the first aspect, in some implementations of the first aspect, based on the foldable electronic device being in the unfolded state, the difference between the resonance point frequency of the first resonance and the resonance point frequency of the parasitic resonance is less than or equal to 50 MHz.

According to this embodiment of this application, when a resonance point of the parasitic resonance is close to a resonance point of the first resonance (the frequency difference is less than 50 MHz), coupling between the first radiator and the second radiator is strong. When the first radiator generates the first resonance, the second radiator has a large current. In an embodiment, at the resonance point of the first resonance, a current generated on the first radiator and a current generated on the second radiator are in a same direction. The current generated on the first radiator and the current generated on the second radiator may form effect similar to a current array, so that the antenna has a strong linear polarization characteristic, and the antenna has higher directivity. Because a gain is related to directivity, and the antenna has higher directivity, a gain of the antenna may be increased, so that the foldable electronic device has better satellite communication performance.

When the resonance point of the parasitic resonance is far away from the resonance point of the first resonance (the frequency difference is greater than or equal to 50 MHz and less than or equal to 200 MHz), coupling between the first radiator and the second radiator is weakened. When the first radiator generates the first resonance, the current on the second radiator becomes weak, to excite generation of some longitudinal currents on the ground plane, so that the antenna has a circular polarization characteristic. In an embodiment, the resonance point frequency of the first resonance is higher than the resonance point frequency of the parasitic resonance, and the antenna has a left-hand circular polarization characteristic. In an embodiment, the resonance point frequency of the first resonance is lower than the resonance point frequency of the parasitic resonance, and the antenna has a right-hand circular polarization characteristic.

With reference to the first aspect, in some implementations of the first aspect, the antenna generates the efficiency pit at the first frequency, and the frequency difference between the resonance point frequency of the first resonance and the frequency of the first frequency is less than or equal to 50 MHz.

With reference to the first aspect, in some implementations of the first aspect, the first radiator is configured to generate a main resonance, the first tuning circuit and the second radiator are configured to generate the parasitic resonance, a resonance point of the parasitic resonance is in a resonance frequency band of the main resonance, and the main resonance and the parasitic resonance jointly form the first resonance.

According to this embodiment of this application, when the difference between the resonance point frequency of the first resonance and the resonance point frequency of the parasitic resonance is less than 50 MHz, it may be understood that the resonance point of the parasitic resonance is in the resonance frequency band of the first resonance, the first radiator is configured to generate the main resonance, the second radiator and the first tuning circuit are configured to generate the parasitic resonance, and the main resonance and the parasitic resonance jointly form the first resonance.

With reference to the first aspect, in some implementations of the first aspect, the second side frame is provided with a third slot and a fourth slot at the third position and the fourth position.

According to this embodiment of this application, both ends of the second radiator are open ends, and a structure similar to a dipole (dipole) antenna may be formed. In an embodiment, the second radiator may operate in a one-half wavelength mode.

With reference to the first aspect, in some implementations of the first aspect, the antenna further includes a second tuning circuit, the second radiator includes a second connection point, and the second tuning circuit is coupled between the second connection point and the ground plane.

With reference to the first aspect, in some implementations of the first aspect, the second side frame is provided with a third slot at the third position, and the second side frame is coupled to the ground plane at the fourth position.

According to this embodiment of this application, one end of the second radiator is a ground end, the other end is an open end, and a structure similar to an IFA may be formed. In an embodiment, the second radiator may operate in a quarter-wavelength mode.

With reference to the first aspect, in some implementations of the first aspect, the second radiator includes a second connection point and a third connection point, the second radiator is provided with a fourth slot between the second connection point and the third connection point, and the second tuning circuit is coupled between the second connection point and the third connection point.

According to this embodiment of this application, the second radiator is provided with the fourth slot, and the fourth slot may be considered as an equivalent capacitor (for example, a distributed capacitor) provided on the second radiator. The equivalent capacitor may enable the second radiator to form a metamaterial structure. A radiation aperture of the second radiator in the metamaterial structure may be increased, and after the fourth slot is provided, an electric field is more dispersed, and a dielectric loss near a conductor is reduced. Therefore, system efficiency and radiation efficiency of the antenna can be effectively improved. By coupling the second tuning circuit between the second connection point and the third connection point, an equivalent capacitance value of the fourth slot can be adjusted, to adjust a radiation characteristic (for example, a resonance point frequency) of the antenna.

In addition, the parasitic resonance of the second radiator may correspond to the quarter-wavelength mode (the second radiator may operate in the quarter-wavelength mode). By using a first resonance circuit and the fourth slot, an electrical length of the second radiator may be greater than three-eighths of a first wavelength, currents on the second radiator are in a same direction (for example, no reversal occurs), and no reversal occurs in an electric field between the second radiator and the ground. The electrical length of the second radiator increases from a quarter of the first wavelength to more than three-eighths of the first wavelength, but the second radiator still operates in the quarter-wavelength mode. In this case, a current density on the second radiator is reduced, and a density of the electric field between the second radiator and the ground plane is reduced, to reduce a conductor loss and a dielectric loss caused by the second radiator and a conductor and a dielectric provided around the second radiator, and improve a radiation characteristic of the antenna. The radiation aperture of the second radiator is increased, to effectively improve system efficiency and radiation efficiency of the antenna.

With reference to the first aspect, in some implementations of the first aspect, a distance between the second connection point and the fourth slot is less than or equal to 5 mm, and/or a distance between the third connection point and the fourth slot is less than or equal to 5 mm.

With reference to the first aspect, in some implementations of the first aspect, the second connection point is located between the third position and the fourth slot, and the third connection point is located between the fourth position and the fourth slot. The first connection point is located between the third position and the second connection point, and a distance between the second connection point and the first connection point is greater than or equal to 0 mm and less than or equal to 5 mm; or the first connection point is located between the fourth position and the third connection point, and a distance between the third connection point and the first connection point is greater than or equal to 0 mm and less than or equal to 5 mm.

According to this embodiment of this application, the radiation aperture of the second radiator is adjusted by using both the first tuning circuit and the second tuning circuit, to achieve a parasitic resonance in an expected frequency band.

It should be understood that the first connection point may be located at any position on the second radiator. This is not limited in this embodiment of this application. When the length of the second radiator between the first connection point and the second connection point/the third connection point is less than or equal to 5 mm, the radiation aperture of the second radiator can be better adjusted, to improve a radiation characteristic of the antenna.

With reference to the first aspect, in some implementations of the first aspect, based on the foldable electronic device being in the unfolded state, the fourth position is located between the second position and the third position.

According to this embodiment of this application, the ground end (an end at the fourth position) of the second radiator may be close to the first radiator, and the open end (an end at the third position) may be far away from the first radiator.

With reference to the first aspect, in some implementations of the first aspect, the foldable electronic device may further include a third housing and a second rotating shaft. The second rotating shaft is located between the second housing and the third housing, and the second rotating shaft is rotatably connected to the second housing and the third housing separately; or the second rotating shaft is located between the first housing and the third housing, and the second rotating shaft is rotatably connected to the first housing and the third housing separately.

According to this embodiment of this application, the technical solutions in the foregoing embodiment may also be applied to a foldable electronic device including three housings.

With reference to the first aspect, in some implementations of the first aspect, the third housing includes a third side frame, at least a part of the third side frame and the ground plane are spaced apart, the third side frame includes a fifth position and a sixth position, the fifth position is located on a third side of the third side frame, and based on the foldable electronic device being in the unfolded state, the first side, the second side, and the third side are a same side of the foldable electronic device. The antenna further includes a third radiator and a third tuning circuit, the third radiator is a conductive part of the third side frame between the fifth position and the sixth position, the third radiator includes a fourth connection point, and the third tuning circuit is coupled between the fourth connection point and the ground plane.

With reference to the first aspect, in some implementations of the first aspect, based on the second rotating shaft being located between the second housing and the third housing, the first radiator is configured to generate the first resonance. Based on the foldable electronic device being in the unfolded state, at a resonance point of the first resonance, a current on the first radiator and a current on the second radiator are in a same direction, and the current on the first radiator and a current on the third radiator are in reverse directions.

According to this embodiment of this application, at the resonance point of the first resonance generated by the first radiator, the current generated on the first radiator and the current generated on the second radiator are in a same direction, and the current generated on the first radiator and the current generated on the third radiator (a fifth tuning circuit may be configured to generate a current in this direction) are in reverse directions. When the foldable electronic device is in the unfolded state, the reverse current generated on the third radiator can reduce effect similar to a current array that may be formed by the current generated on the first radiator and the current generated on the second radiator, to reduce directivity of the antenna, so that the antenna has a wider radiation beam (for example, a beam with a gain that differs from a gain in a maximum radiation direction by less than 3 dB).

With reference to the first aspect, in some implementations of the first aspect, based on the second rotating shaft being located between the first housing and the third housing, the first radiator is configured to generate the first resonance. Based on the foldable electronic device being in the unfolded state, at the resonance point of the first resonance, the current on the first radiator, the current on the second radiator, and the current on the third radiator are in a same direction.

According to this embodiment of this application, at the resonance point of the first resonance generated by the first radiator, the current generated on the first radiator, the current generated on the second radiator, and the current generated on the third radiator are in a same direction. The current generated on the first radiator, the current generated on the second radiator, and the current generated on the third radiator may form effect similar to a current array, so that the antenna has a strong linear polarization characteristic, and the antenna has higher directivity. Because a gain is related to directivity, and the antenna has higher directivity, a gain of the antenna may be increased, so that the foldable electronic device has better satellite communication performance.

With reference to the first aspect, in some implementations of the first aspect, based on the foldable electronic device being in the folded state, the first radiator and the second radiator at least partially overlap in a third direction, and the third direction is a thickness direction of the foldable electronic device.

According to this embodiment of this application, the foldable electronic device is in the folded state, the first radiator and the second radiator at least partially overlap in the third direction. When the feed circuit feeds an electrical signal, the second radiator may be coupled to more energy, to improve a radiation characteristic of the parasitic resonance generated by the second radiator.

With reference to the first aspect, in some implementations of the first aspect, a ratio of a size of the ground plane in an extension direction of the first side when the foldable electronic device is in the unfolded state to a size of the ground plane in the extension direction of the first side when the foldable electronic device is in the folded state is greater than or equal to 1.8, and is less than or equal to 2.2.

With reference to the first aspect, in some implementations of the first aspect, the foldable electronic device performs at least one of the following services in the satellite communication frequency band: receiving and/or sending a short message via satellite, making and/or answering a call via satellite, or data service via satellite.

## BRIEF DESCRIPTION OF DRAWINGS

FIG. 1 is a diagram of a structure of a foldable electronic device 100 according to an embodiment of this application;
FIG. 2 is a diagram of a structure of a foldable electronic device 100 in an outward-folded state;
FIG. 3 is a diagram of a structure of a foldable electronic device 100 in a possible unfolded state;
FIG. 4 is a diagram of a structure of a foldable electronic device 100 in a possible folded state;
FIG. 5 is a diagram of a structure of a foldable electronic device 100 in a possible partially-unfolded state;
FIG. 6 is diagrams of a structure in a common mode of an antenna and corresponding current and electric field distribution according to this application;
FIG. 7 is diagrams of a structure in a differential mode of another antenna and corresponding current and electric field distribution according to this application;
FIG. 8 is diagrams of maximum radiation directions of radiation patterns generated by an antenna 200 in a foldable electronic device 100 according to an embodiment of this application;
FIG. 9 is a diagram of a foldable electronic device 100 according to an embodiment of this application;
FIG. 10 is a diagram of a foldable electronic device 100 according to an embodiment of this application;
FIG. 11 is a diagram of a foldable electronic device 100 according to an embodiment of this application;
FIG. 12 is diagrams of a second radiator 240 according to an embodiment of this application;
FIG. 13 is a diagram of a foldable electronic device 100 according to an embodiment of this application;
FIG. 14 is an S-parameter simulation result of an antenna 200 in a foldable electronic device 100;
FIG. 15 is a system efficiency simulation result of an antenna 200 in a foldable electronic device 100;
FIG. 16 is a radiation pattern in an unfolded state of a foldable electronic device 100 when a second radiator is not provided;
FIG. 17 is a radiation pattern in an unfolded state of a foldable electronic device 100 when a resonance point frequency of a parasitic resonance is lower than a resonance point frequency of a first resonance;
FIG. 18 is a radiation pattern in an unfolded state of a foldable electronic device 100 when a resonance point frequency of a parasitic resonance is close to a resonance point frequency of a first resonance;
FIG. 19 is a radiation pattern in an unfolded state of a foldable electronic device 100 when a resonance point frequency of a parasitic resonance is higher than a resonance point frequency of a first resonance;
FIG. 20 is a diagram of a foldable electronic device 100 according to an embodiment of this application;
FIG. 21 is a radiation pattern in an unfolded state of a foldable electronic device 100 when a second radiator is not provided;

FIG. 22 is a radiation pattern in an unfolded state of a foldable electronic device 100 when a resonance point frequency of a parasitic resonance is lower than a resonance point frequency of a first resonance;

FIG. 23 is a radiation pattern in an unfolded state of a foldable electronic device 100 when a resonance point frequency of a parasitic resonance is close to a resonance point frequency of a first resonance;

FIG. 24 is a radiation pattern in an unfolded state of a foldable electronic device 100 when a resonance point frequency of a parasitic resonance is higher than a resonance point frequency of a first resonance;

FIG. 25 is a diagram of a foldable electronic device 100 according to an embodiment of this application;

FIG. 26 is diagrams of a foldable electronic device 100 according to an embodiment of this application;

FIG. 27 is a radiation pattern in an unfolded state of a foldable electronic device 100 when a second radiator is not provided;

FIG. 28 is a radiation pattern in an unfolded state of a foldable electronic device 100 when a resonance point frequency of a parasitic resonance is lower than a resonance point frequency of a first resonance;

FIG. 29 is a radiation pattern in an unfolded state of a foldable electronic device 100 when a resonance point frequency of a parasitic resonance is close to a resonance point frequency of a first resonance;

FIG. 30 is a radiation pattern in an unfolded state of a foldable electronic device 100 when a resonance point frequency of a parasitic resonance is higher than a resonance point frequency of a first resonance;

FIG. 31 is a diagram of a foldable electronic device 100 according to an embodiment of this application;

FIG. 32 is a diagram of a foldable electronic device 100 according to an embodiment of this application;

FIG. 33 is a diagram of a foldable electronic device 100 according to an embodiment of this application;

FIG. 34 is a radiation pattern in an unfolded state of a foldable electronic device 100 when a second radiator is not provided;

FIG. 35 is a radiation pattern in an unfolded state of a foldable electronic device 100 when a second radiator is provided;

FIG. 36 is a diagram of a foldable electronic device 100 according to an embodiment of this application;

FIG. 37 is a radiation pattern in an unfolded state of the foldable electronic device 100 shown in FIG. 36 at 2.2 GHz;

FIG. 38 is a diagram of a foldable electronic device 100 according to an embodiment of this application;

FIG. 39 is a diagram of a foldable electronic device 100 according to an embodiment of this application;

FIG. 40 is a diagram of a foldable electronic device 100 according to an embodiment of this application;

FIG. 41 is a diagram of a foldable electronic device 100 according to an embodiment of this application;

FIG. 42 is a diagram of a foldable electronic device 100 according to an embodiment of this application;

FIG. 43 is a diagram of a foldable electronic device 100 according to an embodiment of this application;

FIG. 44 is a diagram of a foldable electronic device 100 according to an embodiment of this application, and

FIG. 45 is a diagram of an electronic device 100 according to an embodiment of this application.

## DESCRIPTION OF EMBODIMENTS

The following explains terms that may appear in embodiments of this application.

It should be understood that the term "and/or" in this specification describes only a same field for describing associated objects and represents that three relationships may exist. For example, A and/or B may represent the following three cases: Only A exists, both A and B exist, and only B exists. In addition, the character "/" in this specification generally indicates an "or" relationship between the associated objects.

In this application, "within a range of..." is used, except when it is separately indicated that no end value is included, end values at both ends of the range are included by default. For example, within a range from 1 to 5, two values 1 and 5 are included.

Coupling: The coupling may be understood as direct coupling and/or indirect coupling, and a "coupling connection" may be understood as a direct coupling connection and/or an indirect coupling connection. The direct coupling may also be referred to as an "electrical connection", which may be understood as physical contact and electrical conduction of components, or may be understood as a form of connection between different components in a line structure through a physical line that can transmit an electrical signal, like a printed circuit board (printed circuit board, PCB) copper foil or a conducting wire. The "indirect coupling" may be understood as electrical conduction of two conductors in a spaced/non-contact manner. In an embodiment, the indirect coupling may also be referred to as capacitive coupling. For example, signal transmission is implemented by forming an equivalent capacitor through coupling in a slot between two spaced conductive members.

Element/component: The element/component includes at least one of a lumped element/component, and a distributed element/component.

Lumped element/component: The lumped element/component is a general name of all elements whose sizes are far less than a wavelength corresponding to an operating frequency of a circuit. For a signal, a characteristic of the element is always fixed at any time, regardless of a frequency.

Distributed element/component: Different from the lumped element, if a size of an element is close to or greater than a wavelength corresponding to an operating frequency of a circuit, when a signal passes through the element, a characteristic of each point of the element varies with the signal. In this case, the element cannot be considered as a single entity with a fixed characteristic, but should be referred to as a distributed element.

Capacitor: The capacitor may be understood as a lumped capacitor and/or a distributed capacitor. The lumped capacitor is a capacitive component, for example, a capacitive element. The distributed capacitor (or a distributed type capacitor) is an equivalent capacitor formed by two conductive members that are spaced by a specific slot.

Inductor: The inductor may be understood as a lumped inductor and/or a distributed inductor. The lumped inductor is an inductive component, for example, an inductive element, and the distributed inductor (or a distributed type inductor) is an equivalent inductor formed by using a conductive member with a specific length.

Radiator: The radiator is an apparatus configured to receive/send electromagnetic wave radiation in an antenna. In some cases, an "antenna" is a radiator in a narrow sense. The radiator converts guided wave energy from a transmitter into a radio wave, or converts a radio wave into guided wave energy to radiate and receive a radio wave. Modulated high-frequency current energy (or guided wave energy) generated by the transmitter is transmitted to a transmit radiator through a feed line. The radiator converts the energy into polarized electromagnetic wave energy and transmits the energy in a required direction. A receive radiator converts specific polarized electromagnetic wave energy from a specific direction of space into modulated high-frequency current energy, and transmits the modulated high-frequency current energy to an input end of a receiver through a feed line.

The radiator may include a conductor having a specific shape and size, for example, a linear radiator or a sheet-like radiator. A specific shape is not limited in this application. In an embodiment, the linear radiator may be referred to as a wire antenna for short. In an embodiment, the linear radiator may be implemented by a conductive side frame, and may also be referred to as a side frame antenna. In an embodiment, the linear radiator may be implemented by a bracketed conductor, and may also be referred to as a bracketed antenna. In an embodiment, a wire diameter (for example, including a thickness and a width) of the linear radiator or a radiator of the wire antenna is much less than a wavelength (for example, a dielectric wavelength) (for example, is less than 1/16 of the wavelength), and a length may be compared to the wavelength (for example, the dielectric wavelength) (for example, the length is near 1/8 of the wavelength, or 1/8 to 1/4 of the wavelength, or 1/4 to 1/2 of the wavelength, or greater). Main forms of the wire antenna include a dipole antenna, a half-wave dipole antenna, a monopole antenna, a loop antenna, and an inverted F antenna (also referred to as IFA, Inverted F Antenna). For example, for the dipole antenna, each dipole antenna usually includes two radiation stubs, and each stub is fed by a feed part from a feed end of the radiation stub. For example, the inverted F antenna (Inverted F Antenna, IFA) may be considered as being obtained by adding a ground path to the monopole antenna. The IFA antenna has a feed point and a ground point. A side view of the IFA antenna is inverted F-shaped, and therefore, the IFA antenna is referred to as an inverted F antenna. In an embodiment, the sheet-like radiator may include a microstrip antenna, or a patch (patch) antenna, for example, a planar inverted F antenna (also referred to as PIFA, Planar Inverted F Antenna). In an embodiment, the sheet-like radiator may be implemented by a planar conductor (for example, a conductive sheet or a conductive coating). In an embodiment, the sheet-like radiator may include a conductive sheet, for example, a copper sheet. In an embodiment, the sheet-like radiator may include a conductive coating, for example, silver paste. A shape of the sheet-like radiator includes a circular shape, a rectangular shape, a ring shape, and the like. A specific shape is not limited in this application. A structure of the microstrip antenna generally includes a dielectric substrate, a radiator, and a ground plane, where the dielectric substrate is provided between the radiator and the ground plane.

The radiator may also include a slot or a slit formed on a conductor, for example, a closed or semi-closed slot or slit formed on a grounded conductor surface. In an embodiment, a radiator with a slot or slit may be referred to as a slot antenna or a slotted antenna for short. In an embodiment, a radial size (for example, including a width) of the slot or slit of the slot antenna/slotted antenna is much less than a wavelength (for example, a dielectric wavelength) (for example, is less than 1/16 of the wavelength), and a length size may be compared to the wavelength (for example, the dielectric wavelength) (for example, the length is near 1/8 of the wavelength, or 1/8 to 1/4 of the wavelength, or 1/4 to 1/2 of the wavelength, or greater). In an embodiment, a radiator with a closed slot or slit may be referred to as a closed slot antenna for short. In an embodiment, a radiator with a semi-closed slot or slit (for example, an opening is additionally provided on the closed slot or slit) may be referred to as an open slot antenna for short. In some embodiments, the slot is long strip-shaped. In some embodiments, a length of the slot is approximately half the wavelength (for example, the dielectric wavelength). In some embodiments, a length of the slot is approximately an integer multiple of the wavelength (for example, one time of the dielectric wavelength). In some embodiments, the slot may be used for feeding by using a transmission line bridged on one side or two sides of the slot. In this way, a radio frequency electromagnetic field is excited on the slot, and an electromagnetic wave is radiated to space. In an embodiment, a radiator of the slot antenna or the slotted antenna may be implemented by a conductive side frame that is grounded at two ends, and may also be referred to as a side frame antenna. In this embodiment, it may be considered that the slot antenna or the slotted antenna includes a linear radiator, and the linear radiator is spaced apart from the ground plane and is grounded at two ends of the radiator, to form a closed or semi-closed slot or slit. In an embodiment, the radiator of the slot antenna or the slotted antenna may be implemented by a bracketed conductor that is grounded at both ends, and may also be referred to as a bracketed antenna.

A feed circuit is a combination of all circuits configured to receive and transmit radio frequency signals. The feed circuit may include a transceiver (transceiver) and a radio frequency front end circuit (RF front end). In some cases, in a narrow sense, the "feed circuit" is a radio frequency integrated circuit (RFIC, Radio Frequency Integrated Circuit), and the RFIC may be considered to include a radio frequency front end chip and the transceiver. The feed circuit has a function of converting a radio wave (for example, a radio frequency signal) and an electrical signal (for example, a digital signal). Usually, the feed circuit is considered as a part of radio frequency.

In some embodiments, an electronic device may further include a test base (which is also referred to as a radio frequency base or a radio frequency test base). A coaxial cable may be inserted into the test base, to test a characteristic of the radio frequency front end circuit or the radiator of the antenna through the cable. The radio frequency front end circuit may be considered as a circuit part coupled between the test base and the transceiver.

In some embodiments, the radio frequency front end circuit may be integrated into the radio frequency front end chip in the electronic device, or the radio frequency front end circuit and the transceiver may be integrated into the radio frequency integrated circuit in the electronic device.

It should be understood that any two of a first feed circuit, a second feed circuit, ..., and an $N^{th}$ feed circuit in this application may share a same transceiver, for example, transmit a signal through a radio frequency channel in the transceiver (for example, a pin (pin) of the radio frequency integrated circuit); and may further share a radio frequency front end circuit, for example, process the signal via a tuning circuit or an amplifier in the radio frequency front end circuit.

It should be further understood that two of the first feed circuit, the second feed circuit, ..., and the $N^{th}$ feed circuit in this application usually correspond to two radio frequency test bases in the electronic device.

A matching circuit is a circuit configured to adjust a radiation characteristic of an antenna. In an embodiment, the matching circuit is coupled between the feed circuit and a corresponding radiator. In an embodiment, the matching circuit is coupled between a test base and a radiator. Generally, the matching circuit is a combination of circuits coupled between the radiator and a ground plane. In an embodiment, the matching circuit may include a tuning circuit and/or an electronic element. The tuning circuit may be an electronic element configured to switch a coupling connection of the radiator. The matching circuit has a function of impedance matching and/or frequency tuning. Usually, the matching circuit is considered as a part of an antenna.

Ground structure/feed structure: The ground structure/feed structure may include a connector, for example, a metal dome. A radiator is coupled to a ground plane via the ground structure/coupled to a feed circuit via the feed structure. In some embodiments, the feed structure may include a transmission line/feed line, and the ground structure may include a ground cable.

End/point: An "end/point" in a first terminal/second end/feed end/ground end/feed point/ground point/connection point of an antenna radiator cannot be narrowly understood as an end point or an end part that is physically disconnected from another radiator, but may be considered as a point or a segment on a continuous radiator. In an embodiment, the "end/point" may include a connection/coupling area that is on an antenna radiator and that is coupled to another conductive structure. For example, a feed end/feed point may be a coupling area (for example, an area facing a part of a feed circuit) that is on the antenna radiator and that is coupled to a feed structure or a feed circuit. For another example, a ground end/ground point may be an open end or a closed end of a connection/coupling area that is on the antenna radiator and that is coupled to a ground structure or a ground circuit. In some embodiments, the open end and the closed end are, for example, relative to whether an end is grounded. The closed end is grounded, and the open end is not grounded. In some embodiments, the open end and the closed end are defined based on another conductor. For example, the closed end is electrically connected to the another conductor, and the open end is not electrically connected to the another conductor. In an embodiment, the open end may also be referred to as a floating end, a free end, an opening end or an open-circuit end. In an embodiment, the closed end may also be referred to as a ground end or a short-circuit end. It should be understood that, in some embodiments, another conductor may be coupled through the open end, to transfer coupling energy (which may be understood as transferring a current).

In some embodiments, the "closed end" may also be understood from a perspective of current distribution. The closed end, the ground end, or the like may be understood as a current strong point on a radiator, or may be understood as an electric field weak point on a radiator. In an embodiment, the closed end is coupled to an electronic component (for example, a capacitor or an inductor), so that a current distribution characteristic of a current strong point/electric field weak point of the radiator may not be changed. In an embodiment, a slit (for example, a slot filled with an insulation material) at or near the closed end may not change a current distribution characteristic of a current strong point/electric field weak point of the radiator at the slit.

In some embodiments, the "open end" may also be understood from a perspective of current distribution. The open end, the floating end, or the like may be understood as a current weak point on a radiator, or may be understood as an electric field strong point on a radiator. In an embodiment, the open end is coupled to an electronic component (for example, a capacitor or an inductor), so that a current distribution characteristic of a current weak point/an electric field strong point of the electronic component may not be changed.

It should be understood that a radiator end (similar to a radiator at an opening of the open end or the floating end from a perspective of a radiator structure) in a slot is coupled to the electronic component (for example, the capacitor or the inductor), so that the radiator end is a current strong point/electric field weak point. In this case, it should be understood that the radiator end in the slot is actually a closed end, a ground end, or the like.

A "floating radiator" in embodiments of this application means that the radiator is not directly connected to a feed line/feed stub and/or a ground cable/ground stub, but is fed and/or grounded in an indirect coupling manner.

It should be understood that "floating" in the "floating end" and the "floating radiator" does not mean that there is no structure around the radiator to support the radiator. In an embodiment, the floating radiator may be, for example, a radiator provided on an inner surface of an insulation rear cover.

That currents are codirectional/reverse in embodiments of this application should be understood as that directions of main currents on conductors on a same side are the same or reverse. For example, when codirectionally distributed currents are excited on a bent conductor or an annular conductor (for example, a current path is also bent or annular), it should be understood that, for example, although directions of main currents excited on conductors on two sides of the annular conductor (for example, on conductors on two sides of a slot in conductors around the slot) are reverse, the main currents still fall within a definition of codirectionally distributed currents in embodiments of this application. In an embodiment, that currents on a conductor are in a same direction may mean that the currents on the conductor have no reverse point. In an embodiment, that currents on a conductor are in reverse directions may mean that the currents on the conductor have at least one reverse point. In an embodiment, that currents on two conductors are in a same direction may mean that none of the currents on the two conductors has a reverse point and the currents flow in the same direction. In an embodiment, that currents on two conductors are in reverse directions may mean that none of the currents on the two conductors has a reverse point and the currents flow in the reverse directions. It may be correspondingly understood that directions of currents on a plurality of conductors are codirectional/reverse.

Resonance/resonance frequency: The resonance frequency is also called a resonant frequency. The resonance frequency may have a frequency range, namely, a frequency range in which a resonance occurs. A frequency corresponding to a strongest resonance point is a center frequency. A return loss of the center frequency may be less than -20 dB. It should be understood that, unless otherwise specified, an antenna/a radiator generates a "first/second ... resonance" in this application, where the first resonance should be a fundamental mode resonance generated by the antenna/radiator, or a resonance that is generated by the antenna/radiator and that has a lowest frequency. It should be understood that the antenna/radiator may generate one or more antenna modes based on specific design, and one fundamental mode resonance may be correspondingly generated in each antenna mode.

Resonance frequency band: A range of a resonance frequency is the resonance frequency band, and a return loss of any frequency on the resonance frequency band may be less than -6 dB or -5 dB.

Communication frequency band/operating frequency band: Regardless of a type of antenna, the antenna always operates in a specific frequency range (a frequency bandwidth). For example, an operating frequency band of an antenna supporting a B40 frequency band includes a frequency in a range of 2300 MHz to 2400 MHz. In other words, an operating frequency band of the antenna includes a B40 frequency band. A frequency range that meets a requirement of an indicator may be considered as an operating frequency band of the antenna.

A resonance frequency band and the operating frequency band may be the same, or may partially overlap. In an embodiment, one or more resonance frequency bands of the antenna may cover one or more operating frequency bands of the antenna.

Electrical length: The electrical length may be a ratio of a physical length (namely, a mechanical length or a geometric length) to a wavelength of a transmitted electromagnetic wave, and the electrical length may meet the following formula:

$$\overline{L} = \frac{L}{\lambda},$$

where
L is a physical length, and $\lambda$ is a wavelength of an electromagnetic wave.

Wavelength: The wavelength or an operating wavelength may be a wavelength corresponding to a center frequency of a resonance frequency or a center frequency of an operating frequency band supported by an antenna. For example, it is assumed that a center frequency of a B1 uplink frequency band (with a resonance frequency ranging from 1920 MHz to 1980 MHz) is 1955 MHz, the operating wavelength may be a wavelength calculated by using the frequency of 1955 MHz. The "operating wavelength" is not limited to the center frequency, and may alternatively be a wavelength corresponding to a non-center frequency of the resonance frequency or the operating frequency band.

It should be understood that a wavelength of a radiation signal in the air may be calculated as follows: (Air wavelength or vacuum wavelength)=Speed of light/Frequency, where the frequency is a frequency (MHz) of the radiation signal, and the speed of light may be $3\times108$ m/s. The wavelength of the radiation signal in the dielectric may be calculated as follows:

$$\text{Dielectric wavelength}=(\text{Speed of light}/\sqrt{\varepsilon})/\text{Frequency},$$

where $\varepsilon$ is a relative dielectric constant of the dielectric. The wavelength in embodiments of this application is usually a dielectric wavelength, and may be a dielectric wavelength corresponding to the center frequency of the resonance frequency, or a dielectric wavelength corresponding to the center frequency of the operating frequency band supported by the antenna. For example, it is assumed that a center frequency of a B1 uplink frequency band (with a resonance frequency ranging from 1920 MHz to 1980 MHz) is 1955 MHz, the wavelength may be a dielectric wavelength calculated by using the frequency of 1955 MHz. The "dielectric wavelength" is not limited to the center frequency, and may alternatively be a dielectric wavelength corresponding to the non-center frequency of the resonance frequency or the operating frequency band. For ease of understanding, the dielectric wavelength mentioned in embodiments of this application may be simply calculated by using a relative dielectric constant of the medium filled on one or more sides of the radiator.

Total efficiency (total efficiency) of an antenna: The total efficiency of the antenna is a ratio of input power to output power at an antenna port.

Radiation efficiency (radiation efficiency) of an antenna: The radiation efficiency of the antenna is a ratio of power radiated by the antenna to space (namely, power for effectively converting an electromagnetic wave) to active power input to the antenna. Active power input to the antenna=Input power of the antenna-Loss power. The loss power mainly includes return loss power and metal ohmic loss power and/or dielectric loss power. The radiation efficiency is a value for measuring a radiation capability of an antenna. Both a metal loss and a dielectric loss are factors that affect the radiation efficiency.

A person skilled in the art may understand that the efficiency is usually indicated by a percentage, and there is a corresponding conversion relationship between the efficiency and dB. Efficiency closer to 0 dB indicates better antenna efficiency.

Antenna return loss: The antenna return loss may be understood as a ratio of power of a signal reflected back to an antenna port through an antenna circuit to transmit power of the antenna port. A smaller reflected signal indicates a larger signal radiated by the antenna to space and higher radiation efficiency of the antenna. A larger reflected signal indicates a smaller signal radiated by the antenna to space and lower radiation efficiency of the antenna.

The antenna return loss may be represented by an S11 parameter, and S11 is one of S parameters. S11 indicates a reflection coefficient, and the parameter can represent transmit efficiency of the antenna. The S11 parameter is usually a negative number. A smaller S11 parameter indicates a smaller antenna return loss, less energy reflected back by the antenna, namely, more energy that actually enters the antenna, and higher total efficiency of the antenna. A larger S11 parameter indicates a larger antenna return loss and lower total efficiency of the antenna.

It should be noted that, -6 dB is usually used as a standard value of S11 in engineering. When the value of S11 of the antenna is less than -6 dB, it may be considered that the antenna can operate normally, or it may be considered that transmit efficiency of the antenna is good.

Antenna pattern: The antenna pattern is also referred to as a radiation pattern, is a pattern in which relative field strength (a normalized modulus value) of a radiation field of an antenna changes with a direction at a specific distance from the antenna (a far field), and is usually represented by two plane radiation patterns that are perpendicular to each other in a maximum radiation direction of the antenna.

The antenna pattern usually includes a plurality of radiation beams. A radiation beam with highest radiation strength is referred to as a main lobe, and another radiation beam is referred to as a minor lobe or side lobe. In minor lobes, a minor lobe in an opposite direction of the main lobe is also referred to as a back lobe.

Directivity (directivity): also referred to as directionality of an antenna, is a ratio of a maximum power density to an average value in an antenna pattern at a specific distance from the antenna (a far field), is a dimensionless ratio greater than or equal to 1, and may indicate an energy radiation characteristic of the antenna. Higher directivity indicates a larger proportion of energy radiated by the antenna in a direction, and more concentrated energy radiation.

Antenna gain: The antenna gain represents a degree to which the antenna intensively radiates input power. Usually, a narrower main lobe of the antenna pattern indicates a smaller minor lobe, and a higher antenna gain.

Polarization direction of an antenna: At a given point in space, electric field strength E (a vector) is a function of time t. A vector endpoint periodically depicts a trajectory in space over time. Polarization is referred to as vertical polarization if the trajectory is a straight line and perpendicular to the ground. Polarization is referred to as horizontal polarization if the trajectory is horizontal to the ground. Polarization is referred to as right-hand circular polarization (right-hand circular polarization, RHCP) if the trajectory is an ellipse or a circle and rotates right-handed or clockwise with the time when viewed in a propagation direction. Polarization is referred to as left-hand circular polarization (left-hand circular polarization, LHCP) if the trajectory is an ellipse or a circle and rotates left-handed or anticlockwise with the time when viewed in a propagation direction.

Ground (Ground plane) (ground, GND): The ground (ground plane) may generally mean at least a part of any grounding plane, grounding plate, ground metal layer, or the like in an electronic device (like a mobile phone), or at least a part of any combination of the foregoing grounding plane, grounding plate, ground component, or the like. The "ground" may be configured to ground components in the electronic device. In an embodiment, the "ground" may be a grounding plane of a circuit board of the electronic device, or may be a grounding plate formed by a middle frame of the electronic device or a ground metal layer formed by a metal film below a screen of the electronic device. In an embodiment, the circuit board may be a printed circuit board (printed circuit board, PCB), for example, an 8-layer board, a 10-layer board, a 12-layer board, a 13-layer board, or a 14-layer board having 8, 10, 12, 13, or 14 layers of conductive materials respectively, or an element that is separated and electrically insulated by a dielectric layer or an insulation layer like a glass fiber or a polymer. In an embodiment, the circuit board includes a dielectric substrate, a grounding plane, and a wiring layer. The wiring layer and the grounding plane are electrically connected through a via hole. In an embodiment, components such as a display, a touchscreen, an input button, a transmitter, a processor, a memory, a battery, a charging circuit, and a system on chip (system on chip, SoC) structure may be installed on or connected to the circuit board, or electrically connected to the wiring layer and/or the grounding plane in the circuit board. For example, a radio frequency source is provided at the wiring layer.

Any of the foregoing ground layers, or ground planes, or ground metal layers is made of conductive materials. In an embodiment, the conductive material may be any one of the following materials: copper, aluminum, stainless steel, brass and alloys thereof, copper foil on insulation laminates, aluminum foil on insulation laminates, gold foil on insulation laminates, silver-plated copper, silver-plated copper foil on insulation laminates, silver foil on insulation laminates and tin-plated copper, cloth impregnated with graphite powder, graphite-coated laminates, copper-plated laminates, brass-plated laminates and aluminum-plated laminates. A person skilled in the art may understand that the ground layer/ground plane/ground metal layer may alternatively be made of other conductive materials.

Grounding: The grounding refers to coupling with the ground/ground plane in any manner. In an embodiment, the grounding may be grounding by using an entity, for example, grounding by using an entity (or referred to as entity grounding) at a specific position on the side frame is implemented by using some mechanical parts of the middle frame. In an embodiment, the grounding may be grounding by using a component, for example, grounding by using a component (or referred to as component grounding) like a capacitor/inductor/resistor connected in series or in parallel.

The following describes technical solutions of embodiments in this application with reference to accompanying drawings.

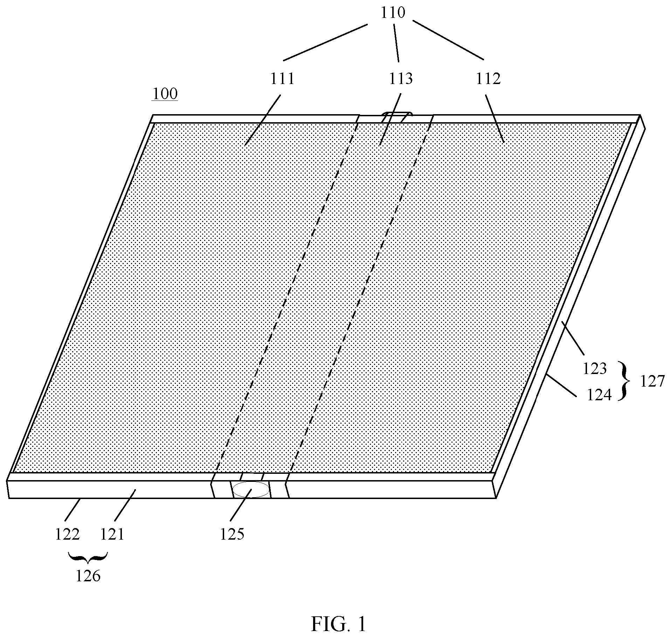

FIG. 1 is a diagram of a structure of a foldable electronic device 100 according to an embodiment of this application. The foldable electronic device 100 may be an electronic device with a folding function, for example, a mobile phone, a tablet computer, an e-reader, a notebook computer, or a wearable device such as a watch. The embodiment shown in FIG. 1 is described by using a foldable mobile phone as an example.

Refer to FIG. 1. The foldable electronic device 100 may include a flexible display 110, a first side frame 121, a first cover body 122, a second side frame 123, a second cover body 124, and a rotating shaft 125. In some embodiments, the first side frame 121, the first cover body 122, the second side frame 123, and the second cover body 124 may form a first housing 126 and a second housing 127 that support the flexible display 110. In some other embodiments, at least one of the first cover body 122 and the second cover body 124 may include a display.

A lattice pattern filled in FIG. 1 may schematically represent the flexible display 110. The flexible display 110 may have features of strong flexibility and bendability, and may provide a user with a new bendability-based interaction mode. For example, a display panel of the flexible display 110 may be any one of a flexible liquid crystal display (liquid crystal display, LCD), an organic light-emitting diode (organic light-emitting diode, OLED), an active-matrix organic light emitting diode (active-matrix organic light emitting diode, AMOLED), a flexible light emitting diode (flex light-emitting diode, FLED), or a quantum dot light emitting diode (quantum dot light emitting diodes, QLED). This is not limited in this embodiment of this application.

The flexible display 110 may include a first display part 111 corresponding to the first housing 126, a second display part 112 corresponding to the second housing 127, and a foldable display part 113 corresponding to the rotating shaft 125. The foldable display part 113 may be connected between the first display part 111 and the second display part 112.

The first side frame 121 may surround a periphery of the first cover body 122, and at least a part of the first side frame 121 may further surround a periphery of the first display part 111. The first display part 111 and the first cover body 122 may be spaced apart in parallel, and the first display part 111 and the first cover body 122 may be located on two sides of the first side frame 121. Space between the first display part 111 and the first cover body 122 may be provided with a component of the foldable electronic device 100, for example, an antenna or a circuit board component.

The second side frame 123 may surround a periphery of the second cover body 124, and at least a part of the second side frame 123 may further surround a periphery of the second display part 112. The second display part 112 and the second cover body 124 may be spaced apart in parallel, and the second display part 112 and the second cover body 124 may be located on two sides of the second side frame 123. Space between the second display part 112 and the second cover body 124 may be provided with a component of the foldable electronic device 100, for example, an antenna or a circuit board component.

In an embodiment provided in this application, the cover body and the side frame may be two parts of the housing of the foldable electronic device 100. The cover body and the side frame may be connected, and a form of the connection may not belong to an assembly manner such as clamping, bonding, welding, riveting, or clearance fit. A connection relationship between the cover body and the side frame is usually difficult to divide. In another embodiment provided in this application, the cover body and the side frame may be two different parts. The housing of the foldable electronic device 100 may be formed by assembling the cover body and the side frame.

At least a part of the side frame may serve as a radiator of an antenna to transmit/receive a radio frequency signal, and there may be a slot between the part of the side frame that serves as the radiator and another part of the cover body, to ensure that the radiator of the antenna has a good radiation environment. In an embodiment, the cover body may be provided with a gap at the part of the side frame that serves as the radiator, to facilitate radiation of the antenna.

The antenna of the electronic device 100 may be further provided in the side frame. When the side frame of the electronic device 100 is made of a non-conductive material, the radiator of the antenna may be located in the electronic device 100 and provided along the side frame. For example, the radiator of the antenna is provided close to the side frame, to reduce a volume occupied by the radiator of the antenna as much as possible, and be closer to the outside of the electronic device 100, so as to implement better signal transmission effect. It should be noted that, that the radiator of the antenna is provided close to the side frame means that the radiator of the antenna may be provided in close contact with the side frame, or may be provided close to the side frame. For example, there may be a specific small slot between the radiator of the antenna and the side frame.

The antenna of the electronic device 100 may be further provided in the housing, for example, a bracketed antenna or a millimeter-wave antenna (not shown in FIG. 1). Clearance of the antenna provided in the housing may be obtained by using a slit/hole in any one of the cover body, and/or the side frame, and/or the display, or by using a non-conductive slot/aperture formed between any several of the cover body, and/or the side frame, and/or the display. The clearance of the antenna may be provided, to ensure radiation performance of the antenna. It should be understood that the clearance of the antenna may be a non-conductive area formed by any conductive member in the electronic device 100, and the antenna radiates a signal to external space through the non-conductive area. In an embodiment, the antenna may be in an antenna form such as an antenna form based on a flexible motherboard (flexible printed circuit, FPC), an antenna form based on laser-direct-structuring (laser-direct-structuring, LDS), or a microstrip disk antenna (microstrip disk antenna, MDA). In an embodiment, the antenna may alternatively use a transparent structure embedded into a display of the electronic device 100, so that the antenna is a transparent antenna element embedded into the display of the electronic device 100.

The foldable electronic device 100 may further include a printed circuit board PCB (not shown in the figure). The PCB is provided in a cavity formed by the cover body. The PCB may be a flame-resistant material (FR-4) dielectric board, or may be a Rogers (Rogers) dielectric board, or may be a hybrid dielectric board of Rogers and FR-4, or the like. Herein, FR-4 is a grade designation of a flame-resistant material, and the Rogers dielectric board is a high-frequency board. An electronic element, for example, a radio frequency integrated circuit, is carried on the PCB 17. In an embodiment, a metal layer may be provided on the printed circuit board PCB. The metal layer may be used for grounding the electronic element carried on the printed circuit board PCB, or may be used for grounding another element, for example, a bracket antenna or a side frame antenna. The metal layer may be referred to as a ground, a grounding plate, or a grounding plane. In an embodiment, the metal layer may be formed by etching metal on a surface of any dielectric board in the PCB. In an embodiment, the metal layer used for grounding may be provided on a side that is of the printed circuit board PCB and that is close to the flexible display 110. In an embodiment, an edge of the PCB may be considered as an edge of the grounding plane of the PCB. The electronic device 100 may further have another ground plane/grounding plate/grounding plane. As described above, details are not described herein again.

The rotating shaft 125 may be connected between the first housing 126 and the second housing 127. Under an action of the rotating shaft 125, the first housing 126 and the second housing 127 may be close to or away from each other. Correspondingly, the first display part 111 of the flexible display 110 and the second display part 112 of the flexible display 110 may be close to or far away from each other, so that the flexible display 110 may be folded or unfolded.

In an example, the rotating shaft 125 may include, for example, a main shaft, a first connection component, and a second connection component. The first connection component may be fastened to the first cover body 122, the second connection component may be fastened to the second cover body 124, and the first connection component and the second connection component may rotate relative to the main shaft. Mutual movement between the first connection component and the second connection component may drive mutual movement between the first housing 126 and the second housing 127, to implement folding and unfolding functions of the foldable electronic device 100.

The foldable electronic device 100 shown in FIG. 1 is currently in an unfolded state. In the unfolded state, an angle between the first housing 126 and the second housing 127 may be about 180°. The flexible display 110 may be in the unfolded state shown in FIG. 1.

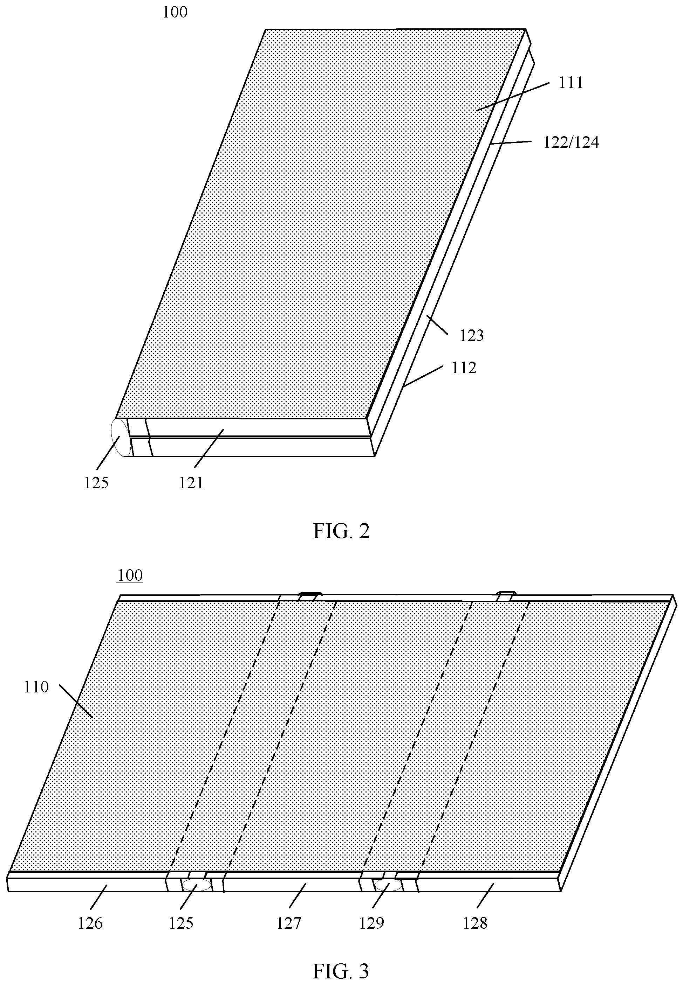

FIG. 2 shows a possible folded state of the foldable electronic device 100. FIG. 2 shows an outward folded state (the outward folded state may be referred to as an outward-folded state for short) of the foldable electronic device 100. The outward folded state shown in FIG. 2 may be, for example, a left-right outward folded state or a top-down outward folded state. With reference to FIG. 1 and FIG. 2, the following describes a possible folded state of the foldable electronic device 100.

In this embodiment of this application, that the foldable electronic device 100 is in a folded state may mean that the foldable electronic device 100 is currently bent, and the foldable electronic device 100 reaches a maximum bending degree. In this case, the first cover body 122 and the second cover body 124 may be approximately parallel to each other, spaced from each other, or provided face to face. In addition, a spacing distance between the first cover body 122 and the second cover body 124 is minimal, and at least a part of the first housing 126 and at least a part of the second housing 127 are accommodated in space enclosed by the flexible display 110. The first display part 111, the first housing 126, the second housing 127, and the second display part 112 are sequentially stacked. Similarly, the first display part 111 and the second display part 112 may be approximately parallel to each other, and are spaced from each other. A spacing distance between the first cover body 122 and the second cover body 124 is less than a spacing distance between the first display part 111 and the second display part 112. In this case, the first display part 111 and the second display part 112 may be considered to be located on different planes.

With reference to FIG. 1 and FIG. 2, when the foldable electronic device 100 is in the outward folded state, the first cover body 122 and the second cover body 124 may be close to each other, and the first display part 111 and the second display part 112 may be close to each other. The first display part 111, the second display part 112, and the foldable display part 113 may form a housing area used to accommodate the first cover body 122, the second cover body 124, and the rotating shaft 125. That is, the first cover body 122, the second cover body 124, and the rotating shaft 125 may be accommodated in space between the first display part 111 and the second display part 112.

It should be understood that the foldable electronic device 100 may be folded inward (the inward folded state may be referred to as an inward-folded state for short). When the foldable electronic device 100 is in the inward folded state, the first cover body 122 and the second cover body 124 may be close to each other, and the first display part 111 and the second display part 112 may be close to each other. The first cover body 122, the second cover body 124, and the rotating shaft 125 may form a housing area used to accommodate the first display part 111, the second display part 112, and the foldable display part 113. In other words, the first display part 111, the second display part 112, and the foldable display part 113 may be accommodated in space between the first cover body 122 and the second cover body 124.

The foldable electronic device 100 may be switched between a folded state and an unfolded state. When the foldable electronic device 100 is in the folded state, space occupied by the foldable electronic device 100 is small. When the foldable electronic device 100 is in the unfolded state, the foldable electronic device 100 may display a large screen, to increase a viewing range of a user.

The foldable electronic device 100 may further include a third housing 128 and a rotating shaft 129, as shown in FIG. 3. The rotating shaft 129 may be connected between the third housing 128 and the second housing 127. The third housing 128 and the second housing 127 may be close to or far away from each other. As a quantity of foldable parts of the foldable electronic device 100 increases, in a case in which a same screen size is maintained in the unfolded state, space occupied by the foldable electronic device 100 may be further reduced in the folded state.

However, the foldable electronic device 100 shown in FIG. 3 has three foldable parts (the first housing 126, the second housing 127, and the third housing 128). Therefore, the foldable electronic device 100 has three forms: 1, an unfolded state. 2, a folded state, and 3, a partially-unfolded state.

1. FIG. 3 shows a possible unfolded state of the foldable electronic device 100. In the unfolded state, angles among the first housing 126, the second housing 127, and the third housing 128 may be about 180°. The flexible display 110 may be in the unfolded state.

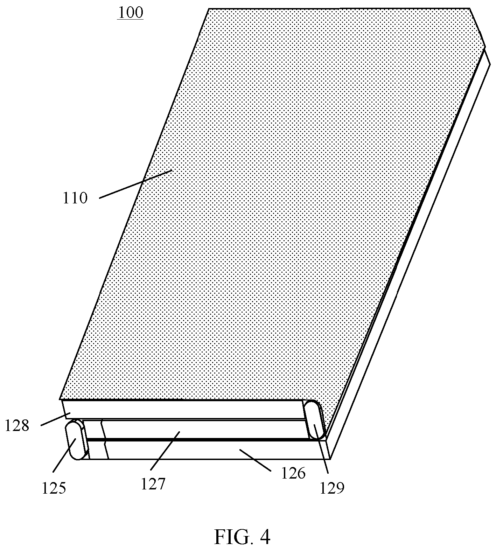

2. FIG. 4 shows a possible folded state (a triple-fold state) of the foldable electronic device 100. In the folded state, the first housing 126 and the second housing 127 rotate along the rotating shaft 125, and the second housing 127 and the third housing 128 rotate along the rotating shaft 129, so that the foldable electronic device 100 reaches a maximum bending degree. In this case, the first housing 126, the second housing 127, and the third housing 128 may be considered to be located on different planes. It should be understood that, for brief description, in the structure shown in FIG. 4, the foldable electronic device 100 is in an S-folded state (a side surface of the foldable electronic device 100 is S-shaped, and the second housing 127 is located between the first housing 126 and the third housing 128). In an embodiment, the foldable electronic device 100 may also be in a G-folded state (a side surface of the foldable electronic device 100 is G-shaped, and the third housing 128 is located between the first housing 126 and the second housing 127). The folded state of the foldable electronic device 100 is not limited in this embodiment of this application.

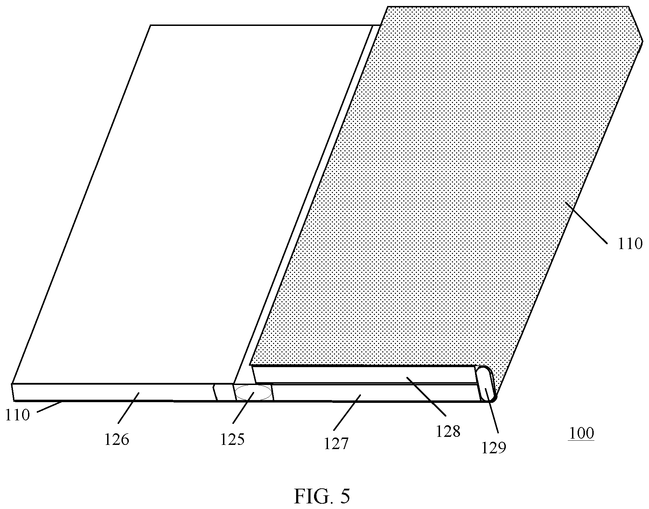

3. FIG. 5 shows a possible partially-unfolded state (a two-folded state) of the foldable electronic device 100. In a partially-unfolded state, an angle between the first housing 126 and the second housing 127 may be about 180°, and the second housing 127 and the third housing 128 rotate along the rotating shaft 129, so that the third housing 128 approaches the second housing 127. In this case, the first housing 126 and the second housing 127 are considered to be located on a same plane, and the second housing 127 and the third housing 128 may be considered to be located on different planes. In another possible partially-unfolded state, an angle between the third housing 128 and the second housing 127 may be about 180°, and the first housing 126 and the second housing 127 rotate along the rotating shaft 125, so that the first housing 126 approaches the second housing 127.

FIG. 1 shows only an example of some parts included in the electronic device 100. Actual shapes, actual sizes, and actual structures of these parts are not limited to those in FIG. 1.

It should be understood that, in embodiments of this application, it may be considered that a surface on which the display of the electronic device is located is a front surface, a surface on which the rear cover is located is a rear surface, and a surface on which the side frame is located is a side surface.

It should be understood that, in embodiments of this application, it is considered that when a user holds the electronic device (the user usually holds the electronic device vertically and faces the display), orientations of the electronic device include the top, the bottom, the left, and the right. It should be understood that, in embodiments of this application, it is considered that when a user holds the electronic device (the user usually holds the electronic device vertically and faces the display), orientations of the electronic device include the top, the bottom, the left, and the right.

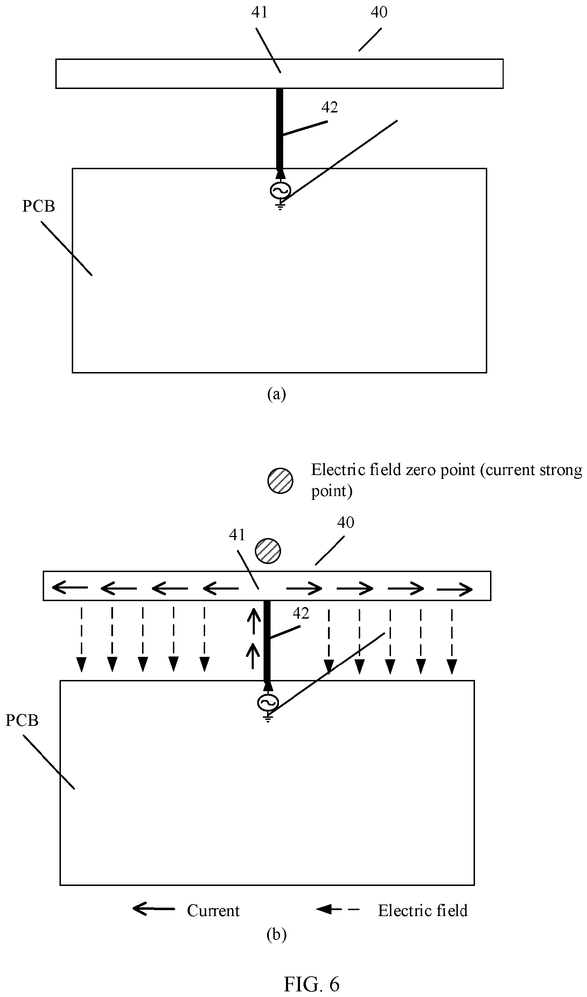

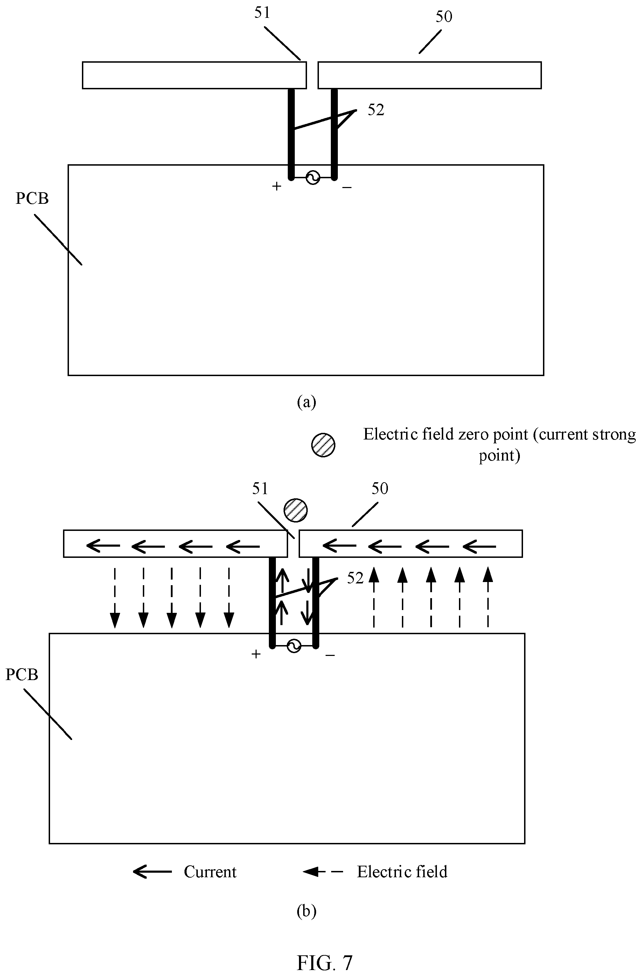

First, FIG. 6 and FIG. 7 are used to describe two antenna modes in this application. FIG. 6 is diagrams of a structure in a common mode of an antenna and corresponding current and electric field distribution according to this application. FIG. 7 is diagrams of a structure in a differential mode of another antenna and corresponding current and electric field distribution according to this application. As shown in FIG. 6 and FIG. 7, two ends of an antenna radiator are open, and a common mode and a differential mode of the antenna radiator may be respectively referred to as a wire common mode and a wire differential mode.

It should be understood that a "common-differential mode" or a "CM-DM mode" in this application is a wire common mode and a wire differential mode that are generated on a same radiator.

1. Wire (Wire) common mode (common mode, CM)

(a) in FIG. 6 shows that two ends of a radiator of an antenna 40 are open, and a feed circuit (not shown in the figure) is connected to a middle position 41. In an embodiment, the antenna 40 adopts a symmetrical feed (symmetrical feed) form. The feed circuit may be connected to the middle position 41 of the antenna 40 through a feed line 42. It should be understood that symmetrical feed may be understood as that one end of the feed circuit is connected to the radiator and the other end of the feed circuit is coupled to a ground plane to implement grounding. A connection point (feed point) between the feed circuit and the radiator is located in the center of the radiator. The center of the radiator may be, for example, a midpoint of a geometric structure, or a midpoint of an electrical length (or an area within a specific range near the midpoint).

The middle position 41 of the antenna 40 may be, for example, a geometric center of the antenna, or a midpoint of an electrical length of the radiator. For example, a connection joint between the feed line 42 and the antenna 40 covers the middle position 41.

(b) in FIG. 6 shows current and electric field distribution of the antenna 40. As shown in (b) in FIG. 6, currents are reversely distributed, for example, symmetrically distributed, on two sides of the middle position 41; and electric fields are codirectionally distributed on the two sides of the middle position 41. As shown in (b) in FIG. 6, currents at the feed line 42 are codirectionally distributed. Based on the codirectional distribution of the currents at the feed line 42, such feeding shown in (a) in FIG. 6 may be referred to as wire CM feeding. Currents are reversely distributed on two sides of the connection joint between the radiator and the feed line 42. In this case, the antenna mode shown in (b) in FIG. 6 may be referred to as the wire CM mode (which may also be referred to as the CM mode for short, for example, for a wire antenna, the CM mode is a wire CM mode). A current and an electric field shown in (b) in FIG. 6 may be respectively referred to as a current and an electric field in the wire CM mode.

The current is large at the middle position 41 of the antenna 40 (a current strong point is near the middle position 41 of the antenna 40), and is small at two ends of the antenna 40, as shown in (b) in FIG. 6. The electric field is weak at the middle position 41 of the antenna 40, and is strong at the two ends of the antenna 40.

2. Wire differential mode (differential mode, DM)

As shown in (a) in FIG. 7, left and right ends of two radiators of an antenna 50 are open ends, and a feed circuit is connected to a middle position 51. In an embodiment, the antenna 50 adopts an anti-symmetrical feed (anti-symmetrical feed) form. One end of the feed circuit is connected to one of the radiators through a feed line 52, and the other end of the feed circuit is connected to the other one of the radiators through a feed line 52. The middle position 51 may be a geometric center of the antenna 50, or a slot formed between the radiators.

It should be understood that, "central anti-symmetrical feed" mentioned in this application may be understood as that a positive electrode and a negative electrode of the feed unit are respectively connected to two connection points near the midpoint of the radiator. In an embodiment, signals output from the positive and negative electrodes of the feed unit have a same amplitude but opposite phases. For example, a phase difference is $180° \pm 10°$.

(b) in FIG. 7 shows current and electric field distribution of the antenna 50. As shown in (b) in FIG. 7, currents are codirectionally distributed, for example, anti-symmetrically distributed, on two sides of the middle position 51 of the antenna 50; and electric fields are reversely distributed on the two sides of the middle position 51. As shown in (b) in FIG. 7, currents at the feed line 52 are reversely distributed. Based on the reverse distribution of the currents at the feed line 52, such feeding shown in (a) in FIG. 7 may be referred to as wire DM feeding. Currents are codirectionally distributed on two sides of a connection joint between the radiator and the feed line 52. In this case, the antenna mode shown in (b) in FIG. 7 may be referred to as the wire DM mode (which may also be referred to as the DM mode for short, for example, for a wire antenna, the DM mode is a wire DM mode). A current and an electric field shown in (b) in FIG. 7 may be respectively referred to as a current and an electric field in the wire DM mode. It should be understood that, based on the currents being codirectionally distributed on the two sides of the connection joint between the radiator and the feed line 52, such an antenna mode shown in (b) in FIG. 7 may also be referred to as a one-half antenna mode or a one-half wavelength mode, or may be referred to as a one-half mode for short.

In an embodiment, in the wire DM mode or the one-half mode, the currents are large at the middle position 51 of the antenna 50 (a current strong point is near the middle position 51 of the antenna 50), and are small at two ends of the antenna 50, as shown in (b) in FIG. 7. The electric field is weak at the middle position 51 of the antenna 50, and is strong at the two ends of the wire antenna 50.

It should be understood that, the radiator of the antenna may be understood as a metal mechanical part that generates radiation, and there may be one radiator as shown in FIG. 6, or may be two radiators as shown in FIG. 7, which may be adjusted based on an actual design or production requirement. For example, for the wire CM mode, two radiators may also be used as shown in FIG. 7, two ends of the two radiators are opposite to each other and are spaced apart with a slot, and a symmetrical feed manner is used for the ends that are close to each other. For example, effect similar to that of the antenna structure shown in FIG. 6 may also be achieved by separately feeding a same feed signal into the ends that are of the two radiators and that are close to each other. Correspondingly, for the wire DM mode, one radiator may also be used as shown in FIG. 6, two feed points are provided at a middle position of the radiator, and an anti-symmetrical feed manner is used. For example, effect similar to that of the antenna structure shown in FIG. 7 may also be achieved if signals of a same amplitude but opposite phases are respectively fed at two symmetrical feed points on the radiator.

3. Wire CM-DM mode

FIG. 6 and FIG. 7 respectively show that when two ends of a radiator are open, a wire CM mode and a wire DM mode are respectively generated in different feed manners.

When an antenna adopts an asymmetric feed form (including a side feed form and an offset feed form, where a feed point deviates from a middle position of the radiator), or a ground point (a position coupled to a ground plane) of the radiator is asymmetric (the ground point deviates from the middle position of the radiator), the antenna may generate both a first resonance and a second resonance, which respectively correspond to the wire CM mode and the wire DM mode. For example, the first resonance corresponds to the wire CM mode, and current and electric field distribution is shown in (b) in FIG. 6. The second resonance corresponds to the wire DM mode, and current and electric field distribution is shown in (b) in FIG. 7.

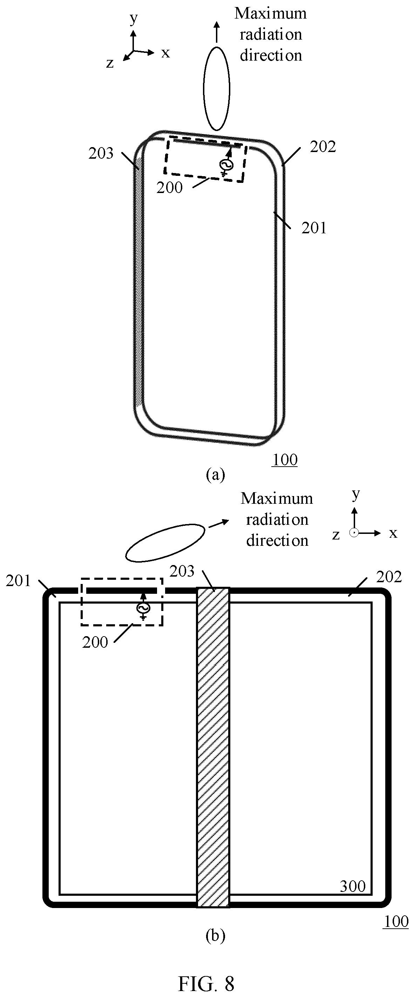

FIG. 8 is diagrams of maximum radiation directions of radiation patterns generated by an antenna 200 in a foldable electronic device 100 according to an embodiment of this application.

It should be understood that, for brevity of description, only an example in which the foldable device 100 includes only a first housing 201 and a second housing 202 is used for description. The first housing 201 and the second housing 202 may be rotatably connected to a rotating shaft 203.

As shown in (a) in FIG. 8, in a folded state, a maximum radiation direction of a radiation pattern generated by the antenna 200 is a top direction (for example, a y direction) of the foldable electronic device 100.

As shown in (b) in FIG. 8, in an unfolded state, because a size of a ground plane 300 increases in an x direction, a current on the ground plane 300 has impact on the maximum radiation direction of the radiation pattern generated by the antenna 200, causing the maximum radiation direction to deviate from the top direction (for example, the y direction) (for example, deflect to the x direction).

When a user performs satellite communication, the electronic device needs to point to a satellite in a specific orientation, to implement satellite alignment (establish a communication connection to the satellite). When the foldable electronic device 100 is in the unfolded state, the maximum radiation direction of the radiation pattern generated by the antenna 200 deviates from the top direction (for example, the y direction) of the foldable electronic device 100, and the user needs to adjust a posture of holding the foldable electronic device 100 to communicate with the satellite. Second, the maximum radiation directions of the radiation patterns generated by the antenna 200 when the foldable electronic device 100 is in the folded state and the unfolded state are different. Therefore, when the user switches a state of the foldable electronic device 100 during satellite communication, if the user does not change the posture of holding the foldable electronic device 100, communication quality deteriorates. To improve communication quality, the user needs to adjust the posture of holding the foldable electronic device 100, so that the maximum radiation direction points to the satellite, to obtain better communication quality. This causes great inconvenience in use.

However, if the foldable electronic device 100 is in the unfolded state, the maximum radiation direction of the radiation pattern generated by the antenna 200 basically points to the top direction (for example, the y direction) of the electronic device 100, for example, has an included angle within a predetermined angle with the y direction. During satellite communication, a communication connection can be conveniently established to the satellite by using the foldable electronic device 100. Second, if the maximum radiation directions of the radiation patterns generated by the antenna 200 when the foldable electronic device 100 is in the folded state and the unfolded state are the same (for example, both are the top direction (for example, the y direction) of the foldable electronic device 100), during satellite communication, a state (the folded state or the unfolded state) of the foldable electronic device 100 is changed, and the user does not need to change the posture of holding the foldable electronic device 100.

Embodiments of this application provide a foldable electronic device. The foldable electronic device includes an antenna, and a conductive part of a side frame of the foldable electronic device is used as a main radiator and a parasitic stub of the antenna, to improve user experience during satellite communication.

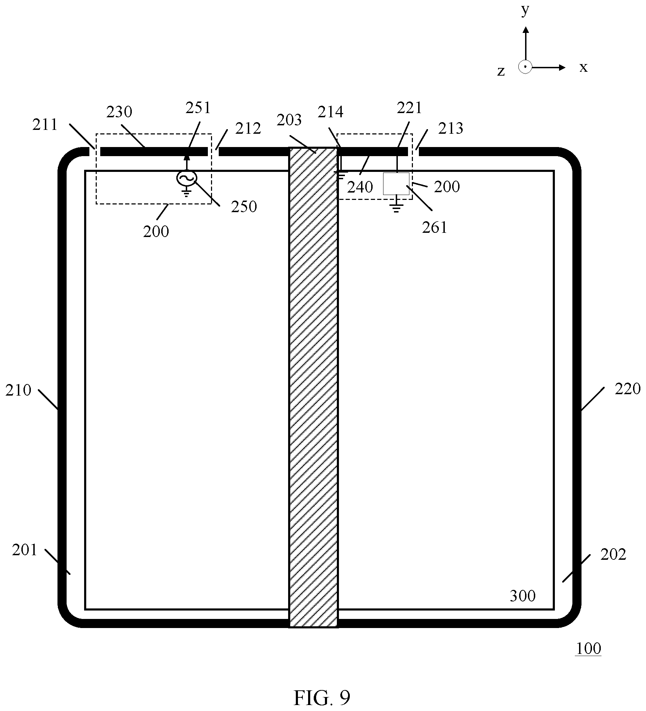

FIG. 9 is a diagram of a foldable electronic device 100 according to an embodiment of this application.

As shown in FIG. 9, the foldable electronic device 100 may include a first housing 201, a second housing 202, and a ground plane 300.

It should be understood that the ground plane 300 in this embodiment of this application has different sizes in different states of the foldable electronic device 100. In an embodiment, when the foldable electronic device 100 is in a folded state, a ratio of a length to a width of the ground plane 300 is greater than or equal to 1.6 and less than or equal to 2.5. The width may be understood as a size of the ground plane 300 in an extension direction of a top edge (top side) or a bottom edge (bottom side) of the foldable electronic device 100. In an embodiment, when the foldable electronic device 100 is in an unfolded state, a length of the foldable electronic device 100 remains unchanged, a width of the foldable electronic device 100 increases, and a ratio of the length to the width of the ground plane 300 is greater than or equal to 0.8 and less than or equal to 1.5.

The width and the length of the ground plane 300 may be understood as sizes of all equivalent ground planes that are formed by a metal layer or a metal piece (for example, a middle plate, a metal layer in a PCB, or a metal layer in a display) that can be equivalent to the ground plane in an extension direction of the width and an extension direction of the length.

The first housing 201 includes a first side frame 210, and at least a part of the first side frame 210 and the ground plane 300 are spaced apart. The second housing 202 includes a second side frame 220, and at least a part of the second side frame 220 and the ground plane 300 are spaced apart.

The first side frame 210 includes a first position 211 and a second position 212. The first side frame 210 is provided with a first slot and a second slot at the first position 211 and the second position 212 respectively.

In an embodiment, a width of the first slot/second slot is greater than or equal to 0.1 mm and less than or equal to 2 mm. It should be understood that, in this embodiment of this application, widths of the slots provided on the side frame may all fall within the foregoing range.

The second side frame 220 includes a third position 213 and a fourth position 214. The second side frame 220 is provided with a third slot at the third position 213. In an embodiment, the second side frame 220 is coupled to the ground plane 300 at the fourth position 214. In an embodiment, the foldable electronic device 100 is in the unfolded state, and the fourth position 214 is located between the second position 212 and the third position 213.

It should be understood that, in this embodiment of this application, a coupling connection is described by using only an electrical connection as an example. In actual production or practice, the coupling connection may also be implemented through indirect coupling. For brevity of description, details are not described again. In addition, for brevity of description, in this embodiment of this application, only an example in which the fourth position 214 is located between the second position 212 and the third position 213 is used for description. In actual production or design, the third position 213 may alternatively be located between the second position 212 and the fourth position 214.

The first position 211 and the second position 212 may be located on a first side of the first side frame 210, and the third position 213 may be located on a second side of the second side frame 220. In an embodiment, the fourth position 214 may be located on the second side of the second side frame 220. When the foldable electronic device 100 is in the unfolded state, the first side and the second side may be a same side of the foldable electronic device 100, for example, a top side or a bottom side. In an embodiment, a ratio of a size (a width of the foldable electronic device 100) of the ground plane 300 in an extension direction of the first side when the foldable electronic device 100 is in the unfolded state to a size (a width of the foldable electronic device 100) of the ground plane 300 in the extension direction of the first side when the foldable electronic device 100 is in the folded state is greater than or equal to 1.8 and less than or equal to 2.2.

The foldable electronic device 100 may further include a rotating shaft 203. The rotating shaft 203 is located between the first housing 201 and the second housing 202, and the rotating shaft 203 is rotatably connected to the first housing 201 and the second housing 202 separately, so that the first housing 201 and the second housing 202 can rotate relative to each other. In an embodiment, the ground plane 300 may include a first part and a second part. The first part may be located in the first housing 201, the second part may be located in the second housing 202, and the first part and the second part may be connected through the rotating shaft 203.

It should be understood that, in the foldable electronic device 100 shown in FIG. 9, the rotating shaft 203 is directly connected to the first housing 201 and the second housing 202 separately, so that the first housing 201 and the second housing 202 can rotate relative to each other. In addition, that "the rotating shaft 203 is rotatably connected to the first housing 201 and the second housing 202 separately" includes a case in which the rotating shaft 203 may be rotatably connected to the first housing or the second housing through one or more second rotating shafts and one or more intermediate housings. For example, in an embodiment, the foldable electronic device 100 may further include a first rotating shaft and a second rotating shaft, and one or more intermediate housings located between the first rotating shaft and the second rotating shaft. The first rotating shaft is located between the first housing 201 and the intermediate housing, and the first rotating shaft is rotatably connected to the first housing 201 and the intermediate housing separately, so that the first housing 201 and the intermediate housing can rotate relative to each other. The second rotating shaft is located between the intermediate housing and the second housing 202, and the rotating shaft 203 is rotatably connected to the intermediate housing and the second housing 202 separately, so that the intermediate housing and the second housing 202 can rotate relative to each other.

The foldable electronic device 100 may further include an antenna 200. The antenna 200 includes a first radiator 230, a second radiator 240, a feed circuit 250, and a first tuning circuit 261.

The first radiator 230 is a conductive part of the first side frame 210 between the first position 211 and the second position 212. The second radiator 240 is a conductive part of the second side frame 220 between the third position 213 and the fourth position 214.

The first radiator 230 includes a feed point 251, and the feed circuit 250 is coupled to the feed point 251.

The second radiator 240 includes a first connection point 221, and the first tuning circuit 261 is coupled between the first connection point 221 and the ground plane 300.

An operating frequency band of the antenna 200 may include a satellite communication frequency band. The foldable electronic device 100 is in the unfolded state, the first radiator 230 is configured to generate a first resonance, and a resonance frequency band of the first resonance includes the satellite communication frequency band. The satellite communication includes at least one communication service of receiving and/or sending a short message (or referred to as a short packet) via satellite, making and/or answering a call via satellite, and data service via satellite (for example, internet access).

In an embodiment, the satellite communication frequency band may include a part of frequency bands in the SkyTone satellite system, and may include a transmit frequency band (1980 MHz to 2010 MHz) and a receive frequency band (2170 MHz to 2200 MHz) in the SkyTone satellite system. In an embodiment, the satellite communication frequency band may include a part of frequency bands in the BeiDou satellite system, and may include a transmit frequency band (1610 MHz to 1626.5 MHz) and a receive frequency band (2483.5 MHz to 2500 MHz) in the BeiDou satellite system. In an embodiment, the satellite communication frequency band may include a part of frequency bands in a low Earth orbit satellite system, and may include a transmit frequency band (2500 MHz to 2520 MHz) and a receive frequency band (2670 MHz to 2690 MHz) in the low Earth orbit satellite system. Alternatively, the technical solution may be applied to another satellite communication system. This is not limited in embodiments of this application.

In an embodiment, when the antenna 200 operates in the SkyTone satellite system (the operating frequency band of the antenna 200 includes at least a part of frequency bands in the SkyTone satellite system), the foldable electronic device 100 may perform voice communication through the antenna 200. In an embodiment, when the antenna 200 operates in the BeiDou satellite system (the operating frequency band of the antenna 200 includes at least a part of frequency bands in the BeiDou satellite system), the foldable electronic device 100 may send or receive a short packet or a picture through the antenna 200.

The first radiator 230, the second radiator 240, and the first tuning circuit 261 are configured to generate a radiation pattern of the antenna. In an embodiment, a maximum radiation direction of the radiation pattern of the antenna 200 is related to the second radiator 240 and the first tuning circuit 261.

It should be understood that, when the foldable electronic device 100 is in the unfolded state, the feed circuit 250 feeds an electrical signal, the first radiator 230 generates the first resonance, and the second radiator 240 and the first tuning circuit 261 can reduce impact of a current of the ground plane 300 on the radiation pattern generated by the antenna. Because impact of the current of the ground plane 300 on the maximum radiation direction of the radiation pattern generated by the antenna is reduced, an included angle between the maximum radiation direction of the radiation pattern generated by the antenna 200 when the foldable electronic device 100 is in the unfolded state and a length direction (for example, a y direction) of the foldable electronic device 100 is small, and it is convenient to establish a communication connection to a satellite. Therefore, during satellite communication, the foldable electronic device 100 has good communication quality in the unfolded state. This effectively improves user experience. In addition, because impact of the current of the ground plane 300 on the maximum radiation direction of the radiation pattern generated by the antenna is reduced, a radiation direction of the antenna 200 does not greatly deflect, so that a user performs satellite communication with better communication quality, thereby effectively improving user experience.

In addition, the first resonance is generated in the wire DM mode in the foregoing embodiment. A current generated in the wire DM mode is mainly generated by the first radiator 230, the current is mainly concentrated on the first radiator 230, and a plurality of current modes are not generated on the ground plane 300. Therefore, the maximum radiation direction of the radiation pattern generated by the antenna 200 is easily determined.

In addition, for the wire CM mode, a horizontal mode of the ground plane may be excited (a proportion of the horizontal mode is greater than that of a vertical mode), but currents corresponding to the horizontal mode on the ground plane are mutually offset. Therefore, system efficiency and radiation efficiency in the wire CM mode are relatively low. For the wire DM mode, radiation of the antenna in the wire DM mode is mainly generated by a radiator, and system efficiency and radiation efficiency of the wire DM mode are better than those of the wire CM mode.

In an embodiment, the foldable electronic device 100 is in the unfolded state, and a difference between a resonance point frequency of the first resonance and a resonance point frequency of a parasitic resonance is less than or equal to 200 MHz, so that the current on the ground plane 300 has less impact on the maximum radiation direction of the radiation pattern generated by the antenna 200.

It should be understood that the frequency difference described in this embodiment of this application may be understood as an absolute value of a frequency difference between the two. In an embodiment, the resonance point frequency of the first resonance may be higher than the resonance point frequency of the parasitic resonance. In an embodiment, the resonance point frequency of the first resonance may be lower than the resonance point frequency of the parasitic resonance.

It should be understood that, when the foldable electronic device 100 is in the unfolded state, the feed circuit 250 feeds an electrical signal, the first radiator 230 is configured to generate the first resonance (the resonance frequency band of the first resonance includes the satellite communication frequency band), and the second radiator 240 is configured to generate the parasitic resonance. The parasitic resonance is close to the first resonance (the difference between the resonance point frequency of the first resonance and the resonance point frequency of the parasitic resonance is less than or equal to 200 MHz). The antenna 200 can improve a radiation characteristic of the first resonance by using the parasitic resonance, so that the user performs satellite communication with better communication quality, thereby effectively improving user experience.

In an embodiment, the maximum radiation direction of the radiation pattern generated by the antenna 200 when the foldable electronic device 100 is in the unfolded state is a first direction, and the maximum radiation direction of the radiation pattern generated by the antenna 200 when the foldable electronic device 100 is in the folded state is a second direction. That the maximum radiation directions of the radiation patterns generated by the antenna 200 when the foldable electronic device 100 is in the folded state and the unfolded state are approximately the same may be understood as: An angle between the first direction and the second direction is less than or equal to 30°.

It should be understood that the first direction is approximately the same as the second direction. When the foldable electronic device 100 performs satellite communication, a state (the folded state or the unfolded state) of the foldable electronic device 100 is changed, and the user does not need to change a posture of holding the foldable electronic device 100. This effectively improves user experience.

In an embodiment, when the foldable electronic device 100 is in the unfolded state, the first tuning circuit 261 may be configured to switch the maximum radiation direction of the radiation pattern generated by the antenna 200.

It should be understood that, that the first tuning circuit 261 may be configured to switch the maximum radiation direction of the radiation pattern generated by the antenna 200 may be understood as: the first tuning circuit 261 may switch an equivalent electrical parameter (for example, equivalent capacitance, equivalent inductance, or equivalent resistance) between the first connection point 221 and the ground plane 300, so that the parasitic resonance generated by the second radiator 240 is close to the first resonance, to reduce impact of the current of the ground plane 300 on the maximum radiation direction of the radiation pattern generated by the antenna 200. Because impact of the current of the ground plane 300 on the maximum radiation direction of the radiation pattern generated by the antenna 200 is reduced, an included angle between the maximum radiation direction of the radiation pattern generated by the antenna 200 when the foldable electronic device 100 is in the unfolded state and the length direction (for example, the y direction) of the foldable electronic device is small, and it is convenient to establish a communication connection to a satellite. Therefore, during satellite communication, the foldable electronic device 100 has good communication quality in the unfolded state. This effectively improves user experience. In addition, because impact of the current of the ground plane 300 on the maximum radiation direction of the radiation pattern generated by the antenna is reduced, the maximum radiation directions of the radiation patterns generated by the antenna 200 when the foldable electronic device 100 is in the folded state and the unfolded state are approximately the same. Therefore, during satellite communication, a state (the folded state or the unfolded state) of the foldable electronic device 100 is changed, and the user does not need to change the posture of holding the foldable electronic device 100. This effectively improves user experience.

In an embodiment, the foldable electronic device 100 is in the unfolded state, and the difference between the resonance point frequency of the first resonance and the resonance point frequency of the parasitic resonance is less than 50 MHz.

It should be understood that when a resonance point of the parasitic resonance is close to a resonance point of the first resonance (the frequency difference is less than 50 MHz), coupling between the first radiator 230 and the second radiator 240 is strong. When the first radiator 230 generates the first resonance, the second radiator 240 has a large current. In an embodiment, at the resonance point of the first resonance, a current generated on the first radiator 230 and a current generated on the second radiator 240 are in a same direction. The current generated on the first radiator 230 and the current generated on the second radiator 240 may form effect similar to a current array, so that the antenna 200 has a strong linear polarization characteristic, and the antenna 200 has higher directivity. Because a gain is related to directivity, and the antenna 200 has higher directivity, a gain of the antenna 200 may be increased, so that the foldable electronic device 100 has better satellite communication performance.

In addition, when the difference between the resonance point frequency of the first resonance and the resonance point frequency of the parasitic resonance is less than 50 MHz, it may be understood that the resonance point of the parasitic resonance is in the resonance frequency band of the first resonance, the first radiator 230 is configured to generate a main resonance, the second radiator 240 and the first tuning circuit 261 are configured to generate the parasitic resonance, and the main resonance and the parasitic resonance jointly form the first resonance.

In an embodiment, the foldable electronic device 100 is in the unfolded state, and the difference between the resonance point frequency of the first resonance and the resonance point frequency of the parasitic resonance is greater than or equal to 50 MHz and less than or equal to 200 MHz.

It should be understood that when the resonance point of the parasitic resonance is far away from the resonance point of the first resonance (the frequency difference is greater than or equal to 50 MHz and less than or equal to 200 MHz), coupling between the first radiator 230 and the second radiator 240 is weakened. When the first radiator 230 generates the first resonance, the current on the second radiator 240 becomes weak, to excite generation of some longitudinal currents on the ground plane 300, so that the antenna 200 has a circular polarization characteristic. In an embodiment, the resonance point frequency of the first resonance is higher than the resonance point frequency of the parasitic resonance, and the antenna 200 has a left-hand circular polarization characteristic. In an embodiment, the resonance point frequency of the first resonance is lower than the resonance point frequency of the parasitic resonance, and the antenna 200 has a right-hand circular polarization characteristic.

It should be understood that during implementation of this application, coupling between the second radiator 240 and the first radiator 230 is weak, and the parasitic resonance cannot be better excited. Therefore, a pit corresponding to the parasitic resonance cannot appear obviously in an S-parameter diagram. Because the parasitic resonance is partially excited by a current, an obvious pit appears on an efficiency curve (for example, radiation efficiency or system efficiency). For example, if an efficiency pit appears at a first frequency, the first frequency may be considered as the resonance point corresponding to the parasitic resonance. In an embodiment, the pit results in a reduction of efficiency (for example, radiation efficiency or system efficiency) by no more than 1.5 dB. In an embodiment, the pit results in a reduction of efficiency (for example, radiation efficiency or system efficiency) by no more than 1 dB.

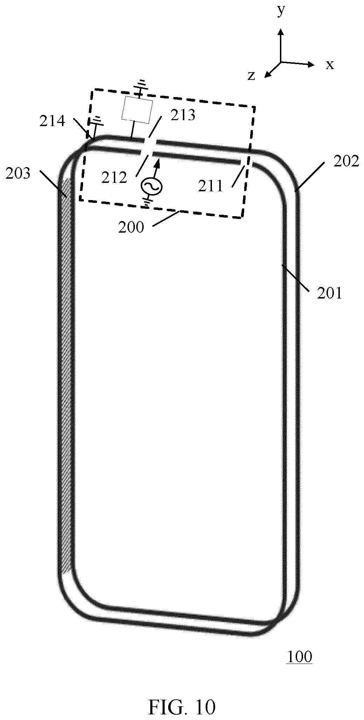

In an embodiment, the foldable electronic device 100 is in the folded state, and the first radiator 230 and the second radiator 240 are adjacently provided in a third direction (for example, no other conductor is provided between the first radiator 230 and the second radiator 240), as shown in FIG. 10. In an embodiment, the first slot/the second slot provided on the first side frame 210 is aligned with the third slot provided on the second side frame 220, to improve an aesthetic degree of the foldable electronic device 100.

The third direction may be understood as a thickness direction of the foldable electronic device 100, or a direction perpendicular to the display in the unfolded state, for example, a z direction.

It should be understood that, in this embodiment of this application, alignment may be understood as that two slots at least partially overlap in the third direction. When the two slots completely overlap in the third direction, the radiation characteristic of the parasitic resonance generated by the second radiator is optimal.

In an embodiment, the foldable electronic device 100 is in the folded state, and the parasitic resonance may be further used to improve a radiation characteristic (for example, radiation efficiency and system efficiency) of the first resonance.

In an embodiment, the foldable electronic device 100 is in the folded state, and the first radiator 230 and the second radiator 240 at least partially overlap in the third direction.

It should be understood that the foldable electronic device 100 is in a folded state, the first slot/the second slot provided on the first side frame 210 is aligned with the third slot provided on the second side frame 220, and when the feed circuit 250 feeds an electrical signal, the third slot may be coupled to more energy by using an electric field in the slot provided on the first side frame 210, to improve a radiation characteristic of the parasitic resonance generated by the second radiator 240.

In an embodiment, the foldable electronic device 100 is in the folded state, and the difference between the resonance point frequency of the first resonance and the resonance point frequency of the parasitic resonance is less than or equal to 200 MHz, so that the antenna 200 has a better radiation characteristic (for example, radiation efficiency and system efficiency).

In an embodiment, the foldable electronic device 100 is in the folded state, and at the resonance point of the first resonance, a current on the first radiator 230 and a current on the second radiator 240 are in a same direction.

In an embodiment, the fourth position 214 may be located on the second side of the second side frame 220. In an embodiment, the fourth position 214 may be located between the third position 213 and the rotating shaft 203, and the third slot is aligned with the second slot. In an embodiment, the third position 213 may be located between the fourth position 214 and the rotating shaft 203, and the third slot is aligned with the first slot.

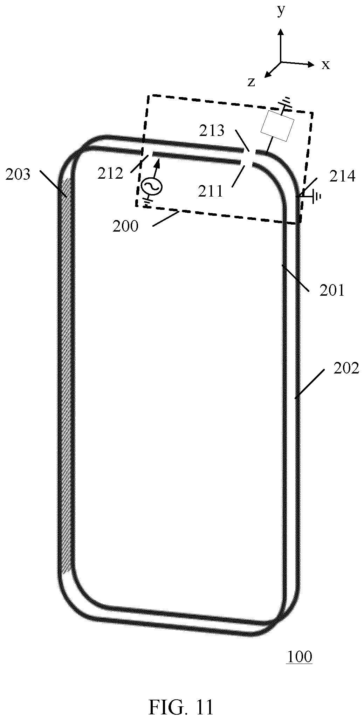

In an embodiment, the fourth position 214 may be located on a third side of the second side frame 220, and the second side intersects with the third side at an angle, as shown in FIG. 11. In an embodiment, the third slot is aligned with the first slot.

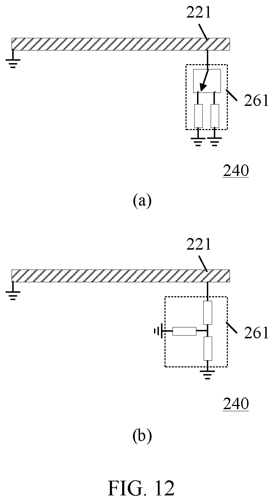

In one embodiment, the first tuning circuit 261 is a circuit including a switch, as shown in (a) in FIG. 12. The switch may be configured to switch electronic elements with different resistance values, capacitance values, or inductance values coupled to the first connection point 221 in different circuit states. The switch may be electrically connected between the electronic element and the first connection point 221, or may be electrically connected between the electronic element and the ground plane 300. Alternatively, the switch may be in an off state, so that the electronic element is not coupled to the first connection point 221. Alternatively, the switch may enable the ground plane 300 to be directly coupled to the first connection point 221, and no electronic element is provided between the ground plane 300 and the first connection point 221.

In one embodiment, the first tuning circuit 261 does not include a switch, and may be a circuit formed by cascading a plurality of electronic elements, as shown in (b) in FIG. 12. The first tuning circuit 261 may have different equivalent capacitance values or equivalent inductance values at different frequencies.

It should be understood that the tuning circuit in this embodiment of this application may be correspondingly understood with reference to the foregoing descriptions. For brevity of description, details are not described.

In an embodiment, a length of a conductor part of the second side frame between the first connection point 221 and the third position 213 is less than or equal to 5 mm.

It should be understood that, because the third slot is provided at the third position 213, and there is a strong electric field at the third slot, when the first connection point 221 is close to the third slot, the first tuning circuit 261 has a better tuning characteristic.

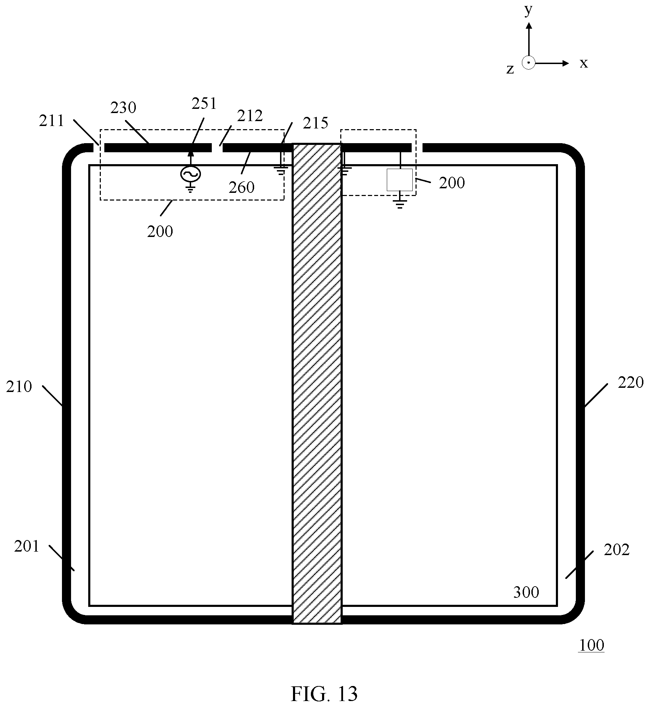

In an embodiment, the first side frame 210 includes a fifth position 215. The first side frame 210 is coupled to the ground plane 300 at the fifth position 215, as shown in FIG. 13. The antenna 200 may further include a third radiator 260. In an embodiment, the third radiator 260 may generate a second resonance, to improve a radiation characteristic (for example, radiation efficiency) of the first resonance.

In an embodiment, a resonance point frequency of the second resonance is higher than the resonance point frequency of the first resonance.

In an embodiment, the third radiator 260 may also be configured to generate the second resonance.

It should be understood that, in the foregoing embodiment, only the first radiator 230 is used as a main radiation stub (a radiator including a feed point). In an embodiment, the third radiator 260 may also include a feed point, so that the third radiator 260 generates the second resonance. In an embodiment, the feed point of the first radiator 230 may be configured to feed a radio frequency signal of a transmit frequency band in a satellite communication frequency band. The feed point of the third radiator 260 may be configured to feed a radio frequency signal of a receive frequency band in the satellite communication frequency band.

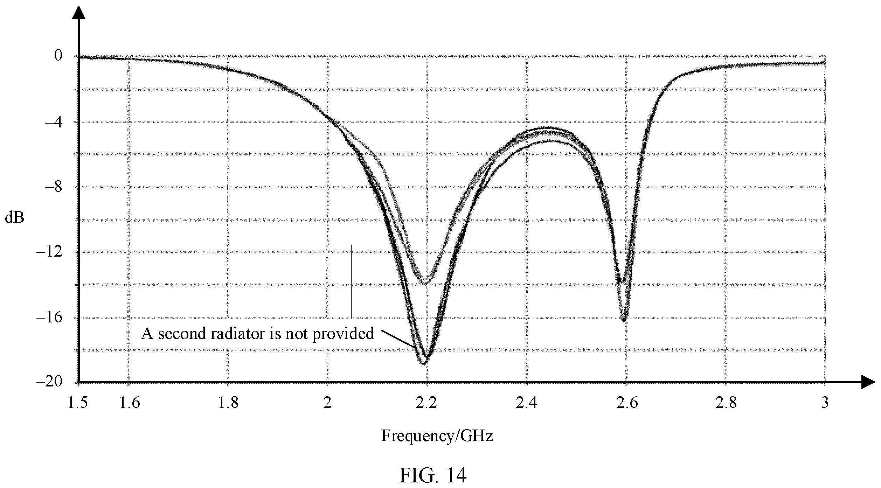

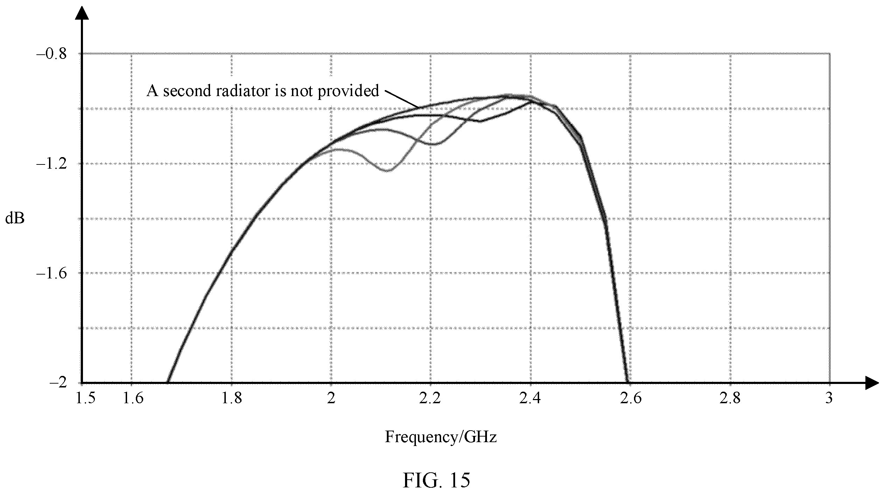

FIG. 14 and FIG. 15 are simulation results of the foldable electronic device 100 shown in FIG. 13 in the unfolded state. FIG. 14 is an S-parameter simulation result of the antenna 200 in the foldable electronic device 100. FIG. 15 is a system efficiency simulation result of the antenna 200 in the foldable electronic device 100.

It should be understood that the simulation results shown in FIG. 14 and FIG. 15 show simulation results when the antenna 200 does not include the second radiator 240, and simulation results when the antenna includes the second radiator 240 and the resonance point frequency of the parasitic resonance is lower than the resonance point frequency of the first resonance, the resonance point frequency of the parasitic resonance is close to the resonance point frequency of the first resonance, or the resonance point frequency of the parasitic resonance is higher than the resonance point frequency of the first resonance.

As shown in FIG. 14, the antenna 200 generates resonances near 2.2 GHz and near 2.6 GHz. The resonance generated near 2.2 GHz may correspond to the first resonance in the foregoing embodiment, and the resonance generated near 2.6 GHz may correspond to the second resonance in the foregoing embodiment.

It should be understood that because the first radiator and the third radiator are located in the first housing, and the second radiator is located in the second housing, coupling between the second radiator and the first radiator is weak, and the parasitic resonance generated by the second radiator has weak impact on an S parameter of the first resonance (not shown in an S-parameter curve).

As shown in FIG. 15, when the second radiator 240 is not provided, no pit appears on a system efficiency curve.

After the second radiator 240 is provided, an electrical parameter (for example, an equivalent capacitance value or an equivalent inductance value of a tuning circuit) of the second radiator is adjusted, so that the resonance point frequency (a pit of system efficiency) of the parasitic resonance is lower than the resonance point frequency of the first resonance, is close to the resonance point frequency of the first resonance, or is higher than the resonance point frequency of the first resonance.

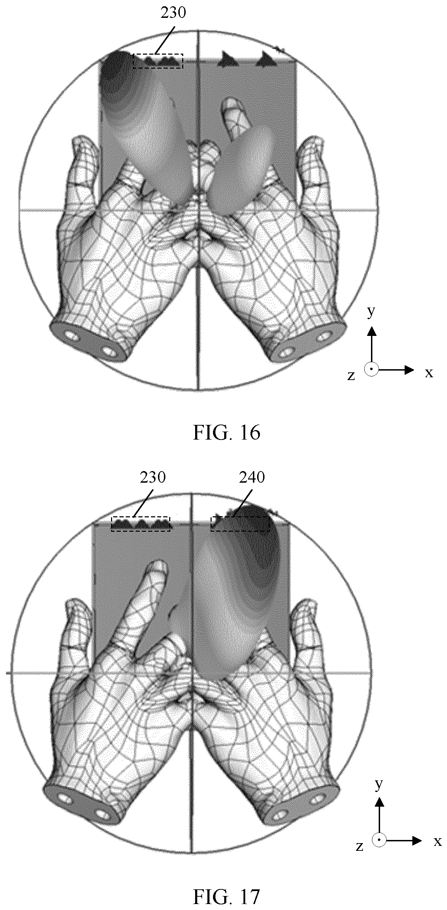

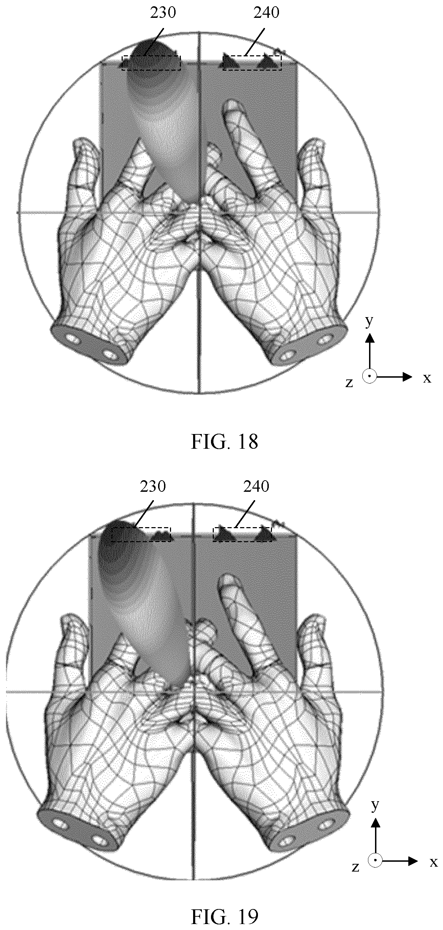

FIG. 16 to FIG. 19 are radiation patterns in the unfolded state of the foldable electronic device 100 shown in FIG. 13 at 2.2 GHz. FIG. 16 is a radiation pattern in the unfolded state of the foldable electronic device 100 when the second radiator is not provided. FIG. 17 is a radiation pattern in the unfolded state of the foldable electronic device 100 when the resonance point frequency of the parasitic resonance is lower than the resonance point frequency of the first resonance. FIG. 18 is a radiation pattern in the unfolded state of the foldable electronic device 100 when the resonance point frequency of the parasitic resonance is close to the resonance point frequency of the first resonance. FIG. 19 is a radiation pattern in the unfolded state of the foldable electronic device 100 when the resonance point frequency of the parasitic resonance is higher than the resonance point frequency of the first resonance.

As shown in FIG. 16, when the second radiator is not provided, in the unfolded state of the foldable electronic device, a current on the ground plane has impact on a maximum radiation direction of the radiation pattern generated by the antenna, so that the maximum radiation direction deviates from the top direction (for example, the y direction). When the second radiator is not provided, directivity of the antenna is 3.72 dBi.

After the second radiator is provided, in the unfolded state of the foldable electronic device, impact of the current of the ground plane 300 on the maximum radiation direction of the radiation pattern generated by the antenna is reduced, so that the maximum radiation direction does not deviate from the top direction (for example, the y direction), and more concentrated energy is radiated, as shown in FIG. 17 to FIG. 19.

When the resonance point frequency of the parasitic resonance is lower than the resonance point frequency of the first resonance, the directivity of the antenna is 4.16 dBi. When the resonance point frequency of the parasitic resonance is close to the resonance point frequency of the first resonance, the directivity of the antenna is 5.08 dBi. When the resonance point frequency of the parasitic resonance is higher than the resonance point frequency of the first resonance, the directivity of the antenna is 4.64 dBi.

It should be understood that higher directivity indicates a larger proportion of energy radiated by the antenna in a direction, and more concentrated energy radiation. When the directivity of the antenna is high, energy radiated by the antenna in the maximum radiation direction accounts for a high proportion, and the antenna has a high gain in the direction, so that the electronic device can have good communication performance.

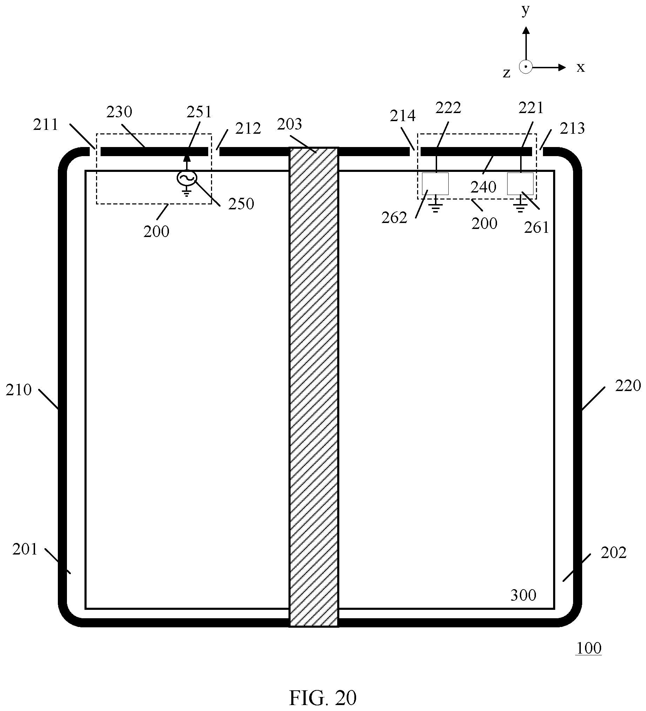

FIG. 20 is a diagram of a foldable electronic device 100 according to an embodiment of this application.

As shown in FIG. 20, the second side frame 220 is provided with a fourth slot at the fourth position 214.

It should be understood that a difference between the antenna 200 shown in FIG. 20 and the antenna 200 shown in FIG. 9 lies only in that the fourth slot is provided at the fourth position 214. In the antenna 200 shown in FIG. 9, the second side frame 220 is coupled to the ground plane 300 at the fourth position 214. One end of the second radiator 240 is a ground end, the other end is an open end, and a structure similar to an IFA may be formed. The second radiator 240 may operate in a quarter-wavelength mode. However, in the antenna 200 shown in FIG. 20, the second side frame 220 is provided with the fourth slot at the fourth position 214, two ends of the second radiator 240 are both open ends, and a structure similar to a dipole (dipole) may be formed. The second radiator 240 may operate in a one-half wavelength mode.

In an embodiment, the antenna 200 further includes a second tuning circuit 262. The second radiator 240 includes a second connection point 222, and the second tuning circuit 262 is coupled between the second connection point 222 and the ground plane 300.

It should be understood that the second radiator 240 is coupled to the first tuning circuit 261 and the second tuning circuit 262.

In an embodiment, a length of a conductor part of the second side frame between the second connection point 222 and the fourth position 214 is less than or equal to 5 mm.

In an embodiment, when the foldable electronic device 100 is in the folded state, the third slot is aligned with the first slot, and the fourth slot is aligned with the second slot.

It should be understood that, because the fourth slot is provided at the fourth position 214, and there is a strong electric field at the fourth slot, when the second connection point 222 is close to the fourth slot, the second tuning circuit 262 has a better tuning characteristic.

For brevity of description, a part that is of the antenna 200 shown in FIG. 20 and that is similar to the antenna 200 shown in FIG. 9 is not described in detail, for example, a position of the first radiator 230, the satellite communication frequency band, the frequency difference between the first resonance generated by the first radiator 230 and the parasitic resonance generated by the second radiator 240, and relative positions of the first radiator 230 and the second radiator 240.

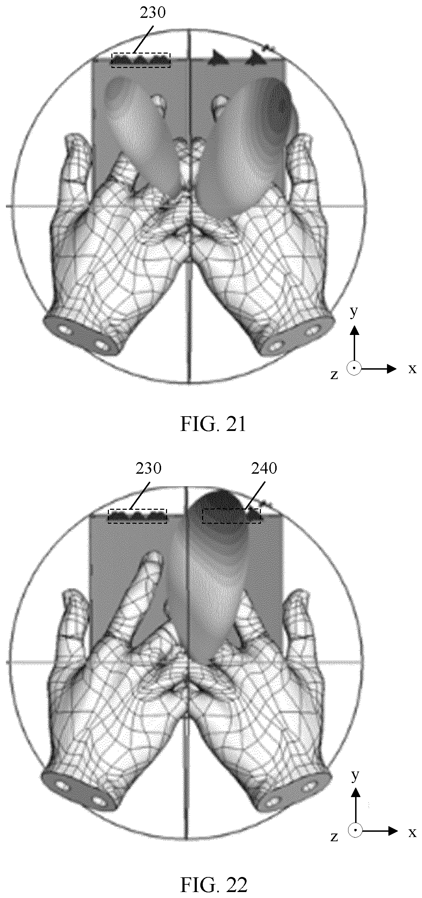

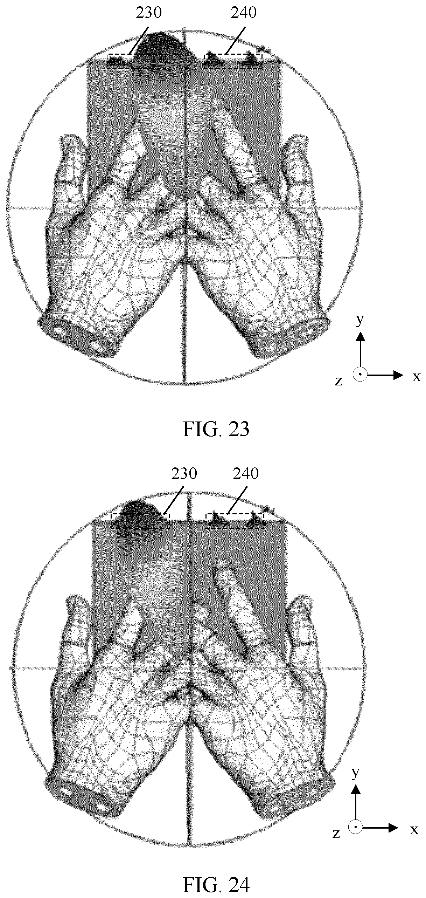

FIG. 21 to FIG. 24 are radiation patterns in the unfolded state of the foldable electronic device 100 shown in FIG. 20 at 2.2 GHz. FIG. 21 is a radiation pattern in the unfolded state of the foldable electronic device 100 when the second radiator is not provided. FIG. 22 is a radiation pattern in the unfolded state of the foldable electronic device 100 when the resonance point frequency of the parasitic resonance is lower than the resonance point frequency of the first resonance. FIG. 23 is a radiation pattern in the unfolded state of the foldable electronic device 100 when the resonance point frequency of the parasitic resonance is close to the resonance point frequency of the first resonance. FIG. 24 is a radiation pattern in the unfolded state of the foldable electronic device 100 when the resonance point frequency of the parasitic resonance is higher than the resonance point frequency of the first resonance.

As shown in FIG. 21, when the second radiator is not provided, in the unfolded state of the foldable electronic device, a current on the ground plane has impact on a maximum radiation direction of the radiation pattern generated by the antenna, so that the maximum radiation direction deviates from the top direction (for example, the y direction). When the second radiator is not provided, directivity of the antenna is 3.53 dBi.

After the second radiator is provided, in the unfolded state of the foldable electronic device, impact of the current of the ground plane 300 on the maximum radiation direction of the radiation pattern generated by the antenna is reduced, so that the maximum radiation direction does not deviate from the top direction (for example, the y direction), and more concentrated energy is radiated, as shown in FIG. 22 to FIG. 24.

When the resonance point frequency of the parasitic resonance is lower than the resonance point frequency of the first resonance, the directivity of the antenna is 4.83 dBi. When the resonance point frequency of the parasitic resonance is close to the resonance point frequency of the first resonance, the directivity of the antenna is 4.73 dBi. When the resonance point frequency of the parasitic resonance is higher than the resonance point frequency of the first resonance, the directivity of the antenna is 4.86 dBi.

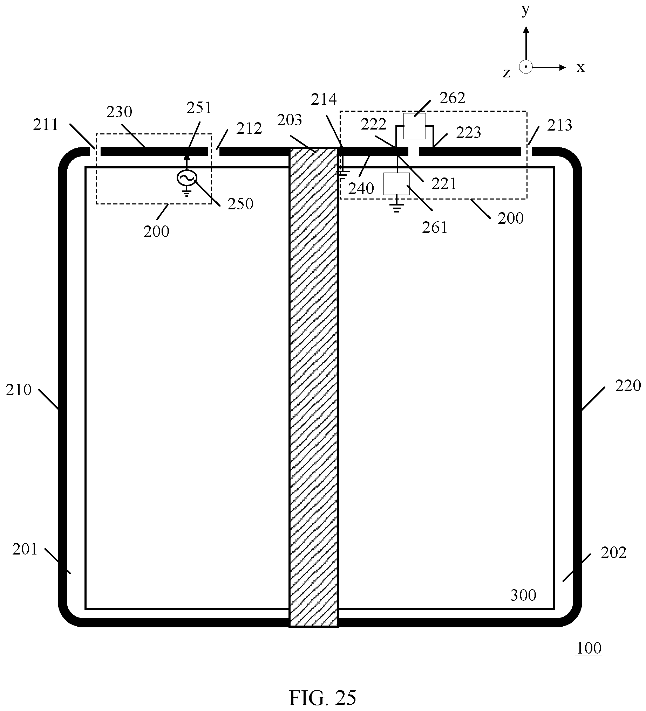

FIG. 25 is a diagram of a foldable electronic device 100 according to an embodiment of this application.

As shown in FIG. 25, the second side frame 220 is provided with the third slot at the third position 213. The second side frame 220 is coupled to the ground plane 300 at the fourth position 214. The second side frame 220 is provided with a fourth slot between the third position 213 and the fourth position 214.

It should be understood that the second radiator 240 is electrically connected to the ground plane 300 at the first connection point 221 through the first tuning circuit 261, so that when the second radiator 240 generates a parasitic resonance, a current on the second radiator 240 is shunted in an area near the first connection point 221. Because shunt occurs in the area near the first connection point 221, current density on the second radiator 240 can be reduced. In an embodiment, current distribution on the second radiator 240 is more dispersed, to reduce a conductor loss of the second radiator 240. In an embodiment, current distribution on the second radiator 240 is more dispersed, to increase a radiation aperture of the second radiator 240. Because the conductor loss of the second radiator 240 is reduced, and the radiation aperture of the antenna 200 is increased, system efficiency and radiation efficiency of the antenna can be improved.

In addition, the second radiator 240 is provided with the fourth slot, and the fourth slot may be considered as an equivalent capacitor (for example, a distributed capacitor) provided on the second radiator 240. The equivalent capacitor may enable the second radiator 240 to form the metamaterial structure. The radiation aperture of the second radiator 240 in the metamaterial structure may be increased, and after the fourth slot is provided, an electric field is more dispersed, and a dielectric loss near a conductor is reduced. Therefore, system efficiency and radiation efficiency of the antenna 200 can be effectively improved. By coupling a second tuning circuit 262 between a second connection point 222 and a third connection point 223, an equivalent capacitance value of the fourth slot can be adjusted, to adjust a radiation characteristic (for example, a resonance point frequency) of the antenna 200.

It should be understood that a difference between the antenna 200 shown in FIG. 25 and the antenna 200 shown in FIG. 9 lies only in a position of the first connection point 221 and the fourth slot. In both the antennas 200 shown in FIG. 9 and FIG. 25, the second radiator 240 is of a structure similar to an IFA in which one end is a ground end and the other end is an open end, and the second radiator 240 operates in a quarter-wavelength mode. However, in the antenna 200 shown in FIG. 25, the second radiator 240 forms a metamaterial structure, and a length of the second radiator 240 is greater than a length of the second radiator 240 shown in FIG. 9.

In an embodiment, in the antenna 200 shown in FIG. 9, an electrical length of the second radiator 240 is a quarter of a first wavelength, and the first wavelength may be a wavelength corresponding to the parasitic resonance. In an embodiment, in the antenna 200 shown in FIG. 25, an electrical length of the second radiator 240 is greater than three-eighths of the first wavelength. In the antenna 200 shown in FIG. 25, the parasitic resonance of the second radiator 240 may correspond to the quarter-wavelength mode. By using a first resonance circuit 261 and the fourth slot, an electrical length of the second radiator 240 may be greater than three-eighths of the first wavelength, currents on the second radiator 240 are in a same direction (for example, no reversal occurs), and no reversal occurs in an electric field between the second radiator 240 and the ground. The electrical length of the second radiator 240 increases from a quarter of the first wavelength to more than three-eighths of the first wavelength, but the second radiator still operates in the quarter-wavelength mode. In this case, the current density on the second radiator 240 is reduced, and a density of the electric field between the second radiator 240 and the ground plane 300 is reduced, to reduce a conductor loss and a dielectric loss caused by the second radiator 240 and a conductor and a dielectric provided around the second radiator 240, and improve a radiation characteristic of the antenna 200. The radiation aperture of the second radiator 240 is increased, to effectively improve system efficiency and radiation efficiency of the antenna 200.

The first wavelength may be understood as a vacuum wavelength corresponding to a resonance point of the parasitic resonance, or may be understood as a vacuum wavelength corresponding to a center frequency of a resonance frequency band formed by the parasitic resonance. Because there is a specific correspondence between a vacuum wavelength and a dielectric wavelength, the foregoing proportion may be converted into a proportion of the dielectric wavelength. Details are not described in this application.

In an embodiment, the antenna 200 further includes the second tuning circuit 262. The second radiator 240 includes the second connection point 222 and the third connection point 223, and the second tuning circuit 262 is coupled between the second connection point 222 and the third connection point 223. The fourth slot is located between the second connection point 222 and the third connection point 223.

It should be understood that, by coupling the second tuning circuit 262 between the second connection point 222 and the third connection point 223, the equivalent capacitance value of the fourth slot can be adjusted, to adjust a radiation characteristic (for example, a resonance point frequency of the parasitic resonance generated by the second radiator 240) of the antenna 200.

For brevity of description, in the antenna 200 shown in FIG. 25, only an example in which two sides of the fourth slot are coupled to the second tuning circuit 262 is used for description. In actual production or design, the antenna 200 may not include the second tuning circuit 262, and the equivalent capacitance value of the fourth slot is adjusted in another manner.

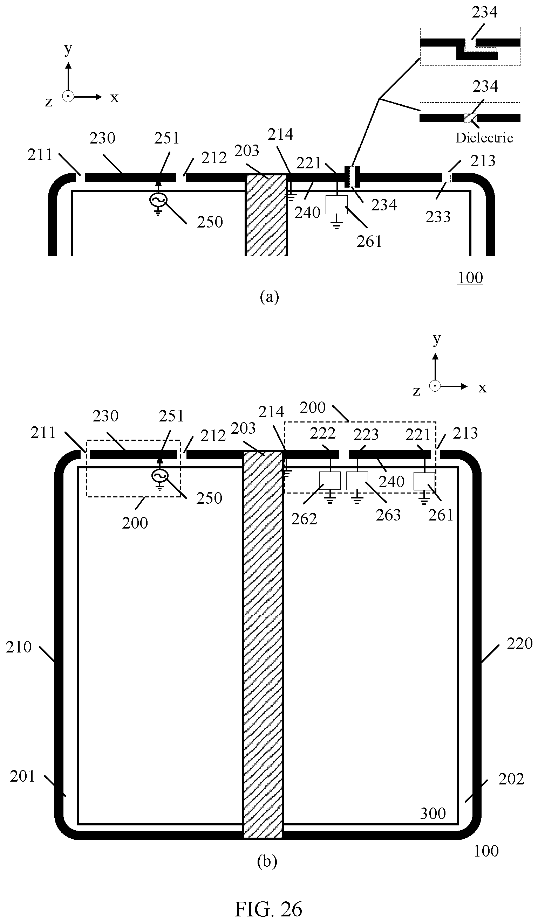

In an embodiment, parameters of radiators on two sides of the fourth slot 234 are adjusted, to adjust the equivalent capacitance value of the fourth slot 234, as shown in (a) in FIG. 26.

A formula for calculating the capacitance value is as follows:

$$C = \frac{\varepsilon S}{4\pi kd},$$

where $\varepsilon$ is a dielectric constant of a dielectric between two polar plates (radiators on two sides of the slot) of the capacitor; $\delta$ is an absolute dielectric constant in a vacuum; k is an electrostatic force constant; S is an area of overlap of the two polar plates, and is an area of overlap of the side radiators on the two sides of the slot in this embodiment of this application; and d is a vertical distance between the two polar plates, and is a width of the fourth slot 234 in this embodiment of this application.

For brevity of description, in the electronic device shown in (a) in FIG. 26, only a manner of adjusting the equivalent capacitance value of the fourth slot 234 by changing the area of overlap of the radiators on the two sides of the fourth slot 234 and the dielectric filled in the fourth slot 234 is shown. In actual production or design, the equivalent capacitance value of the fourth slot 234 may also be adjusted in another manner. This is not limited in this embodiment of this application.

The equivalent capacitance value of the slot in this embodiment of this application may be adjusted in the foregoing manner. For brevity of description, details are not described again.

In an embodiment, the antenna 200 further includes the second tuning circuit 262 and a third tuning circuit 263, as shown in (b) of FIG. 26.

In an embodiment, the first tuning circuit 261 may include a capacitor or an electronic element equivalent to the capacitor.

In an embodiment, an equivalent capacitance value of the first tuning circuit 261 may be less than or equal to a first threshold. The first threshold may be designed based on the resonance point frequency of the parasitic resonance generated by the second radiator 240. When the resonance point frequency of the parasitic resonance is lower than or equal to 1 GHz, the first threshold is 10 pF. When the resonance point frequency of the parasitic resonance is higher than 1 GHz, the first threshold is 2 pF.

In an embodiment, the second tuning circuit 262 may include an inductor or an electronic element equivalent to the capacitor.

In an embodiment, an equivalent inductance value of the second tuning circuit 262 may be less than or equal to 10 nH.

It should be understood that the equivalent capacitance value of the first tuning circuit 261 and the equivalent inductance value of the second tuning circuit 262 are designed based on different resonance point frequencies of the parasitic resonance, so that current distribution on the second radiator 240 can be more dispersed, a conductor loss is reduced, and a radiation aperture of the second radiator 240 is increased, to improve a radiation characteristic (for example, radiation efficiency and system efficiency) of the antenna.

In an embodiment, a distance between the second connection point 222 and/or the third connection point 223 and the fourth slot is less than or equal to 5 mm.

The distance between the second connection point 222 and/or the third connection point 223 and the fourth slot may be understood as a minimum distance between the second connection point 222 and/or the third connection point 223 and conductors on two sides of the fourth slot (a length of the second radiator 240 between the second connection point 222 and/or the third connection point 223 and the fourth slot). When the second tuning circuit 262 is electrically connected to the second connection point 222 and the third connection point 223 through connecting pieces (for example, metal domes), the distance between the second tuning circuit 262 and the fourth slot may be understood as a minimum distance between a center of a part in which the connection point is in contact with the connecting piece and conductors on two sides of the fourth slot.

In an embodiment, the second connection point 222 may be located between the fourth position 214 and the third connection point 223.

In an embodiment, the first connection point 221 is located between the fourth position 214 and the second connection point 222. In an embodiment, a distance between the first connection point 221 and the second connection point 222 (for example, a length of the second radiator between the first connection point 221 and the second connection point 222) is greater than or equal to 0 mm and less than or equal to 5 mm.

It should be understood that, when the distance between the first connection point 221 and the second connection point 222 is equal to 0 mm, the first connection point 221 overlaps the second connection point 222. In an embodiment, one end of the first tuning circuit 261 and one end of the second tuning circuit 262 may be coupled to the second connection point 222 (the first connection point 221) through a same connecting piece.

In an embodiment, the first connection point 221 may be located between the third position 213 and the third connection point 223. In an embodiment, a distance between the first connection point 221 and the third connection point 223 (for example, a length of the second radiator between the first connection point 221 and the third connection point 223) is greater than or equal to 0 mm and less than or equal to 5 mm.

It should be understood that, when the distance between the first connection point 221 and the third connection point 223 is equal to 0 mm, the first connection point 221 overlaps the third connection point 223. In an embodiment, one end of the first tuning circuit 261 and one end of the second tuning circuit 262 may be coupled to the third connection point 223 (the first connection point 221) through a same connecting piece.

The radiation aperture of the second radiator 240 is adjusted by using both the first tuning circuit 261 and the second tuning circuit 262, to achieve a parasitic resonance in an expected frequency band.

It should be understood that the first connection point 221 may be located at any position on the second radiator 240. This is not limited in this embodiment of this application. When the length of the second radiator between the first connection point 221 and the second connection point 222/the third connection point 223 is less than or equal to 5 mm, the radiation aperture of the second radiator 240 can be better adjusted, to improve a radiation characteristic of the antenna 200.

In an embodiment, a length of the second radiator 240 between a first end (the ground end, at the fourth position 214) of the second radiator 240 and the fourth slot is less than a length of the second radiator 240 between a second end (the open end, at the third position 213) of the second radiator 240 and the fourth slot.

It should be understood that the length of the radiator between one end of the radiator and the first slot may be understood as a length of a conductor part between an end part of the end and the fourth slot. For brevity of description, it may be correspondingly understood in this embodiment of this application.

In an embodiment, a length of the second radiator 240 between the first end (the ground end, at the fourth position 214) of the second radiator 240 and the fourth slot is less than three-fifths of the length of the second radiator 240 between the second end (the open end, at the third position 213) of the second radiator 240 and the fourth slot.

In an embodiment, a length of the second radiator 240 between the first end (the ground end, at the fourth position 214) of the second radiator 240 and the fourth slot is less than one-third of the length of the second radiator 240 between the second end (the open end, at the third position 213) of the second radiator 240 and the fourth slot.

In an embodiment, a length of the second radiator 240 between the first end (the ground end, at the fourth position 214) of the second radiator 240 and the fourth slot is less than one-seventh of the length of the second radiator 240 between the second end (the open end, at the third position 213) of the second radiator 240 and the fourth slot.

It should be understood that the fourth slot may be located in an area in which a current of the second radiator 240 is large. An area with a large current should be understood as a corresponding second radiator 240 (for example, operating in a quarter-wavelength mode) that is not slotted. After the fourth slot is provided, strength of an electric field of the second radiator 240 is weakened, to disperse the electric field. This improves system efficiency and radiation efficiency of the antenna 200.

For brevity of description, a part that is of the antenna 200 shown in FIG. 25 and that is similar to the antenna 200 shown in FIG. 9 is not described in detail, for example, a position of the first radiator 230, the satellite communication frequency band, the frequency difference between the first resonance generated by the first radiator 230 and the parasitic resonance generated by the second radiator 240, and relative positions of the first radiator 230 and the second radiator 240.

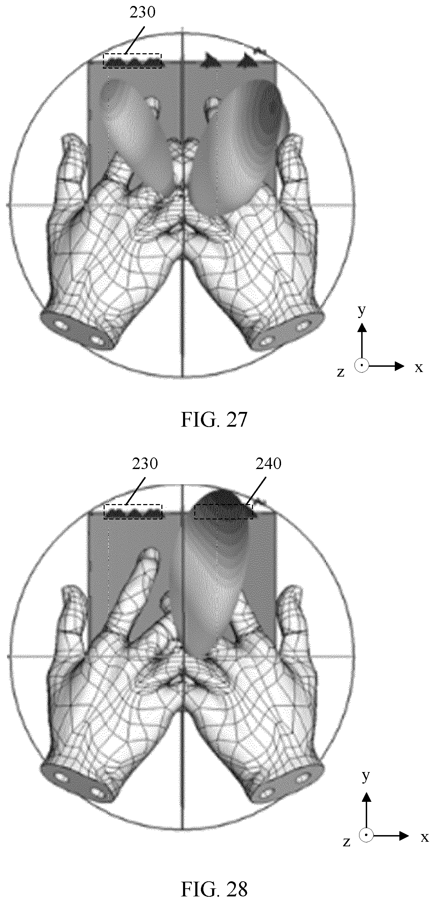

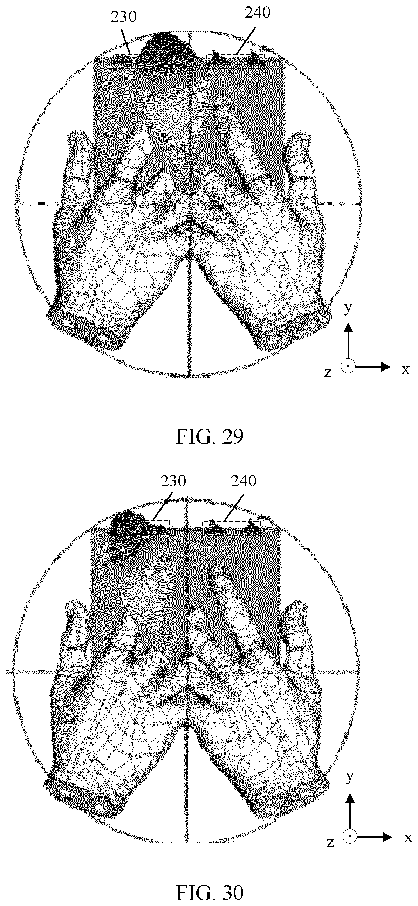

FIG. 27 to FIG. 30 are radiation patterns in the unfolded state of the foldable electronic device 100 shown in FIG. 25 at 2.2 GHz. FIG. 27 is a radiation pattern in the unfolded state of the foldable electronic device 100 when the second radiator is not provided. FIG. 28 is a radiation pattern in the unfolded state of the foldable electronic device 100 when the resonance point frequency of the parasitic resonance is lower than the resonance point frequency of the first resonance. FIG. 29 is a radiation pattern in the unfolded state of the foldable electronic device 100 when the resonance point frequency of the parasitic resonance is close to the resonance point frequency of the first resonance. FIG. 30 is a radiation pattern in the unfolded state of the foldable electronic device 100 when the resonance point frequency of the parasitic resonance is higher than the resonance point frequency of the first resonance.

As shown in FIG. 27, when the second radiator is not provided, in the unfolded state of the foldable electronic device, a current on the ground plane has impact on a maximum radiation direction of the radiation pattern generated by the antenna, so that the maximum radiation direction deviates from the top direction (for example, the y direction). When the second radiator is not provided, directivity of the antenna is 3.53 dBi.

After the second radiator is provided, in the unfolded state of the foldable electronic device, impact of the current of the ground plane 300 on the maximum radiation direction of the radiation pattern generated by the antenna is reduced, so that the maximum radiation direction does not deviate from the top direction (for example, the y direction), and more concentrated energy is radiated, as shown in FIG. 28 to FIG. 30.

When the resonance point frequency of the parasitic resonance is lower than the resonance point frequency of the first resonance, the directivity of the antenna is 5 dBi. When the resonance point frequency of the parasitic resonance is close to the resonance point frequency of the first resonance, the directivity of the antenna is 5.02 dBi. When the resonance point frequency of the parasitic resonance is higher than the resonance point frequency of the first resonance, the directivity of the antenna is 5.01 dBi.

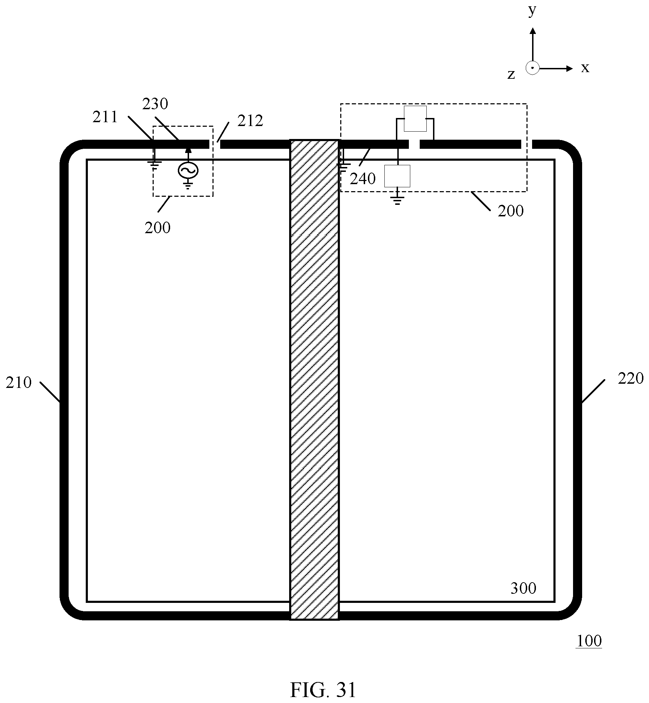

FIG. 31 is a diagram of a foldable electronic device 100 according to an embodiment of this application.

As shown in FIG. 31, the first side frame 210 is coupled to the ground plane 300 at the first position 211.

It should be understood that a difference between the antenna 200 shown in FIG. 31 and the antenna 200 shown in FIG. 25 lies only in a boundary condition of the first radiator 230. In the foregoing embodiment, only an example in which both ends of the first radiator 230 are open ends and the first radiator 230 forms a structure similar to a dipole is used for description. In actual production or design, a first end of the first radiator 230 is a ground end, and a second end is an open end, to form a structure similar to an IFA. This is not limited in this application.

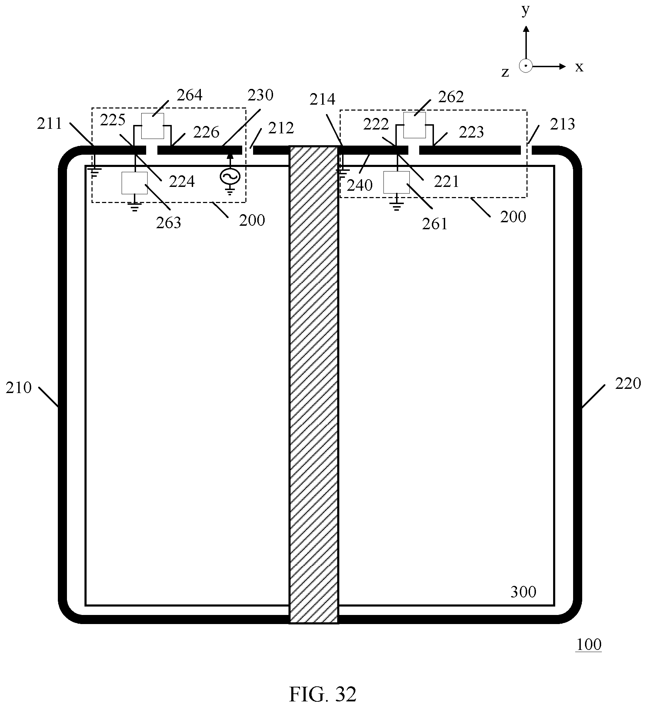

In an embodiment, the antenna 200 may further include a third tuning circuit 263 and/or a fourth tuning circuit 264, as shown in FIG. 32.

The first radiator 230 includes a fourth connection point 224, and the third tuning circuit 263 is coupled between the fourth connection point 224 and the ground plane 300.

The first radiator 230 includes a fifth connection point 225 and a sixth connection point 226, and the fourth tuning circuit 264 is coupled between the fifth connection point 225 and the sixth connection point 226. The first radiator 230 is provided with a fifth slot between the fifth connection point 225 and the sixth connection point 226.

It should be understood that the first radiator 230 is electrically connected to the ground plane 300 at the fourth connection point 224 through the third tuning circuit 263, so that when the first radiator 230 generates a parasitic resonance, a current on the first radiator 230 is shunted in an area near the fourth connection point 224.

Because shunt occurs in the area near the fourth connection point 224, current density on the first radiator 230 can be reduced. In an embodiment, current distribution on the first radiator 230 is more dispersed, to reduce a conductor loss of the first radiator 230. In an embodiment, current distribution on the first radiator 230 is more dispersed, to increase a radiation aperture of the first radiator 230. Because the conductor loss of the first radiator 230 is reduced, and the radiation aperture of the antenna 200 is increased, system efficiency and radiation efficiency of the antenna can be improved.

In addition, the first radiator 230 is provided with the fifth slot, and the fifth slot may be considered as an equivalent capacitor (for example, a distributed capacitor) provided on the first radiator 230. The equivalent capacitor may enable the first radiator 230 to form a metamaterial structure. The radiation aperture of the first radiator 230 in the metamaterial structure may be increased, and after the fifth slot is provided, an electric field is more dispersed, and a dielectric loss near a conductor is reduced. Therefore, system efficiency and radiation efficiency of the antenna 200 can be effectively improved. By coupling the fourth tuning circuit 264 between the fifth connection point 225 and the sixth connection point 226, an equivalent capacitance value of the fifth slot can be adjusted, to adjust a radiation characteristic (for example, a resonance point frequency) of the antenna 200.

In an embodiment, for a relative position relationship between the fourth connection point 224, the fifth connection point 225, the sixth connection point 226, and the fifth slot, refer to a corresponding understanding of the relative position relationship between the first connection point 221, the second connection point 222, the third connection point 223, and the fourth slot in the foregoing embodiment. For brevity of description, details are not described again.

For brevity of description, a part that is of the antenna 200 shown in FIG. 31 and FIG. 32 and that is similar to the antenna 200 shown in FIG. 25 is not described in detail, for example, a position of the first radiator 230, the satellite communication frequency band, the frequency difference between the first resonance generated by the first radiator 230 and the parasitic resonance generated by the second radiator 240, and relative positions of the first radiator 230 and the second radiator 240.

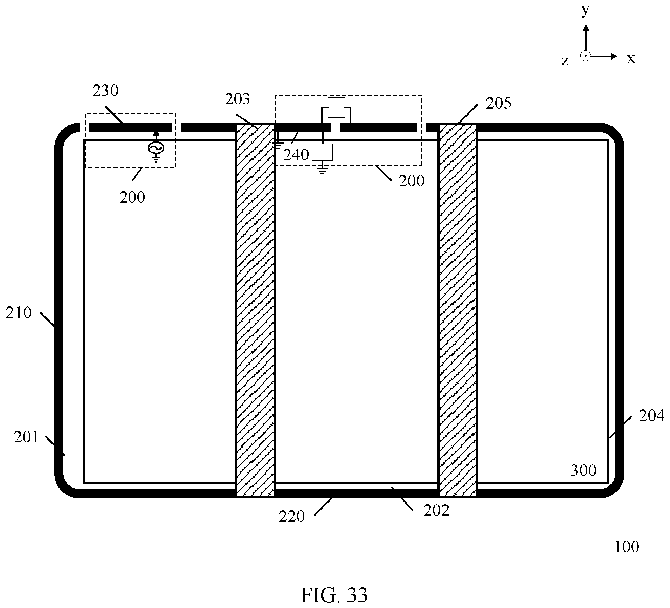

FIG. 33 is a diagram of a foldable electronic device 100 according to an embodiment of this application.

It should be understood that, in the foregoing embodiment, only an example in which the foldable electronic device 100 (for example, a two-fold electronic device) includes only two housings is used for description. In actual production or design, the technical solutions provided in embodiments of this application may also be applied to a plurality of housings (for example, a multi-fold electronic device). As shown in FIG. 33, only an example in which the foldable electronic device 100 includes three housings is used for description.

As shown in FIG. 33, the foldable electronic device 100 may further include a third housing 204 and a rotating shaft 205. The rotating shaft 205 is located between the second housing 202 and the third housing 204, and the rotating shaft 205 is rotatably connected to the second housing 202 and the third housing 204 separately, so that the second housing 202 and the third housing 204 can rotate relative to each other.

It should be understood that a difference between the antenna 200 shown in FIG. 33 and the foldable electronic device 100 shown in FIG. 25 lies only in the third housing 204 and the rotating shaft 205. A part that is of the antenna 200 shown in FIG. 33 and that is similar to the antenna 200 shown in FIG. 25 is not described in detail, for example, a position of the first radiator 230, the satellite communication frequency band, the frequency difference between the first resonance generated by the first radiator 230 and the parasitic resonance generated by the second radiator 240, and relative positions of the first radiator 230 and the second radiator 240.

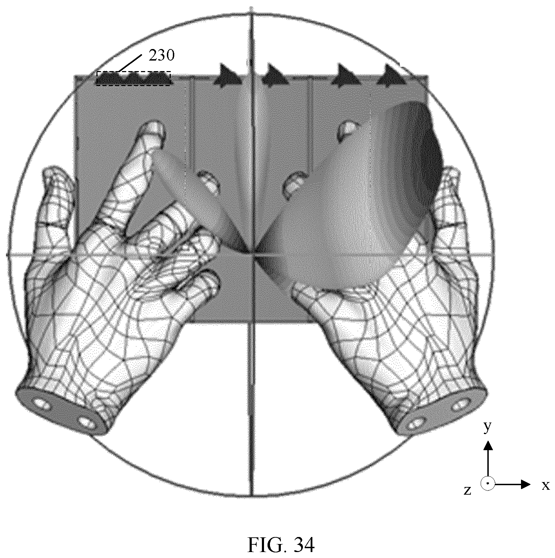

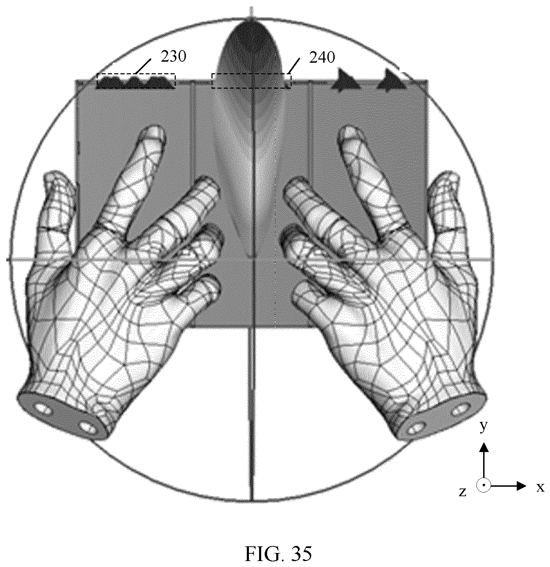

FIG. 34 and FIG. 35 are radiation patterns in an unfolded state of the foldable electronic device 100 shown in FIG. 33 at 2.2 GHz. FIG. 34 is a radiation pattern in the unfolded state of the foldable electronic device 100 when the second radiator is not provided. FIG. 35 is a radiation pattern in the unfolded state of the foldable electronic device 100 when the second radiator is provided.

As shown in FIG. 34, when the second radiator is not provided, compared with the foregoing embodiment, the foldable electronic device shown in FIG. 33 has a larger size of a ground plane in the unfolded state, a current on the ground plane has greater impact on a maximum radiation direction of the radiation pattern generated by the antenna, and the maximum radiation direction of the radiation pattern generated by the antenna deviates from a top direction (for example, a y direction) by a greater angle. When the second radiator is not provided, directivity of the antenna is 3.77 dBi.

As shown in FIG. 35, after the second radiator is provided, in the unfolded state of the foldable electronic device, impact of a current of the ground plane 300 on the maximum radiation direction of the radiation pattern generated by the antenna is reduced, so that the maximum radiation direction does not deviate from the top direction (for example, the y direction), and radiation energy is more concentrated. Directivity of the antenna is 5.56 dBi.

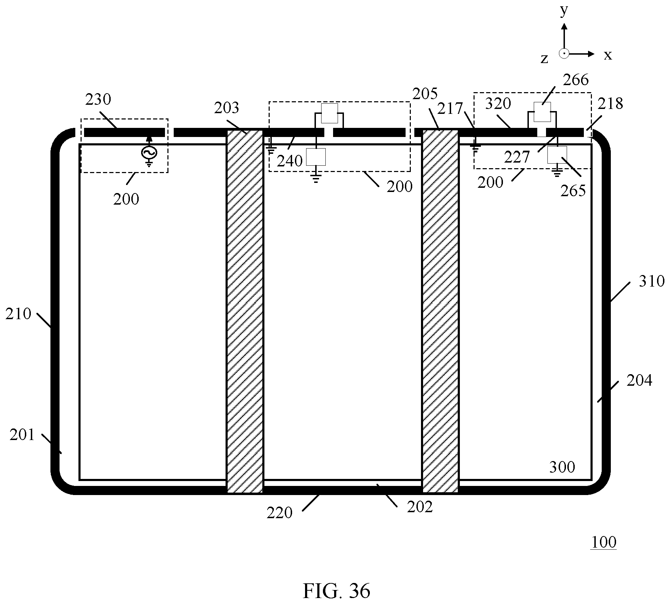

FIG. 36 is a diagram of a foldable electronic device 100 according to an embodiment of this application.

As shown in FIG. 36, the third housing 204 includes a third side frame 310, and at least a part of the third side frame 310 and the ground plane 300 are spaced apart.

The third side frame 310 includes a seventh position 217 and an eighth position 218. The seventh position 217 may be located on a third side of the third side frame 310. In an embodiment, the eighth position 218 may be located on the third side of the third side frame 310. When the foldable electronic device 100 is in an unfolded state, the first side, the second side, and the third side may be a same side of the foldable electronic device 100, for example, a top side or a bottom side.

The antenna 200 further includes a third radiator 320 and a fifth tuning circuit 265. The third radiator 320 is a conductive part of the third side frame 310 between the seventh position 217 and the eighth position 218.

It should be understood that a difference between the antenna 200 shown in FIG. 36 and the foldable electronic device 100 shown in FIG. 33 lies only in the third radiator 320.

In the foldable electronic device 100 shown in FIG. 33, the third radiator 320 is not provided (the third side frame 310 does not include the seventh position 217 or the eighth position 218). At a resonance point of a first resonance generated by the first radiator 230, a current generated on the first radiator 230 and a current generated on the second radiator 240 are in a same direction. When the foldable electronic device 100 is in the unfolded state, the current generated on the first radiator 230 and the current generated on the second radiator 240 may form effect similar to a current array, so that the antenna 200 has a strong linear polarization characteristic, and the antenna 200 has higher directivity.

However, in the foldable electronic device 100 shown in FIG. 36, the third radiator 320 is provided. At a resonance point of the first resonance generated by the first radiator 230, a current generated on the first radiator 230 and a current generated on the second radiator 240 are in a same direction, and the current generated on the first radiator 230 and a current generated on the third radiator 320 (the fifth tuning circuit 265 may be configured to generate the current in this direction) are in reverse directions. When the foldable electronic device 100 is in the unfolded state, the reverse current generated on the third radiator 320 can reduce effect similar to a current array that may be formed by the current generated on the first radiator 230 and the current generated on the second radiator 240, to reduce directivity of the antenna 200, so that the antenna 200 has a wider radiation beam (for example, a beam with a gain that differs from a gain in a maximum radiation direction by less than 3 dB).

In an embodiment, a structure formed by the third radiator 320 may be similar to any structure formed by the second radiator 240 in the foregoing embodiment. In an embodiment, the third radiator 320 may be in a structure in which one end is an open end and the other end is a ground end. The third side frame 310 is provided with a sixth slot at the seventh position 217, and is coupled to the ground plane 300 at the eighth position 218. Alternatively, the third side frame 310 is coupled to the ground plane 300 at the seventh position 217, and is provided with a sixth slot at the eighth position 218. In an embodiment, the third radiator 320 may be in a metamaterial structure. The antenna 200 includes a sixth tuning circuit 266. The sixth tuning circuit 266 is coupled between an eighth connection point and a ninth connection point of the third radiator 320, and the third radiator 320 is provided with a slot between the eighth connection point and the ninth connection point. In an embodiment, the third radiator 320 may be in a structure in which two ends are open ends. The third side frame 310 is provided with the sixth slot and the seventh slot at the seventh position 217 and the eighth position 218.

It should be understood that the third radiator 320 and the second radiator 240 may be in a same structure, for example, a structure in which both ends are open ends, or a structure in which one end is an open end and the other end is a ground end. Alternatively, the third radiator 320 and the second radiator 240 may be in different structures. This is not limited in this embodiment of this application, and may be selected based on actual production or design.

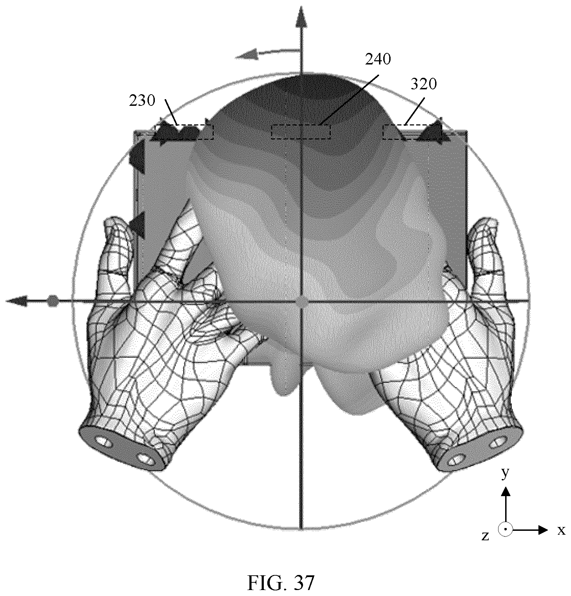

FIG. 37 is a radiation pattern in the unfolded state of the foldable electronic device 100 shown in FIG. 36 at 2.2 GHz.

As shown in FIG. 37, after the second radiator is provided, in the unfolded state of the foldable electronic device, impact of a current of the ground plane 300 on a maximum radiation direction of the radiation pattern generated by the antenna is reduced, so that the maximum radiation direction does not deviate from a top direction (for example, a y direction).

In addition, after the third radiator is provided, the reverse current generated on the third radiator can reduce effect similar to a current array that may be formed by the current generated on the first radiator and the current generated on the second radiator. Directivity of the antenna is reduced to 2.1 dBi.

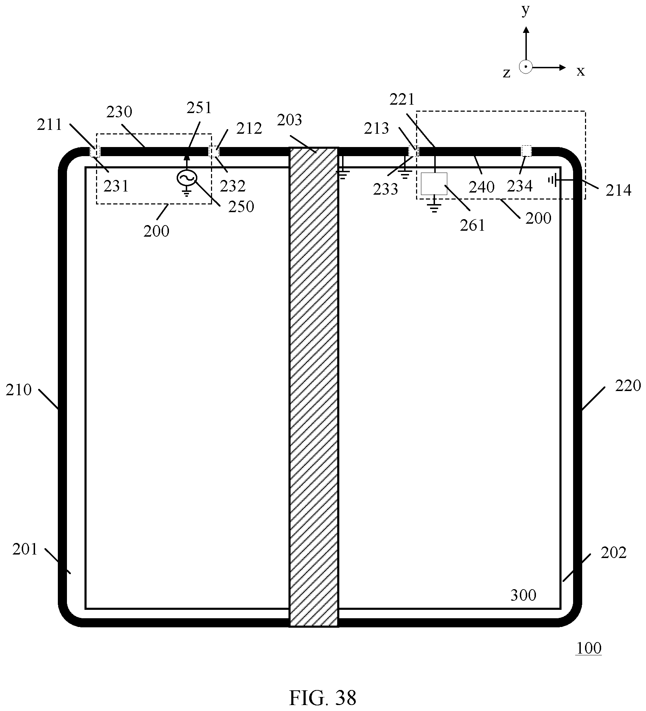

FIG. 38 is a diagram of another foldable electronic device 100 according to an embodiment of this application.

As shown in FIG. 38, the second side frame 220 is provided with the third slot 233 at the third position 213. The second side frame 220 is coupled to the ground plane 300 at the fourth position 214. The second side frame 220 is provided with a fourth slot 234 between the third position 213 and the fourth position 214.

When the foldable electronic device 100 is in an unfolded state, the third position 213 is located between the second position 212 and the fourth position 214.

It should be understood that a difference between the antenna 200 in the foldable electronic device 100 shown in FIG. 38 and the antenna 200 in the foldable electronic device 100 shown in FIG. 25, FIG. 31 to FIG. 33, and FIG. 36 lies only in relative position relationships between the third position 213 and the fourth position 214 relative to the rotating shaft 203.

In the foldable electronic device 100 shown in FIG. 25, FIG. 26, FIG. 31 to FIG. 33, and FIG. 36, when the foldable electronic device 100 is in the unfolded state, the fourth position 214 is located between the second position 212 and the third position 213. The fourth position 214 is closer to the rotating shaft 203 compared with the third position 213 (a distance between the fourth position 214 and the rotating shaft 203 along the second side frame 220 is less than a distance between the third position 213 and the rotating shaft 203 along the second side frame 220). A first end of the second radiator 240 is an open end, a second end is a ground end, and the ground end of the second radiator 240 is close to the rotating shaft 203.

However, in the foldable electronic device 100 shown in FIG. 38, when the foldable electronic device 100 is in the unfolded state, the third position 213 is located between the second position 212 and the fourth position 214. The fourth position 214 is further away from to the rotating shaft 203 compared with the third position 213 (a distance between the fourth position 214 and the rotating shaft 203 along the second side frame 220 is greater than a distance between the third position 213 and the rotating shaft 203 along the second side frame 220). A first end of the second radiator 240 is an open end, a second end is a ground end, and the open end of the second radiator 240 is close to the rotating shaft 203.

The antenna 200 in the foldable electronic device 100 shown in FIG. 38 may also have a radiation characteristic of the antenna 200 in the foregoing embodiment. For example, the first tuning circuit 261 can reduce impact of a current of the ground plane 300 on the radiation characteristic of the antenna 200. In an embodiment, the first tuning circuit 261 can reduce impact of the current of the ground plane 300 on a maximum radiation direction of a radiation pattern generated by the antenna 200. The first tuning circuit 261 can reduce impact of the current of the ground plane 300 on the maximum radiation direction of the radiation pattern generated by the antenna 200, to adjust the maximum radiation direction of the radiation pattern generated by the antenna 200. When the foldable electronic device 100 is in the unfolded state, the first tuning circuit 261 may be configured to adjust the maximum radiation direction of the radiation pattern generated by the antenna 200, so that the maximum radiation direction of the radiation pattern generated by the antenna 200 is oriented towards a target direction (for example, towards a communication satellite).

In an embodiment, when the foldable electronic device 100 is in a folded state, the first slot 231 provided on the first side frame 210 is aligned with the fourth slot 234 provided on the second side frame 220, and/or the second slot 232 provided on the first side frame 210 is aligned with the third slot 233 provided on the second side frame 220, to improve an aesthetic degree of the foldable electronic device 100.

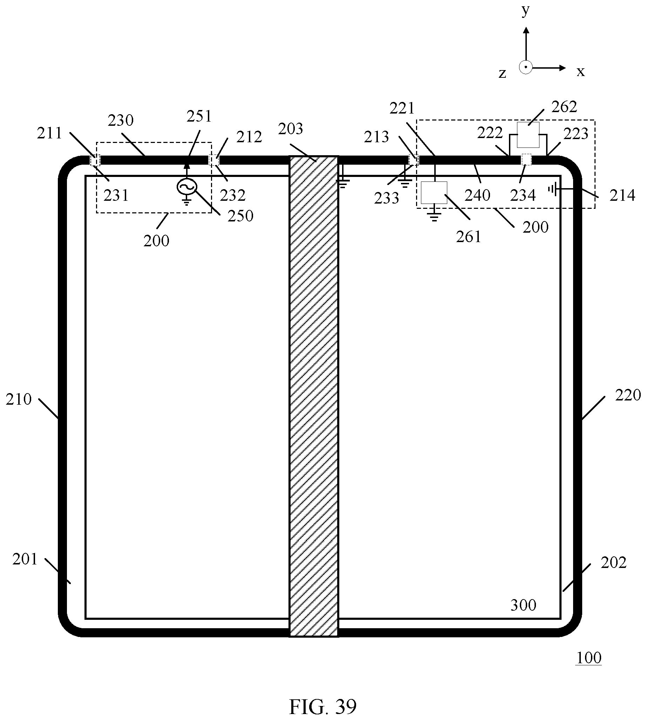

In an embodiment, the antenna 200 further includes the second tuning circuit 262, as shown in FIG. 39. The second radiator 240 includes the second connection point 222 and the third connection point 223, and the second tuning circuit 262 is coupled between the second connection point 222 and the third connection point 223. The fourth slot is located between the second connection point 222 and the third connection point 223.

It should be understood that the first radiator 230, the second radiator 240, the first tuning circuit 261, and the second tuning circuit 262 are configured to generate the radiation pattern of the antenna. In an embodiment, by coupling the second tuning circuit 262 between the second connection point 222 and the third connection point 223, an equivalent capacitance value of the fourth slot can be adjusted, to adjust a radiation characteristic (for example, a resonance point frequency) of the antenna 200.

For brevity of description, a part that is of the antenna 200 shown in FIG. 38 and FIG. 39 and that is similar to the antenna 200 shown in the foregoing embodiment is not described in detail, for example, a position of the first radiator 230, the satellite communication frequency band, the frequency difference between the first resonance generated by the first radiator 230 and the parasitic resonance generated by the second radiator 240, and relative positions of the first radiator 230 and the second radiator 240.

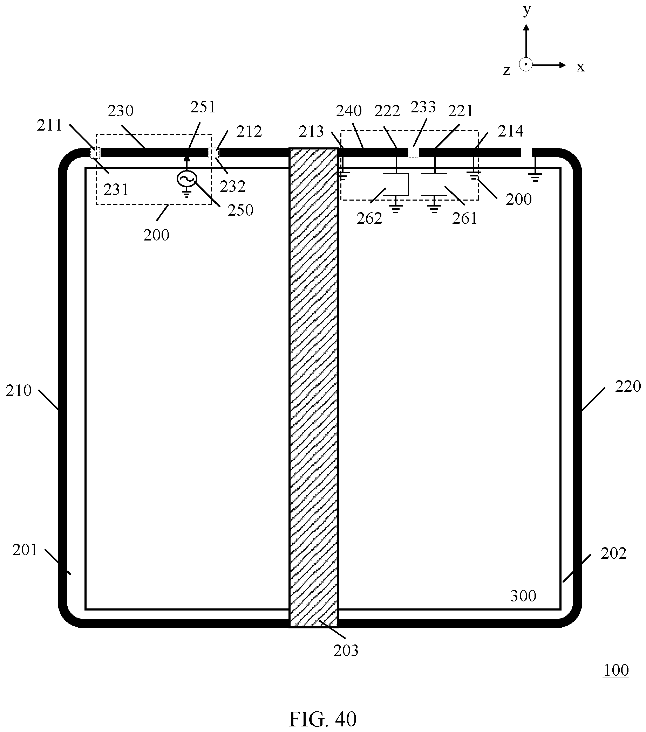

FIG. 40 is a diagram of a foldable electronic device 100 according to an embodiment of this application.

As shown in FIG. 40, the second side frame 220 is coupled to the ground plane 300 at the third position 213 and the fourth position 214. The second side frame 220 is provided with the third slot 233 between the third position 213 and the fourth position 214.

It should be understood that a difference between the antenna 200 in the foldable electronic device 100 shown in FIG. 38 and the antenna 200 in the foldable electronic device 100 shown in the foregoing embodiment lies only in a boundary condition of the second radiator 240 (two ends of the second radiator 240 are open ends or ground ends).

In some of the foregoing embodiments, a first end of the second radiator 240 is an open end, and a second end is a ground end (for example, in the foldable electronic device 100 shown in FIG. 9 and FIG. 25), to form a structure similar to an IFA. In some of the foregoing embodiments, the first end and the second end of the second radiator 240 are open ends (for example, in the foldable electronic device 100 shown in FIG. 20), to form a structure similar to a dipole.

In the foldable electronic device 100 shown in FIG. 40, a first end and a second end of the second radiator 240 are ground ends, to form a structure similar to a slot antenna. The second radiator 240 may operate in a one-half wavelength mode.

The antenna 200 in the foldable electronic device 100 shown in FIG. 40 may also have a radiation characteristic of the antenna 200 in the foregoing embodiment. For example, the first tuning circuit 261 can reduce impact of a current of the ground plane 300 on the radiation characteristic of the antenna 200. In an embodiment, the first tuning circuit 261 can reduce impact of the current of the ground plane 300 on a maximum radiation direction of a radiation pattern generated by the antenna 200. The first tuning circuit 261 can reduce impact of the current of the ground plane 300 on the maximum radiation direction of the radiation pattern generated by the antenna 200, to adjust the maximum radiation direction of the radiation pattern generated by the antenna 200. When the foldable electronic device 100 is in the unfolded state, the first tuning circuit 261 may be configured to adjust the maximum radiation direction of the radiation pattern generated by the antenna 200, so that the maximum radiation direction of the radiation pattern generated by the antenna 200 is oriented towards a target direction (for example, towards a communication satellite).

In an embodiment, the antenna 200 further includes the second tuning circuit 262, as shown in FIG. 40. The second radiator 240 includes the second connection point 222, and the second tuning circuit 262 is coupled to the second connection point 222. In an embodiment, the third slot 233 is located between the second connection point 222 and the first connection point 221.

It should be understood that the first radiator 230, the second radiator 240, the first tuning circuit 261, and the second tuning circuit 262 are configured to generate the radiation pattern of the antenna. In an embodiment, the first tuning circuit 261 and the second tuning circuit 262 may be configured to jointly adjust a radiation characteristic of the antenna 200 (for example, a resonance point frequency of parasitic resonance generated by the second radiator 240).

In an embodiment, when the foldable electronic device 100 is in a folded state, the second slot 232 provided on the first side frame 210 is aligned with the third slot 233 provided on the second side frame 220, to improve an aesthetic degree of the foldable electronic device 100.

In an embodiment, the third position 213 and the fourth position 214 are located on the second side of the second side frame 220.

In an embodiment, when the foldable electronic device 100 is in the folded state, the first slot 231 provided on the first side frame 210 is aligned with the third slot 233 provided on the second side frame 220, to improve an aesthetic degree of the foldable electronic device 100.

In an embodiment, the third position 213 may be located on the second side of the second side frame 220. The fourth position 214 is located on another side of the second side frame 220.

In an embodiment, a minimum distance between the second radiator 240 and the first rotating shaft 203 is less than or equal to a quarter of a length of the second radiator 240. In an embodiment, the minimum distance between the second radiator 240 and the first rotating shaft 203 is less than or equal to one-eighth of the length of the second radiator 240. In an embodiment, the minimum distance between the second radiator 240 and the first rotating shaft 203 is less than or equal to 10 mm. In an embodiment, the minimum distance between the second radiator 240 and the first rotating shaft 203 is less than or equal to 5 mm.

In an embodiment, the minimum distance between the second radiator 240 and the first rotating shaft 203 is greater than or equal to a quarter of the length of the second radiator 240. In an embodiment, the minimum distance between the second radiator 240 and the first rotating shaft 203 is greater than or equal to a half of the length of the second radiator 240. In an embodiment, the minimum distance between the second radiator 240 and the first rotating shaft 203 is greater than or equal to 20 mm. In an embodiment, the minimum distance between the second radiator 240 and the first rotating shaft 203 is greater than or equal to 40 mm.

It should be understood that a specific position of the second radiator 240 is not limited in this embodiment of this application, and is adjusted based on actual production or design. For brevity of description, details are not described again.

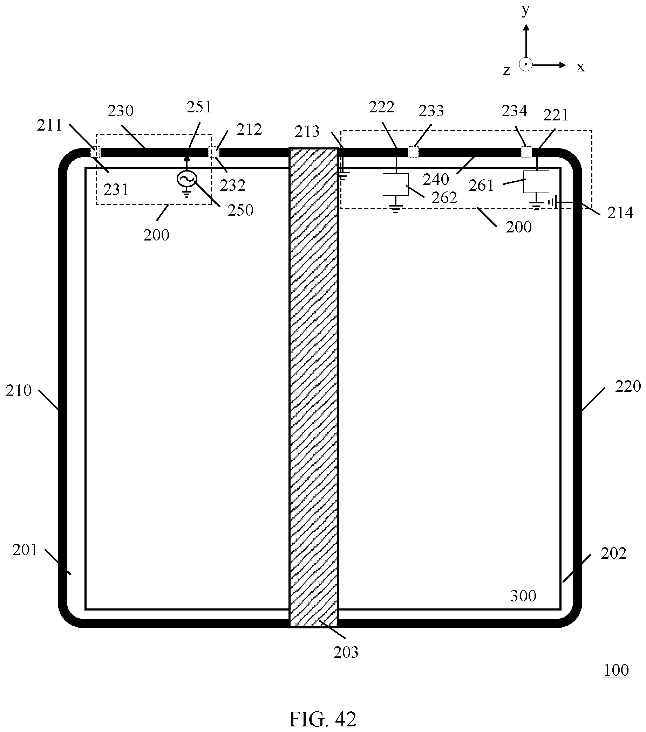

In an embodiment, the third slot 233 and the fourth slot 234 are provided between the third position 213 and the fourth position 214 on the second side frame 220, as shown in FIG. 42.

In an embodiment, the third position 213, the third slot 233, the fourth slot 234, and the fourth position 214 are sequentially arranged. In an embodiment, the third position 213 may be located on the second side of the second side frame 220. The fourth position 214 is located on another side of the second side frame 220.

In an embodiment, when the foldable electronic device 100 is in a folded state, the first slot 231 provided on the first side frame 210 is aligned with the fourth slot 234 provided on the second side frame 220, and/or the second slot 232 provided on the first side frame 210 is aligned with the third slot 233 provided on the second side frame 220, to improve an aesthetic degree of the foldable electronic device 100.

In an embodiment, when the second side frame 220 is provided with the third slot 233 and the fourth slot 234, the antenna 200 may include a plurality of tuning circuits.

It should be understood that the first radiator 230, the second radiator 240, and the plurality of tuning circuits are configured to generate the radiation pattern of the antenna. In an embodiment, the plurality of tuning circuits are configured to jointly adjust a radiation characteristic of the antenna 200 (for example, a resonance point frequency of parasitic resonance generated by the second radiator 240).

It should be understood that, in this embodiment of this application, in FIG. 42, only an example in which the antenna 200 includes the first tuning circuit 261 and the second tuning circuit 262 (the third slot 233 and the fourth slot 234 are located between the first connection point 221 and the second connection point 222) is used for description. In actual production or design, a position at which a tuning circuit is coupled to the second radiator 240 and a quantity of tuning circuits may be adjusted. For example, a tuning circuit is coupled between radiators on two sides of a slot, or a radiator between the third slot and the fourth slot includes a connection point coupled to a tuning circuit. For brevity of description, details are not described again.

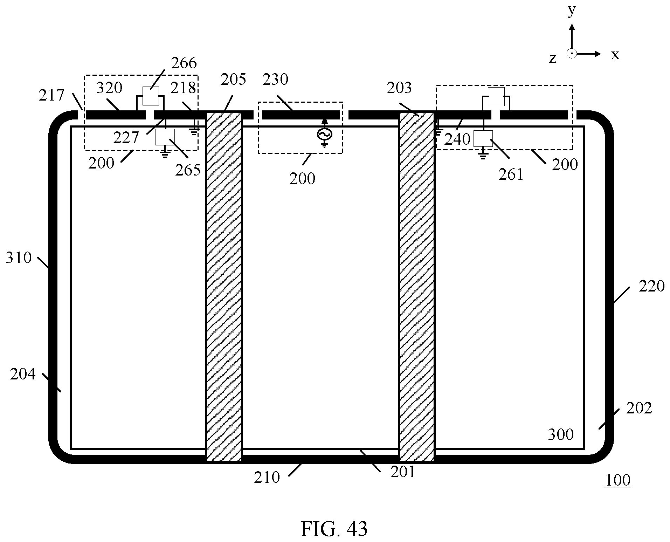

FIG. 43 is a diagram of a foldable electronic device 100 according to an embodiment of this application.

As shown in FIG. 43, the foldable electronic device 100 may further include a third housing 204 and a rotating shaft 205. The rotating shaft 205 is located between the first housing 201 and the third housing 204, and the rotating shaft 205 is rotatably connected to the first housing 201 and the third housing 204 separately, so that the first housing 201 and the third housing 204 can rotate relative to each other.

It should be understood that a difference between the antenna 200 shown in FIG. 43 and the foldable electronic device 100 shown in FIG. 33 lies only in positions of the third housing 204 and the rotating shaft 205. In the foldable electronic device 100 shown in FIG. 33, the rotating shaft 205 is located between the second housing 202 and the third housing 204. In the foldable electronic device 100 shown in FIG. 43, the rotating shaft 205 is located between the first housing 201 and the third housing 204.

In an embodiment, the third housing 204 includes a third side frame 310, and at least a part of the third side frame 310 and the ground plane 300 are spaced apart. The third side frame 310 includes a seventh position 217 and an eighth position 218. The seventh position 217 may be located on a third side of the third side frame 310. In an embodiment, the eighth position 218 may be located on the third side of the third side frame 310. When the foldable electronic device 100 is in an unfolded state, the first side, the second side, and the third side may be a same side of the foldable electronic device 100, for example, a top side or a bottom side.

In an embodiment, the antenna 200 further includes a third radiator 320 and a fifth tuning circuit 265. The third radiator 320 is a conductive part of the third side frame 310 between the seventh position 217 and the eighth position 218.

The third radiator 320 includes a seventh connection point 227, and the fifth tuning circuit 265 is coupled between the seventh connection point 227 and the ground plane 300.

It should be understood that, when the foldable electronic device 100 is in the unfolded state, the feed circuit feeds an electrical signal, the first radiator 230 is configured to generate a first resonance, the second radiator 240 is configured to generate a first parasitic resonance, and the third radiator 320 may be configured to generate a second parasitic resonance. The first tuning circuit 261 and the fifth tuning circuit 265 may be configured to switch a maximum radiation direction of a radiation pattern generated by the antenna 200. The first tuning circuit 261 may switch an equivalent electrical parameter (for example, equivalent capacitance, equivalent inductance, or equivalent resistance) between the first connection point 221 and the ground plane 300, so that the first parasitic resonance generated by the second radiator 240 is close to the first resonance. The fifth tuning circuit 265 may switch an equivalent electrical parameter (for example, equivalent capacitance, equivalent inductance, or equivalent resistance) between the seventh connection point 227 and the ground plane 300, so that the second parasitic resonance generated by the third radiator 320 is close to the first resonance (descriptions that the first parasitic resonance and the second parasitic resonance are close to the first resonance may be similar to descriptions that the parasitic resonance generated by the second radiator is close to the first resonance in the foregoing embodiment, and details are not described again). The first parasitic resonance and the second parasitic resonance jointly reduce impact of a current of the ground plane 300 on a radiation characteristic of the antenna 200. The first parasitic resonance and the second parasitic resonance jointly reduce impact of the current of the ground plane 300 on the maximum radiation direction of the radiation pattern generated by the antenna 200. When the foldable electronic device 100 is in the unfolded state, the first parasitic resonance and the second parasitic resonance jointly reduce impact of the current of the ground plane 300 on the maximum radiation direction of the radiation pattern generated by the antenna 200, to adjust the maximum radiation direction of the radiation pattern generated by the antenna 200. The first parasitic resonance and the second parasitic resonance jointly adjust the maximum radiation direction of the radiation pattern generated by the antenna 200, so that the maximum radiation direction of the radiation pattern generated by the antenna 200 is oriented towards a target direction (for example, towards a communication satellite). Because impact of the current of the ground plane 300 on the maximum radiation direction of the radiation pattern generated by the antenna 200 is reduced, maximum radiation directions of radiation patterns generated by the antenna 200 when the foldable electronic device 100 is in the folded state and the unfolded state are approximately the same. Therefore, during satellite communication, a state (the folded state or the unfolded state) of the foldable electronic device 100 is changed, and the user does not need to change a posture of holding the foldable electronic device 100. This effectively improves user experience.

In addition, at a resonance point of the first resonance generated by the first radiator 230, a current generated on the first radiator 230, a current generated on the second radiator 240, and a current generated on the third radiator 320 are in a same direction. The current generated on the first radiator 230, the current generated on the second radiator 240, and the current generated on the third radiator 320 may form effect similar to a current array, so that the antenna 200 has a strong linear polarization characteristic, and the antenna 200 has higher directivity. Because a gain is related to directivity, and the antenna 200 has higher directivity, a gain of the antenna 200 may be increased, so that the foldable electronic device 100 has better satellite communication performance.

In an embodiment, a structure formed by the third radiator 320 may be similar to any structure formed by the second radiator 240 in the foregoing embodiment. For example, a structure formed by the third radiator 320 in FIG. 43 may be replaced with a structure formed by any second radiator 240 in the foregoing embodiments. In an embodiment, the third radiator 320 may be in a structure in which one end is an open end and the other end is a ground end. The third side frame 310 is provided with a sixth slot at the seventh position 217, and is coupled to the ground plane 300 at the eighth position 218. Alternatively, the third side frame 310 is coupled to the ground plane 300 at the seventh position 217, and is provided with a sixth slot at the eighth position 218. In an embodiment, the third radiator 320 may be in a metamaterial structure. The antenna 200 includes a sixth tuning circuit 266. The sixth tuning circuit 266 is coupled between an eighth connection point and a ninth connection point of the third radiator 320, and the third radiator 320 is provided with a slot between the eighth connection point and the ninth connection point. In an embodiment, the third radiator 320 may be in a structure in which two ends are open ends. The third side frame 310 is provided with the sixth slot and the seventh slot at the seventh position 217 and the eighth position 218.

It should be understood that the third radiator 320 and the second radiator 240 may be any structure described in the foregoing embodiments. For brevity of description, details are not described again. In an embodiment, the third radiator 320 and the second radiator 240 may be in a same structure, for example, a structure in which both ends are open ends, or a structure in which one end is an open end and the other end is a ground end. Alternatively, the third radiator 320 and the second radiator 240 may be in different structures. This is not limited in this embodiment of this application, and may be selected based on actual production or design.

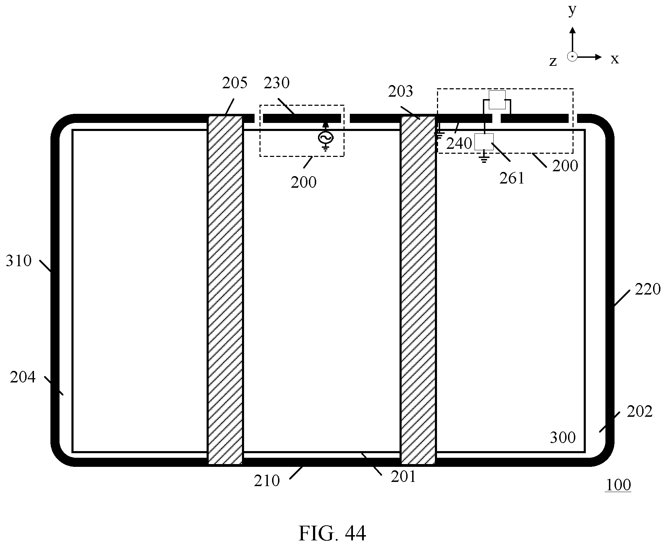

FIG. 44 is a diagram of a foldable electronic device 100 according to an embodiment of this application.

It should be understood that a difference between the antenna 200 shown in FIG. 44 and the foldable electronic device 100 shown in FIG. 43 lies only in: The third radiator 320 is not included.

In the foldable electronic device 100 shown in FIG. 43, the third radiator 320 is provided. At a resonance point of the first resonance generated by the first radiator 230, a current generated on the first radiator 230, a current generated on the second radiator 240, and a current generated on the third radiator 320 are in a same direction. The current generated on the first radiator 230, the current generated on the second radiator 240, and the current generated on the third radiator 320 may form effect similar to a current array, so that the antenna 200 has a strong linear polarization characteristic, and the antenna 200 has higher directivity.

However, in the foldable electronic device 100 shown in FIG. 44, the third radiator 320 is not provided. For example, effect similar to a current array formed by the currents is reduced compared with the antenna 200 shown in FIG. 43, to reduce directivity of the antenna 200, so that the antenna 200 has a wider radiation beam (for example, a beam width with a gain that differs from a gain in a maximum radiation direction by less than 3 dB).

That the third radiator 320 is not provided may be understood as that none of the radiators (parasitic stubs) on the third side frame 310 has large impact on a radiation pattern of the antenna 200 (for example, a maximum radiation direction of the radiation pattern generated by the antenna 200 deflects by more than 10°).

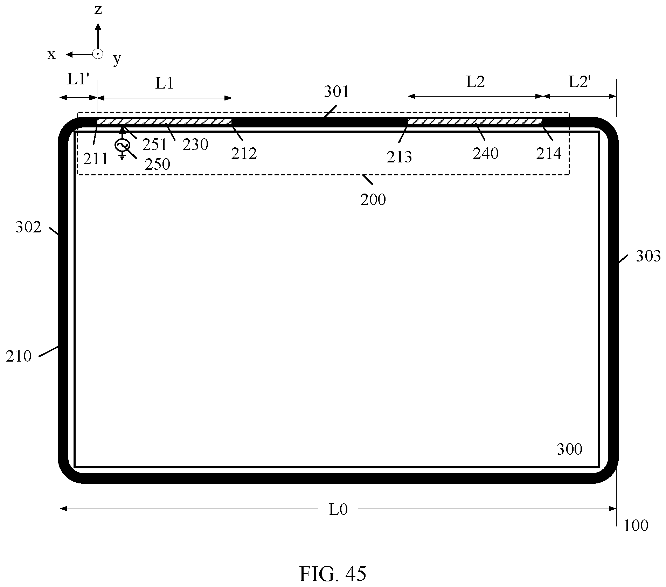

FIG. 45 is a diagram of an electronic device 100 according to an embodiment of this application.

It should be understood that, in the foregoing embodiments, an example in which the electronic device 100 is a foldable electronic device is used for description. In actual production or design, the technical solutions in the embodiments of this application may also be applied to another type of electronic device 100 that includes a large-size ground plane.

As shown in FIG. 45, a subdevice 100 of the electronic device 100 may include a first side frame 210 and a ground plane 300. At least a part of the first side frame 210 and a ground plane 300 are spaced apart.

The first side frame 210 includes a first side 301. The first side 301 includes a first position 211, a second position 212, a third position 213, and a fourth position 214 that are sequentially arranged. The first side frame 301 is provided with an insulation slot or is coupled to the ground plane 300 at the first position 211. The first side frame 301 is provided with an insulation slot or is coupled to the ground plane 300 at the second position 212. The first side frame 301 is provided with an insulation slot or is coupled to the ground plane 300 at the third position 213. The first side frame 301 is provided with an insulation slot or is coupled to the ground plane 300 at the fourth position 214.

The electronic device 100 may further include an antenna 200. An operating frequency band of the antenna 200 may include a satellite communication frequency band.

The antenna 200 includes a first radiator 230, a second radiator 240, a feed circuit 250, and a first tuning circuit 261.

The first radiator 230 is a conductive part of the first side frame 210 between the first position 211 and the second position 212. The second radiator 240 is a conductive part of the second side frame 220 between the third position 213 and the fourth position 214.

The first radiator 230 includes a feed point 251, and the feed circuit 250 is coupled to the feed point 251.

The second radiator 240 includes a first connection point 221, and the first tuning circuit 261 is coupled between the first connection point 221 and the ground plane 300.

The first side frame 210 further includes a second side 302 and a third side 303 that intersect with the first side 301 at angles.

In an embodiment, a length L0 of the first side 301, a length L1 of the first radiator 230, and a length L2 of the second radiator 240 meet: $1.2 \times (L1+L2) \leq L0$. In an embodiment, the length L0 of the first side 301, the length L1 of the first radiator 230, and the length L2 of the second radiator 240 meet: $1.5 \times (L1+L2) \leq L0$. In an embodiment, the length L0 of the first side 300, the length L1 of the first radiator 231, and the length L2 of the second radiator 240 meet: $2 \times (L1+L2) \leq L0$.

It should be understood that the length L0 of the first side 301 may be understood as a size of the electronic device 100 in an extension direction (for example, an x direction) of the first side 301. A proportional relationship between the length L0 of the first side 301, and the length L1 of the first radiator 230 and the length L2 of the second radiator 240 may also be understood as a proportional relationship between a size L0' of the ground plane 300 in the extension direction (for example, the x direction) of the first side 301, and the length L1 of the first radiator 230 and the length L2 of the second radiator 240. For example, $1.2 \times (L1+L2) \leq L0'$, $1.5 \times (L1+L2) \leq L0'$, and $2 \times (L1+L2) \leq L0'$.

In an embodiment, a distance between the first position 211 and the second side 302 is less than or equal to a distance between the second position 212 and the third side 303. The first radiator 230 is provided close to the second side 302.

It should be understood that the distance between the first position 211 and the second side 302 may be understood as a distance between the first position 211 and the second side 302 along the extension direction (for example, the x direction) of the first side 301. For brevity of description, a distance to a side described in this embodiment of this application may be correspondingly understood.

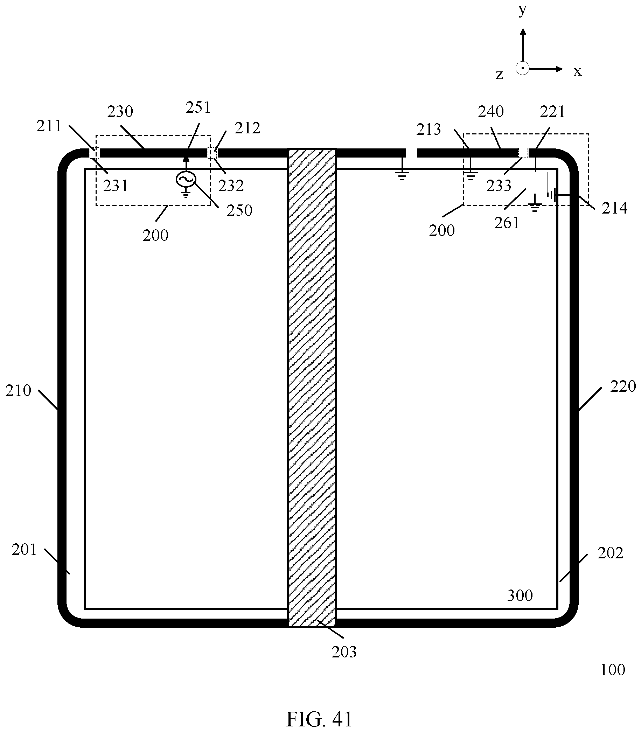

It should be understood that, in the foregoing embodiment (for example, the electronic device 100 shown in FIG. 9 to FIG. 43), the electronic device 100 is a foldable electronic device, and the first radiator 230 and the second radiator 240 are respectively located on the first housing 201 and the second housing 202 that can be folded with each other in the electronic device 100. When the electronic device 100 is in the unfolded state, both the first radiator 230 and the second radiator 240 are located on a same side of the electronic device 100. The feed circuit 250 feeds an electrical signal, the first radiator 230 generates a first resonance, and the second radiator 240 and the first tuning circuit 261 can reduce impact of a current of the ground plane 300 on a radiation pattern generated by the antenna.

A difference between the electronic device 100 shown in FIG. 45 and the electronic device 100 shown in the foregoing embodiments (the electronic device 100 shown in FIG. 9 to FIG. 44) lies only in that the electronic device 100 cannot be folded.

In the electronic device 100 shown in FIG. 45, the first radiator 230 and the second radiator 240 may be any structure of the first radiator 230 and any structure of the second radiator 240 in the foregoing embodiments.

When the first radiator 230 is provided close to the second side 302, the feed circuit 250 feeds an electrical signal, the first radiator 230 generates the first resonance, and the second radiator 240 and the first tuning circuit 261 can reduce impact of the current of the ground plane 300 on the radiation pattern generated by the antenna. Because impact of the current of the ground plane 300 on the maximum radiation direction of the radiation pattern generated by the antenna is reduced, the included angle between the maximum radiation direction of the radiation pattern generated by the antenna 200 and a direction (for example, a y direction) perpendicular to an extension direction of the first side 301 is small. The maximum radiation direction of the radiation pattern generated by the antenna 200 may be oriented towards a target direction (for example, towards a communication satellite), and it is convenient to establish a communication connection to the satellite.

In an embodiment, the first radiator 230 and the second radiator 240 are respectively located on two sides of a midpoint of the first side 301. Lengths of the first side 301 on two sides of the midpoint are the same.

It should be understood that the first radiator 230 and the second radiator 240 are respectively located on two sides of the midpoint of the first side 301, so that impact of the current of the ground plane 300 on one side of the second radiator 240 on the maximum radiation direction of the radiation pattern generated by the antenna can be further reduced, so that the maximum radiation direction of the radiation pattern generated by the antenna 200 does not deflect towards the side of the second radiator 240.

In an embodiment, a distance L1' between the first position 211 and the second side 302 and a length L1 of the first radiator 230 meet $L1' \leq L1$. In an embodiment, the distance L1' between the first position 211 and the second side 302 and the length L1 of the first radiator 230 meet $L1' \leq L1 \times 0.5$.

In an embodiment, a distance L2' between the fourth position 214 and the third side 303 and a length L2 of the second radiator 240 meet $L2' \leq L2$. In an embodiment, the distance L2' between the fourth position 214 and the third side 303 and the length L2 of the second radiator 240 meet $L2' \leq L2 \times 0.5$.

It should be understood that a part that is of the electronic device 100 shown in FIG. 45 and that is similar to the electronic device 100 shown in FIG. 9 to FIG. 44 is not described again. For example, the similar part includes: a related parameter of an insulation slot provided on a side frame, a satellite communication frequency band, and an efficiency pit generated in an operating frequency band by a parasitic resonance generated by a parasitic stub.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A foldable electronic device, comprising:

   a first housing, a second housing, and a ground plane, wherein

   the first housing comprises a first side frame, the second housing comprises a second side frame, at least a part of the first side frame and the ground plane are spaced apart, and at least a part of the second side frame and the ground plane are spaced apart;
   the first side frame comprises a first position and a second position, and the first position and the second position are located on a first side of the first side frame; and
   the second side frame comprises a third position and a fourth position, the third position is located on a second side of the second side frame, and based on the foldable electronic device being in an unfolded state, the first side and the second side are a top side or a bottom side of the foldable electronic device;

   a first rotating shaft, wherein the first rotating shaft is located between the first housing and the second housing, and the first rotating shaft is rotatably connected to the first housing and the second housing separately; and
   an antenna, wherein the antenna comprises:

   a first radiator and a second radiator, wherein the first radiator is a conductive part of the first side frame between the first position and the second position, and the second radiator is a conductive part of the second side frame between the third position and the fourth position;

   a feed circuit, wherein the first radiator comprises a feed point, and the feed circuit is coupled to the feed point; and
   a first tuning circuit, wherein the second radiator comprises a first connection point, and the first tuning circuit is coupled between the first connection point and the ground plane, wherein

   based on the foldable electronic device being in the unfolded state, the first radiator is configured to generate a first resonance, a resonance frequency band of the first resonance comprises a satellite communication frequency band, and the first radiator, the second radiator, and the first tuning circuit are configured to generate a radiation pattern of the antenna.

2. The foldable electronic device according to claim 1, wherein the first side frame is provided with a first slot and a second slot at the first position and the second position.

3. The foldable electronic device according to claim 1, wherein the first side frame is provided with a first slot at the first position, and the first side frame is coupled to the ground plane at the second position.

4. The foldable electronic device according to claim 1, wherein

   the first side frame is provided with a first slot at the first position, and the first side frame is coupled to the ground plane at the second position; and
   the antenna further comprises a second tuning circuit, the first radiator comprises a second connection point and a third connection point, the first radiator is provided with a second slot between the second connection point and the third connection point, and the second tuning circuit is coupled between the second connection point and the third connection point.

5. The foldable electronic device according to any one of claims 1 to 4, wherein based on the foldable electronic device being in the unfolded state, a maximum radiation direction of the radiation pattern of the antenna is related to the second radiator and the first tuning circuit.

6. The foldable electronic device according to any one of claims 1 to 5, wherein
   based on the antenna operating in the satellite communication frequency band,

   when the foldable electronic device is in the unfolded state, a maximum radiation direction of the radiation pattern generated by the antenna is a first direction; and
when the foldable electronic device is in a folded state, a maximum radiation direction of the radiation pattern generated by the antenna is a second direction, and an angle between the first direction and the second direction is less than or equal to 30°.

7. The foldable electronic device according to any one of claims 1 to 6, wherein the first tuning circuit and the second radiator are configured to generate a parasitic resonance, and a frequency difference between a resonance point frequency of the first resonance and a resonance point frequency of the parasitic resonance is less than or equal to 200 MHz.

8. The foldable electronic device according to any one of claims 1 to 7, wherein the antenna generates an efficiency pit at a first frequency, wherein a frequency difference between the resonance point frequency of the first resonance and a frequency of the first frequency is less than or equal to 200 MHz.

9. The foldable electronic device according to any one of claims 1 to 8, wherein based on the foldable electronic device being in the unfolded state, the difference between the resonance point frequency of the first resonance and the resonance point frequency of the parasitic resonance is less than or equal to 50 MHz.

10. The foldable electronic device according to any one of claims 1 to 9, wherein the antenna generates an efficiency pit at a first frequency, wherein the frequency difference between the resonance point frequency of the first resonance and the frequency of the first frequency is less than or equal to 50 MHz.

11. The foldable electronic device according to any one of claims 1 to 10, wherein the first radiator is configured to generate a main resonance, the first tuning circuit and the second radiator are configured to generate a parasitic resonance, a resonance point of the parasitic resonance is in a resonance frequency band of the main resonance, and the main resonance and the parasitic resonance jointly form the first resonance.

12. The foldable electronic device according to any one of claims 1 to 11, wherein the second side frame is provided with a third slot and a fourth slot at the third position and the fourth position.

13. The foldable electronic device according to claim 12, wherein the antenna further comprises a third tuning circuit, the second radiator comprises a fourth connection point, the third tuning circuit is coupled between the fourth connection point and the ground plane, and the first radiator, the second radiator, the first tuning circuit, and the third tuning circuit are configured to generate the radiation pattern of the antenna.

14. The foldable electronic device according to any one of claims 1 to 11, wherein

based on the foldable electronic device being in the unfolded state, the fourth position is located between the second position and the third position; and
the second side frame is provided with a third slot at the third position, and the second side frame is coupled to the ground plane at the fourth position.

15. The foldable electronic device according to any one of claims 1 to 11, wherein

based on the foldable electronic device being in the unfolded state, the fourth position is located between the second position and the third position; and
the second side frame is coupled to the ground plane at the third position, and the second side frame is provided with a third slot at the fourth position.

16. The foldable electronic device according to claim 14 or 15, wherein

the antenna further comprises a third tuning circuit; and
the second radiator comprises a fourth connection point and a fifth connection point, the second radiator is provided with a fourth slot between the fourth connection point and the fifth connection point, the third tuning circuit is coupled between the fourth connection point and the fifth connection point, and the first radiator, the second radiator, the first tuning circuit, and the third tuning circuit are configured to generate the radiation pattern of the antenna.

17. The foldable electronic device according to claim 16, wherein

a distance between the fourth connection point and the fourth slot is less than or equal to 5 mm; and/or
a distance between the fifth connection point and the fourth slot is less than or equal to 5 mm.

18. The foldable electronic device according to claim 16 or 17, wherein

the fourth connection point is located between the third position and the fourth slot, and the fifth connection point is located between the fourth position and the fourth slot; and
the first connection point is located between the third position and the fourth connection point, and a distance between the fourth connection point and the first connection point is greater than or equal to 0 mm and less than or equal to 5 mm; or
the first connection point is located between the fourth position and the fifth connection point, and a distance between the fifth connection point and the first connection point is greater than or equal to 0 mm and less than or equal to 5 mm.

19. The foldable electronic device according to any one of claims 1 to 11, wherein the second side frame is coupled to the ground plane at the third position and the fourth position.

20. The foldable electronic device according to claim 19, wherein the second radiator is provided with a third slot and/or a fourth slot between the third position and the fourth position.

21. The foldable electronic device according to any one of claims 1 to 20, wherein a minimum distance between the second radiator and the first rotating shaft is less than or equal to a quarter of a length of the second radiator.

22. The foldable electronic device according to any one of claims 1 to 20, wherein a minimum distance between the second radiator and the first rotating shaft is greater than or equal to a quarter of a length of the second radiator.

23. The foldable electronic device according to any one of claims 1 to 22, wherein

the foldable electronic device may further comprise a third housing and a second rotating shaft, wherein
the second rotating shaft is located between the second housing and the third housing, and the second rotating shaft is rotatably connected to the second housing and the third housing separately; or
the second rotating shaft is located between the first housing and the third housing, and the second rotating shaft is rotatably connected to the first housing and the third housing separately.

24. The foldable electronic device according to claim 23, wherein

the third housing comprises a third side frame, at least a part of the third side frame and the ground plane are spaced apart, the third side frame comprises a fifth position and a sixth position, the fifth position is located on a third side of the third side frame, and based on the foldable electronic device being in the unfolded state, the first side, the second side, the third side are a same side of the foldable electronic device; and
the antenna further comprises a third radiator and a fourth tuning circuit, the third radiator is a conductive part of the third side frame between the fifth position and the sixth position, the third radiator comprises a sixth connection point, and the fourth tuning circuit is coupled between the sixth connection point and the ground plane.

25. The foldable electronic device according to claim 24, wherein

based on the second rotating shaft being located between the second housing and the third housing, the first radiator is configured to generate the first resonance; and
based on the foldable electronic device being in the unfolded state, at a resonance point of the first resonance, a current on the first radiator and a current on the second radiator are in a same direction, and the current on the first radiator and a current on the third radiator are in reverse directions.

26. The foldable electronic device according to claim 25, wherein

based on the second rotating shaft being located between the first housing and the third housing, the first radiator is configured to generate the first resonance; and
based on the foldable electronic device being in the unfolded state, at the resonance point of the first resonance, the current on the first radiator, the current on the second radiator, and the current on the third radiator are in a same direction.

27. The foldable electronic device according to any one of claims 1 to 26, wherein based on the foldable electronic device being in the folded state, the first radiator and the second radiator at least partially overlap in a third direction, and the third direction is a thickness direction of the foldable electronic device.

28. The foldable electronic device according to any one of claims 1 to 27, wherein

a ratio of a size of the ground plane in an extension direction of the first side when the foldable electronic device is in the unfolded state to a size of the ground plane in the extension direction of the first side when the foldable electronic device is in the folded state is greater than or equal to 1.8, and is less than or equal to 2.2.

29. The foldable electronic device according to any one of claims 1 to 28, wherein
the foldable electronic device performs at least one of the following services in the satellite communication frequency band: receiving and/or sending a short message via satellite, making and/or answering a call via satellite, or data service via satellite.

30. An electronic device, comprising:

a ground plane;
a side frame, wherein at least a part of the side frame and the ground plane are spaced apart, wherein
the side frame comprises a first side and a second side that intersect at an angle, and the first side comprises a first position, a second position, a third position, and a fourth position that are successively arranged; and
an antenna, wherein the antenna comprises:

a first radiator and a second radiator, wherein the first radiator is a conductive part of the side frame between the first position and the second position, and the second radiator is a conductive part of the side frame between the third position and the fourth position;
a feed circuit, wherein the first radiator comprises a feed point, and the feed circuit is coupled to the feed point; and
a first tuning circuit, wherein the second radiator comprises a first connection point, and the first tuning circuit is coupled between the first connection point and the ground plane, wherein

a length L0 of the first side, a length L1 of the first radiator, and a length L2 of the second radiator meet $1.2 \times (L1+L2) \leq L0$;
a distance L1' between the first position and the second side and the length L1 of the first radiator meet $L1' \leq L1$; and
the first radiator is configured to generate a first resonance, a resonance frequency band of the first resonance comprises a satellite communication frequency band, and the first radiator, the second radiator, and the first tuning circuit are configured to generate a radiation pattern of the antenna.

31. The electronic device according to claim 30, wherein the first radiator and the second radiator are respectively located on two sides of a midpoint of the first side, and lengths of the first side on the two sides of the midpoint are the same.

32. The electronic device according to claim 30 or 31, wherein the side frame is provided with a first slot and a second slot at the first position and the second position.

33. The electronic device according to claim 30 or 31, wherein

the side frame is provided with a first slot at the first position, and the side frame is coupled to the ground plane at the second position; or
the side frame is coupled to the ground plane at the first position, and the side frame is provided with a first slot at the second position.

34. The electronic device according to any one of claims 30 to 33, wherein
the side frame is provided with a third slot and a fourth slot at the third position and the fourth position.

35. The electronic device according to any one of claims 30 to 33, wherein

the side frame is coupled to the ground plane at the third position, and the side frame is provided with a third slot at the fourth position; or
the side frame is provided with a third slot at the third position, and the side frame is coupled to the ground plane at the fourth position.

36. The electronic device according to claim 35, wherein

the antenna further comprises a second tuning circuit; and
the second radiator comprises a second connection point and a third connection point, the second radiator is provided with a fourth slot between the second connection point and the third connection point, the second tuning circuit is coupled between the second connection point and the third connection point, and the first radiator, the second radiator, the first tuning circuit, and the second tuning circuit are configured to generate the radiation pattern of the antenna.

FIG. 1

100

111

122/124

123

112

125    121

FIG. 2

100

110

126    125    127    129    128

FIG. 3

FIG. 4

110

126   125   127   128   129   100

FIG. 5

41　　　　　　　　40

42

PCB

(a)

Electric field zero point (current strong point)

41　　　　　40

42

PCB

←—　Current　　　←- -　Electric field

(b)

FIG. 6

51

50

52

PCB

(a)

Electric field zero point (current strong point)

51

50

52

PCB

Current ← — Electric field

(b)

FIG. 7

Maximum radiation direction

(a)

100

Maximum radiation direction

(b)

100

FIG. 8

FIG. 9

FIG. 10

FIG. 11

221

261

240

(a)

221

261

240

(b)

FIG. 12

FIG. 13

FIG. 14

FIG. 15

230

FIG. 16

230          240

FIG. 17

230    240

FIG. 18

230    240

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

FIG. 36

FIG. 37

FIG. 38

FIG. 39

FIG. 40

FIG. 41

FIG. 42

FIG. 43

FIG. 44

FIG. 45

## INTERNATIONAL SEARCH REPORT

| International application No. |
|---|
| **PCT/CN2024/140214** |

**A.　CLASSIFICATION OF SUBJECT MATTER**

H01Q1/22(2006.01)i;　H01Q1/36(2006.01)i;　H01Q1/44(2006.01)i

According to International Patent Classification (IPC) or to both national classification and IPC

**B.　FIELDS SEARCHED**

Minimum documentation searched (classification system followed by classification symbols)

IPC: H01Q

Documentation searched other than minimum documentation to the extent that such documents are included in the fields searched

Electronic data base consulted during the international search (name of data base and, where practicable, search terms used)

CNTXT, CNKI, IEEE, EPTXT, USTXT, WOTXT, VEN: 天线, 辐射体, 可折叠, 框, 方向图, 馈电点, 接地, 间隙, 卫星, 通信; antenna, radiator, foldable, frame, directional, diagram, feeding, point, ground, gap, satellite, communication

**C.　DOCUMENTS CONSIDERED TO BE RELEVANT**

| Category* | Citation of document, with indication, where appropriate, of the relevant passages | Relevant to claim No. |
|---|---|---|
| X | CN 116053760 A (HUAWEI TECHNOLOGIES CO., LTD.) 02 May 2023 (2023-05-02) description, paragraphs 26-146, and figures 1-21 | 1-29 |
| A | CN 111628298 A (HUAWEI TECHNOLOGIES CO., LTD.) 04 September 2020 (2020-09-04) entire document | 1-36 |
| A | CN 116315584 A (HUAWEI TECHNOLOGIES CO., LTD.) 23 June 2023 (2023-06-23) entire document | 1-36 |
| A | CN 117117470 A (HUAWEI TECHNOLOGIES CO., LTD.) 24 November 2023 (2023-11-24) entire document | 1-36 |
| A | WO 2020222428 A1 (SAMSUNG ELECTRONICS CO., LTD.) 05 November 2020 (2020-11-05) entire document | 1-36 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 February 2025** | **12 February 2025** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/140214**

| Patent document cited in search report | | | Publication date (day/month/year) | Patent family member(s) | | | Publication date (day/month/year) |
|---|---|---|---|---|---|---|---|
| CN | 116053760 | A | 02 May 2023 | None | | | |
| CN | 111628298 | A | 04 September 2020 | None | | | |
| CN | 116315584 | A | 23 June 2023 | None | | | |
| CN | 117117470 | A | 24 November 2023 | None | | | |
| WO | 2020222428 | A1 | 05 November 2020 | KR | 20200126232 | A | 06 November 2020 |
| | | | | US | 2022050652 | A1 | 17 February 2022 |
| | | | | US | 11907607 | B2 | 20 February 2024 |

Form PCT/ISA/210 (patent family annex) (July 2022)

**REFERENCES CITED IN THE DESCRIPTION**

**Patent documents cited in the description**

- CN 202311871918

- CN 202411651410